# EUROPEAN PATENT APPLICATION

(11) **EP 4 852 060 A1**
(43) Date of publication of application: **09.12.2026**
(21) Application number: 24922535.0
(22) Date of filing: 23.09.2024
(51) Int. Cl.: H01L 25/075, H10H 20/857, H10H 20/831, H10H 20/832, H10D 86/00

(54) **DISPLAY DEVICE**

(30) Priority: 30.01.2024 KR 20240014175
(71) Applicant: Samsung Display Co., Ltd., Yongin-si, Gyeonggi-do 17113 (KR)
(72) Inventor: HONG, Sung Chul, Yongin-si, Gyeonggi-do 17113 (KR); PARK, Do Yeong, Yongin-si, Gyeonggi-do 17113 (KR); PYO, Ki Hyun, Yongin-si, Gyeonggi-do 17113 (KR)
(74) Representative: Marks & Clerk LLP
(86) International application number: PCT/KR2024/014301
(87) International publication number: WO 2025/164870

(57) **Abstract**

A display device includes a first lower connection electrode disposed on a same layer as an anode electrode and spaced apart from the anode electrode, a first upper connection electrode electrically connected to the first lower connection electrode and disposed on the anode electrode to face the anode electrode, a cathode electrode disposed on a same layer as the first upper connection electrode and spaced apart from the first upper connection electrode, a first sub light emitting element that overlaps the anode electrode, and a second sub light emitting element that overlaps the first lower electrode, and the first sub light emitting element and the second sub light emitting element are electrically connected to each other in series through the first lower connection electrode and the first upper connection electrode between the anode electrode and the cathode electrode.

## Description

### Technical Field

The disclosure relates to a display device.

### Background Art

A display device is a device that displays an image by combining light emitted from pixels. In the case that a luminance of a pixel is improved, display quality of the image displayed on the display device may be improved.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### Detailed Description of Invention

### Technical Problem

An object of the disclosure is to provide a display device with improved display quality.

### Technical Solution

According to embodiments, a display device includes: a pixel circuit layer including a transistor; an anode electrode disposed on the pixel circuit layer and electrically connected to the transistor; a first lower connection electrode, wherein the first lower connection electrode and the anode electrode are disposed on a same layer, and the first lower connection electrode is spaced apart from the anode electrode; a first upper connection electrode electrically connected to the first lower connection electrode and disposed on the anode electrode to face the anode electrode; a cathode electrode, wherein the cathode electrode and the first upper connection electrode are disposed on a same layer, and the cathode electrode is spaced apart from the first upper connection electrode; a first sub light emitting element that overlaps the anode electrode; and a second sub light emitting element that overlaps the first lower electrode, and the first sub light emitting element and the second sub light emitting element may be electrically connected in series through the first lower connection electrode and the first upper connection electrode between the anode electrode and the cathode electrode.

In an embodiment, the first sub light emitting element may include a plurality of first sub light emitting elements, and the plurality of first sub light emitting elements may be electrically connected in parallel.

In an embodiment, the second sub light emitting element may include a plurality of second sub light emitting elements, and the plurality of second sub light emitting elements may be electrically connected in parallel.

In an embodiment, each of the first sub light emitting element and the second sub light emitting element may include a first semiconductor layer having a first polarity, and a second semiconductor layer having a second polarity different from the first polarity and disposed on the first semiconductor layer.

In an embodiment, the first semiconductor layer of the first sub light emitting element may be electrically connected to the anode electrode, the second semiconductor layer of the first sub light emitting element may be electrically connected to the first upper connection electrode, and the first semiconductor layer of the second sub light emitting element may be electrically connected to the first lower connection electrode.

In an embodiment, the display device may further include a second upper connection electrode, wherein the second upper connection electrode and the first upper connection electrode are disposed on a same layer, and the second upper connection electrode is spaced apart from the cathode electrode and the first upper connection electrode, and disposed on the first lower connection electrode to face the first lower connection electrode; a second lower connection electrode, wherein the second lower connection electrode and the anode electrode are disposed on a same layer, and the second lower connection electrode is spaced apart from the anode electrode and the first lower connection electrode, and is electrically connected to the second upper connection electrode; and a third sub light emitting element that overlaps the second lower connection electrode.

In an embodiment, the second sub light emitting element and the third sub light emitting element may be electrically connected in series through the second lower connection electrode and the second upper connection electrode between the first lower connection electrode and the cathode electrode.

In an embodiment, the third sub emitting element may include a plurality of third sub light emitting elements, and the plurality of third sub light emitting elements may be electrically connected in parallel.

In an embodiment, the display device may further include: a third upper connection electrode, wherein the third upper connection electrode and the first upper connection electrode are disposed on a same layer, and the third upper connection electrode is spaced apart from the cathode electrode, the first upper connection electrode, and the second upper connection electrode, and is disposed on the second lower connection electrode to face the second lower connection electrode; a third lower connection electrode, wherein the third lower connection electrode and the anode electrode are disposed on a same layer, wherein the third lower connection electrode is spaced apart from the anode electrode, the first lower connection electrode, and the second lower connection electrode, and is electrically connected to the third upper connection electrode; and a fourth sub light emitting element that overlaps the third lower connection electrode.

In an embodiment, the third sub light emitting element and the fourth sub light emitting element may be electrically connected in series through the third lower connection electrode and the third upper connection electrode between the second lower connection electrode and the cathode electrode.

According to embodiments, a display device includes: a pixel circuit layer including a transistor; an anode electrode disposed on the pixel circuit layer and electrically connected to the transistor; a first connection electrode spaced apart from the anode electrode, wherein the first connection electrode and the anode electrode are disposed on a same layer; a cathode electrode spaced apart from the anode electrode and the first connection electrode, wherein the cathode electrode and the anode electrode are disposed on a same layer; a first sub light emitting element electrically connected between the anode electrode and the first connection electrode; and a second sub light emitting element electrically connected between the first connection electrode and the cathode electrode, wherein the first sub light emitting element and the second sub light emitting element may be electrically connected in series through the first connection electrode between the anode electrode and the cathode electrode.

In an embodiment, the first sub light submitting element may include a plurality of first sub light emitting elements, and the plurality of first sub light emitting elements may be electrically connected in parallel.

In an embodiment, the second sub light submitting element may include a plurality of second sub light emitting elements, and the plurality of second sub light emitting elements may be connected to each other in parallel.

In an embodiment, each of the first sub light emitting element and the second sub light emitting element may include a first semiconductor layer having a first polarity, a second semiconductor layer having a second polarity different from the first polarity and disposed on the first semiconductor layer, a first bonding electrode electrically connected to the first semiconductor layer and protruding in a direction facing the pixel circuit layer, and a second bonding electrode electrically connected to the second semiconductor layer and protruding in the direction facing the pixel circuit layer.

In an embodiment, the first bonding electrode of the first sub light emitting element may be electrically connected to the anode electrode, the second bonding electrode of the first sub light emitting element may be electrically connected to the first connection electrode, and the first bonding electrode of the second sub light emitting element may be electrically connected to the first connection electrode.

In an embodiment, the display device may further include: a second connection electrode, wherein the second connection electrode and the anode electrode are disposed on a same layer, and the second connection electrode is spaced apart from the anode electrode, the first connection electrode, and the cathode electrode; and a third sub light emitting element electrically connected between the second connection electrode and the cathode electrode, wherein the second sub light emitting element and the third sub light emitting element may be electrically connected in series through the second connection electrode between the first connection electrode and the cathode electrode.

In an embodiment, the third sub light emitting element may comprise a plurality of third sub light emitting elements, and the plurality of third sub light emitting elements may be electrically connected in parallel.

According to embodiments, a display device includes: a pixel circuit layer including a transistor; an anode electrode disposed on the pixel circuit layer and electrically connected to the transistor; a cathode electrode, wherein the cathode electrode and the anode electrode are disposed on a same layer, and the cathode electrode is spaced apart from the anode electrode; a first sub light emitting element and a second sub light emitting element electrically connected between the anode electrode and the cathode electrode; and a first connection electrode disposed on the first sub light emitting element and the second sub light emitting element, wherein the first connection electrode electrically connects the first sub light emitting element and the second sub light emitting element, and wherein the first sub light emitting element and the second sub light emitting element may be electrically connected in series through the first connection electrode between the anode electrode and the cathode electrode.

In an embodiment, the first sub light emitting element may include a plurality of first sub light emitting elements, and the plurality of first sub light emitting elements may be electrically connected in parallel.

In an embodiment, the second sub light emitting element may include a plurality of second sub light emitting elements, and the plurality of second sub light emitting elements may be electrically connected in parallel.

In an embodiment, each of the first sub light emitting element and the second sub light emitting element may include a first semiconductor layer having a first polarity, a second semiconductor layer having a second polarity different from the first polarity and disposed below the first semiconductor layer, a first bonding electrode electrically connected to the first semiconductor layer and protruding in a direction away from the pixel circuit layer, and a second bonding electrode electrically connected to the second semiconductor layer and protruding in the direction away from the pixel circuit layer.

In an embodiment, the first bonding electrode of the first sub light emitting element may be electrically connected to the anode electrode, the second bonding electrode of the first sub light emitting element may be electrically connected to the first connection electrode, and the first bonding electrode of the second sub light emitting element may be electrically connected to the first connection electrode.

In an embodiment, the display device may further include a third sub light emitting element electrically connected between the first connection electrode and the cathode electrode, and a second connection electrode disposed on the second sub light emitting element and the third sub light emitting element, and electrically connecting the second sub light emitting element and the third sub light emitting element, and the second sub light emitting element and the third sub light emitting element may be electrically connected in series through the second connection electrode between the first connection electrode and the cathode electrode.

In an embodiment, the third sub light emitting element may include a plurality of third sub light emitting elements, and the plurality of third sub light emitting elements may be electrically connected in parallel.

In an embodiment, the display device may further include a floating electrode disposed between the anode electrode and the cathode electrode.

In an embodiment, the display device may further include a reflective electrode covering at least a portion of the floating electrode.

### Advantageous Effects

A display device according to embodiments of the disclosure may include a first sub light emitting element and a second sub light emitting element electrically connected in series between an anode electrode and a cathode electrode. As described above, as the first sub light emitting element and the second sub light emitting element are electrically connected in series, a luminance of the display device may be further improved.

A sub light emitting element included in a display device according to embodiments be a vertical light emitting element, a flip chip type of light emitting element, or a lateral chip type of light emitting element. The disclosure discloses a novel series connection structure using the various types of light emitting elements as described above.

### Description of Drawings

FIG. 1 is a block diagram illustrating a display device according to embodiments of the disclosure;
FIG. 2 is a block diagram illustrating an embodiment of one sub-pixel among sub-pixels included in the display device of FIG. 1;
FIG. 3 is a block diagram illustrating an embodiment of one sub-pixel among the sub-pixels included in the display device of FIG. 1;
FIG. 4 is a schematic plan view illustrating a display panel configuring the display device of FIG. 1;
FIG. 5 is a schematic cross-sectional view illustrating an embodiment of the display panel of FIG. 4;
FIG. 6 is a schematic cross-sectional view illustrating an embodiment of the display panel of FIG. 4;
FIGS. 7 and 8 are schematic plan views illustrating a (1-1)-th embodiment of one of the pixels included in the display panel of FIG. 3;
FIGS. 9 and 10 are schematic cross-sectional views illustrating the pixel according to the (1-1)-th embodiment of FIG. 8;
FIGS. 11 and 12 are schematic plan views illustrating a (1-2)-th embodiment of one of the pixels included in the display panel of FIG. 3;
FIGS. 13 and 14 are schematic cross-sectional views illustrating the pixel according to the (1-2)-th embodiment of FIG. 12;
FIGS. 15 and 16 are schematic plan views illustrating a (1-3)-th embodiment of one of the pixels included in the display panel of FIG. 3;
FIG. 17 is a schematic plan view illustrating a (2-1)-th embodiment of one of the pixels included in the display panel of FIG. 3;
FIGS. 18 and 19 are schematic cross-sectional views illustrating the pixel according to the (2-1)-th embodiment of FIG. 17;
FIG. 20 is a schematic plan view illustrating a (2-2)-th embodiment of one of the pixels included in the display panel of FIG. 3;
FIGS. 21 to 23 are schematic cross-sectional views illustrating the pixel according to the (2-2)-th embodiment of FIG. 20;
FIG. 24 is a schematic plan view illustrating a (2-3)-th embodiment of one of the pixels included in the display panel of FIG. 3;
FIGS. 25 and 26 are schematic cross-sectional views illustrating the pixel according to the (2-3)-th embodiment of FIG. 24;
FIG. 27 is a schematic plan view illustrating a (3-1)-th embodiment of one of the pixels included in the display panel of FIG. 3;
FIGS. 28 and 29 are schematic cross-sectional views illustrating the pixel according to the (3-1)-th embodiment of FIG. 27;
FIG. 30 is a schematic plan view illustrating a (3-2)-th embodiment of one of the pixels included in the display panel of FIG. 3;
FIGS. 31 to 33 are schematic cross-sectional views illustrating the pixel according to the (3-2)-th embodiment of FIG. 30;
FIG. 34 is a schematic plan view illustrating a (3-3)-th embodiment of one of the pixels included in the display panel of FIG. 3;
FIGS. 35 and 36 are schematic cross-sectional views illustrating the pixel according to the (3-3)-th embodiment of FIG. 34;
FIG. 37 is a block diagram illustrating a display system according to an embodiment; and
FIGS. 38 to 41 are schematic perspective views illustrating application examples of the display system of FIG. 37.

### Modes of the Invention

Hereinafter, embodiments are described in detail with reference to the accompanying drawings. It should be noted that in the following description, portions for understanding the disclosure are described, and descriptions of other portions may be omitted in order not to obscure the subject matter of the disclosure. In addition, the disclosure may be embodied in other forms without being limited to the embodiments described herein. However, the embodiments described herein are provided to describe in detail to readily implement the technical concept of the disclosure to those skilled in the art to which the disclosure pertains.

Throughout the specification, in a case where a portion is "connected" to another portion, the case includes not only a case where the portion is "directly connected" but also a case where the portion is "indirectly connected" with another element therebetween. Terms used herein are for describing embodiments and are not intended to limit the disclosure.

Throughout the specification, in a case where a given portion "includes" a certain component, the case means that the portion may further include another component without excluding another component unless otherwise stated.

In the drawings, sizes, thicknesses, ratios, and dimensions of the elements may be exaggerated for ease of description and for clarity. Like numbers refer to like elements throughout.

As used herein, the singular forms are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Here, terms such as first and second may be used to describe various components, but these components are not limited to these terms. These terms are used to distinguish one component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and thus the spatially relative terms used herein are interpreted according thereto.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

Various embodiments are described with reference to drawings schematically illustrating ideal embodiments. Accordingly, it will be expected that shapes may vary, for example, according to tolerances and/or manufacturing techniques. Therefore, the embodiments disclosed herein cannot be construed as being limited to shown shapes, and should be interpreted as including, for example, changes in shapes that occur as a result of manufacturing. As described above, the shapes shown in the drawings may not show actual shapes of areas of a device, and the embodiments are not limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

Embodiments may be described and illustrated in the accompanying drawings in terms of functional blocks, units, and/or modules.

Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies.

In the case of the blocks, units, and/or modules being implemented by microprocessors or other similar hardware, they may be programmed and controlled using software (for example, microcode) to perform various functions discussed herein and may optionally be driven by firmware and/or software.

It is also contemplated that each block, unit, and/or module may be implemented by dedicated hardware, or as a combination of dedicated hardware to perform some functions and a processor (for example, one or more programmed microprocessors and associated circuitry) to perform other functions.

Each block, unit, and/or module of embodiments may be physically separated into two or more interacting and discrete blocks, units, and/or modules without departing from the scope of the disclosure.

Further, the blocks, units, and/or modules of embodiments may be physically combined into more complex blocks, units, and/or modules without departing from the scope of the disclosure.

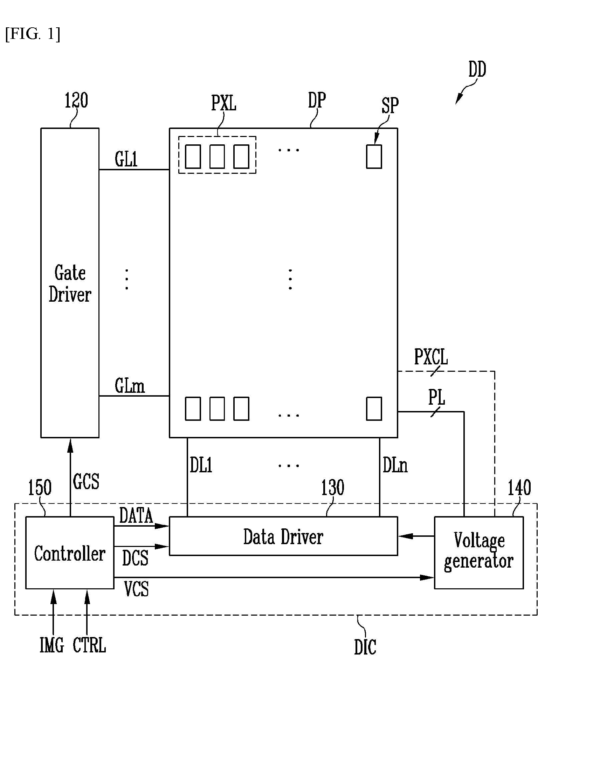

FIG. 1 is a block diagram illustrating a display device according to embodiments of the disclosure.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate of light of two or more colors. For example, each of the sub-pixels SP may generate light such as red, green, blue, cyan, magenta, or yellow.

Two or more sub-pixels among the sub-pixels SP may configure one pixel PXL. For example, the pixel PXL may include three sub-pixels as shown in FIG. 1. The pixel PXL may emit light of various colors and various luminances according to a combination of light emitted from the sub-pixels included in the pixel PXL.

The gate driver 120 may be connected to the sub-pixels SP arranged (or disposed) in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, and the like within the spirit and the scope of the disclosure.

The gate driver 120 may be disposed on one side or a side of the display panel DP. However, embodiments are not limited thereto. For example, the gate driver 120 may be divided into two or more physically and/or logically divided drivers, and such drivers may be disposed on one side or a side of the display panel DP and another side of the display panel DP opposite the one side or a side. As described above, the gate driver 120 may be disposed around the display panel DP in various shapes according to embodiments.

The data driver 130 is connected to the sub-pixels SP arranged in a column direction through the first to n-th data lines DL1 to DLn. The data driver 130 receives image data DATA and a data control signal DCS from the controller 150. The data driver 130 operates in response to the data control signal DCS. In embodiments, the data control signal DCS may include a source start signal, a source shift clock, a source output enable signal, and the like within the spirit and the scope of the disclosure.

The data driver 130 may receive voltages from the voltage generator 140. The data driver 130 may apply data signals having grayscale voltages corresponding to the image data DATA to the first to n-th data lines DL1 to DLn using the received voltages. In the case that the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may be configured to generate voltages and provide the generated voltages to components of the display device DD, such as the gate driver 120, the data driver 130, and the controller 150. The voltage generator 140 may generate the voltages by receiving an input voltage from an outside of the display device DD and regulating the received voltage.

The voltage generator 140 may generate a first power voltage and a second power voltage. The generated first and second power voltages may be provided to the sub-pixels SP through power lines PL. In an embodiment, at least one of the first and second power voltages may be provided from the outside of the display device DD.

The voltage generator 140 may provide various voltages and/or signals. For example, the voltage generator 140 may provide one or more initialization voltages applied to the sub-pixels SP. For example, during a sensing operation for sensing electrical characteristics of transistors and/or light emitting elements of the sub-pixels SP, a selectable reference voltage may be applied to the first to n-th data lines DL1 to DLn, and the voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, the pixel control lines PXCL are connected between the voltage generator 140 and the display panel DP, but embodiments are not limited thereto. For example, the pixel control lines PXCL may be connected between the gate driver 120 and the display panel DP. In this case, the pixel control signals may be transmitted from the voltage generator 140 to the pixel control lines PXCL through the gate driver 120.

The controller 150 controls overall operations of the display device DD. The controller 150 receives input image data IMG and a control signal CTRL corresponding thereto from the outside. The controller 150 may provide the gate control signal GCS, the data control signal DCS, and the voltage control signal VCS in response to the control signal CTRL.

The controller 150 may convert the input image data IMG so that the input image data IMG is suitable for the display device DD or the display panel DP and output the image data DATA. In embodiments, the controller 150 may output the image data DATA by aligning the input image data IMG so that the input image data IMG is suitable for the sub-pixels SP of a row unit.

Two or more components of the data driver 130, the voltage generator 140, and the controller 150 may be mounted on one integrated circuit. As shown in FIG. 1, the data driver 130, the voltage generator 140, and the controller 150 may be included in a driver integrated circuit DIC. In this case, the data driver 130, the voltage generator 140, and the controller 150 may be functionally divided components in one driver integrated circuit DIC. In other embodiments, at least one of the data driver 130, the voltage generator 140, and the controller 150 may be provided as a component distinguished from the driver integrated circuit DIC.

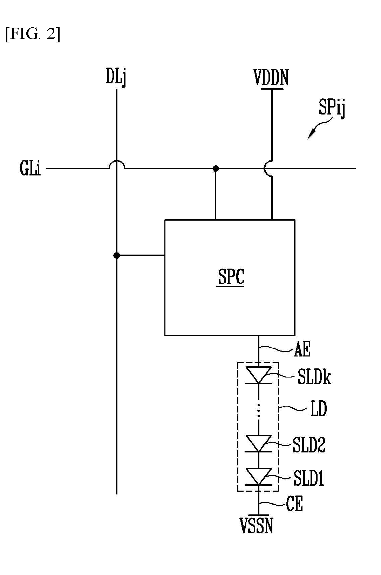

FIG. 2 is a block diagram illustrating an embodiment of one sub-pixel among the sub-pixels included in the display device of FIG. 1. In FIG. 2, among the sub-pixels SP of FIG. 1, a sub-pixel SPij arranged in an i-th row (i is an integer greater than or equal to 1 and less than or equal to m) and a j-th column (j is an integer greater than or equal to 1 and less than or equal to n) is shown as an example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL of FIG. 1 and may receive the first power voltage. The second power voltage node VSSN may be connected to another one of the power lines PL of FIG. 1 and may receive the second power voltage. The first power voltage may have a level higher than that of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD may be configured to emit light according to a current flowing from the anode electrode AE to the cathode electrode CE.

In embodiments, the light emitting element LD may include first to k-th sub light emitting elements SLD1 to SLDk connected between the anode electrode AE and the cathode electrode CE. In this case, the first to k-th sub light emitting elements SLD1 to SLDk may be connected to each other in series between the anode electrode AE and the cathode electrode CE. As described above, as the light emitting element LD may include sub light emitting elements SLD1 to SLDk connected to each other in series, a luminance of the light emitting element LD may be further improved.

The sub-pixel circuit SPC may be connected to an i-th gate line GLi among the first to m-th gate lines GL1 to GLm of FIG. 1, and a j-th data line DLj among the first to n-th data lines DL1 to DLn of FIG. 1. In response to a gate signal received through the i-th gate line GLi, the sub-pixel circuit SPC may control the light emitting element LD to emit light according to a data signal received through the j-th data line DLj. In embodiments, the sub-pixel circuit SPC may be further connected to the pixel control lines PXCL of FIG. 1. In this case, the sub-pixel circuit SPC may control the light emitting element LD in further response to the pixel control signals received through the pixel control lines PXCL.

For such operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal oxide semiconductor field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, and the like within the spirit and the scope of the disclosure.

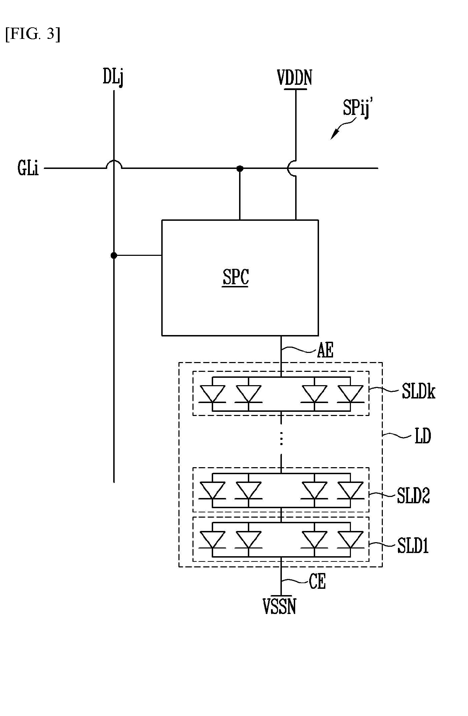

FIG. 3 is a block diagram illustrating an embodiment of one sub-pixel among the sub-pixels included in the display device of FIG. 1. In FIG. 3, among the sub-pixels SP of FIG. 1, a sub-pixel SPij' arranged in an i-th row (i is an integer greater than or equal to 1 and less than or equal to m) and a j-th column (j is an integer greater than or equal to 1 and less than or equal to n) is shown as an example.

The sub-pixel SPij' may be substantially equal to the sub-pixel SPij described with reference to FIG. 2, except that each of the first to k-th sub light emitting elements SLD1 to SLDk may be configured of a plurality of light emitting elements. Therefore, a description of an overlapping content may be omitted.

In the sub-pixel SPij', each of the first to k-th sub light emitting elements SLD1 to SLDk may include light emitting elements connected to each other in parallel. For example, each of the first to k-th sub light emitting elements SLD1 to SLDk may independently include two, three, four, or more light emitting elements connected to each other in parallel. In this case as well, the first to k-th sub light emitting elements SLD1 to SLDk may be connected to each other in series between the anode electrode AE and the cathode electrode CE, and thus a luminance of the light emitting element LD may be improved.

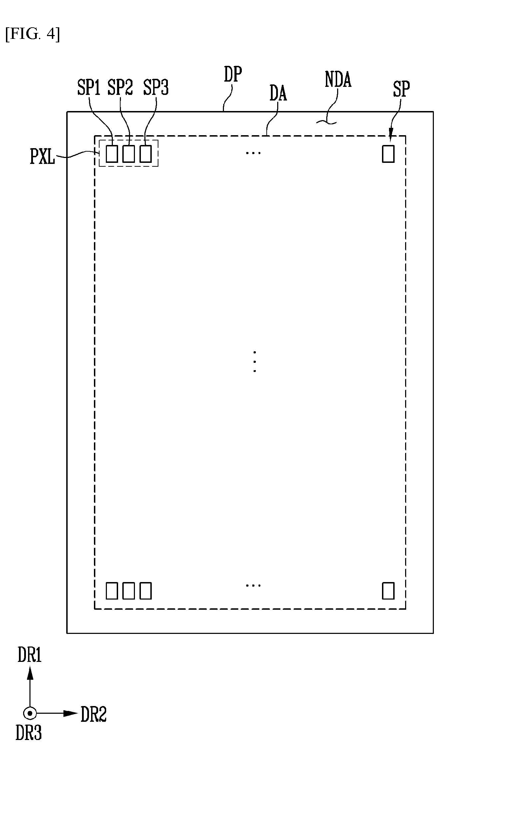

FIG. 4 is a schematic plan view illustrating the display panel configuring the display device of FIG. 1.

Referring to FIG. 4, the display panel DP may include a display area DA and a non-display area NDA. The display panel DP may display an image through the display area DA. The non-display area NDA may be disposed around the display area DA.

The display panel DP may include the sub-pixels SP disposed in the display area DA. The sub-pixels SP may be arranged along a first direction DR1 and a second direction DR2 crossing (or intersecting) the first direction DR1. For example, the sub-pixels SP may be arranged in a matrix form along the first direction DR1 and the second direction DR2. As another example, the sub-pixels SP may be arranged in a zigzag form along the first direction DR1 and the second direction DR2. An arrangement of the sub-pixels SP may vary according to embodiments. The first direction DR1 may be a column direction, and the second direction DR2 may be a row direction.

Two or more sub-pixels among the sub-pixels SP may configure one pixel PXL. In FIG. 4, the pixel PXL may include three sub-pixels SP1, SP2, and SP3, but embodiments are not limited thereto. For example, the pixel PXL may include two sub-pixels. Hereinafter, for convenience of description, it may be assumed that the pixel PXL may include the first to third sub-pixels SP1, SP2, and SP3.

Each of the first to third sub-pixels SP1, SP2, and SP3 may generate light of one of various colors such as red, green, blue, cyan, magenta, and yellow. Hereinafter, for clear and concise description, it is assumed that the first sub-pixel SP1 may be configured to generate light of a red color, the second sub-pixel SP2 may be configured to generate light of a green color, and the third sub-pixel SP3 may be configured to generate light of a blue color.

Each of the first to third sub-pixels SP1, SP2, and SP3 may include at least one light emitting element configured to generate light. In embodiments, the light emitting elements of the first to third sub-pixels SP1, SP2, and SP3 may generate light of a same color. For example, the light emitting elements of the first to third sub-pixels SP1, SP2, and SP3 may generate the light of the blue color. In other embodiments, the light emitting elements of the first to third sub-pixels SP1, SP2, and SP3 may generate light of different colors. For example, the light emitting elements of the first to third sub-pixels SP1, SP2, and SP3 may generate light of a red color, a green color, and a blue color, respectively.

As the display panel DP, a light emitting diode display panel (LED display panel) using a micro scale or nano scale of light emitting diode as a light emitting element, and a display panel capable of self-emission such as an organic light emitting display panel (OLED panel) using an organic light emitting diode as a light emitting element may be used.

A component for controlling the sub-pixels SP may be disposed in the non-display area NDA. Lines connected to the sub-pixels SP, for example, the first to m-th gate lines GL1 to GLm, the first to n-th data lines DL1 to DLn, the power lines PL, and the pixel control lines PXCL of FIG. 1 may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. In this case, the data driver 130, the voltage generator 140, and the controller 150 may be implemented as a driver integrated circuit DIC of FIG. 1, separate from the display panel DP, and the driver integrated circuit DIC may be connected to the lines disposed in the non-display area NDA. In other embodiments, the gate driver 120 may be implemented as one integrated circuit separate from the display panel DP, together with the data driver 130, the voltage generator 140, and the controller 150.

In embodiments, the display area DA may have various shapes. The display area DA may have a closed loop shape including sides of a straight line and/or a curved line. For example, the display area DA may have shapes of a polygon, a circle, a semicircle, an ellipse, and the like within the spirit and the scope of the disclosure.

In embodiments, the display panel DP may have a flat display surface. In other embodiments, the display panel DP may have a display surface that is at least partially round. In embodiments, the display panel DP may be bendable, foldable, or rollable. In such cases, the display panel DP and/or a substrate of the display panel DP may include materials having a flexible property.

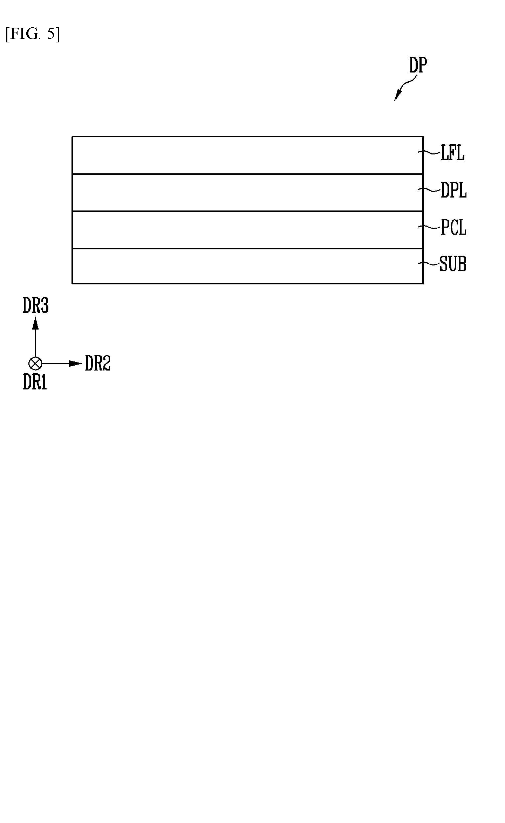

FIG. 5 is a schematic cross-sectional view illustrating an embodiment of the display panel of FIG. 4.

Referring to FIG. 5, the display panel DP may include a substrate SUB, and a pixel circuit layer PCL, a display element layer DPL, and a light functional layer LFL sequentially stacked each other on the substrate SUB in a third direction DR3 crossing the first and second directions DR1 and DR2.

The substrate SUB may be formed of an insulating material such as glass or resin. For example, the substrate SUB may include a glass substrate. As another example, the substrate SUB may include a polyimide (PI) substrate. As a further example, the substrate SUB may include a silicon wafer substrate formed using a semiconductor process.

In embodiments, the substrate SUB may be formed of a flexible material that may be bent or folded, and may have a single-layer structure or a multi-layer structure. For example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers and semiconductor patterns and conductive patterns disposed between the insulating layers. The conductive patterns of the pixel circuit layer PCL may function as circuit elements, lines, and the like within the spirit and the scope of the disclosure.

The circuit elements of the pixel circuit layer PCL may form the sub-pixel circuit SPC of each of the sub-pixels SP of FIG. 4. In other words, the circuit elements of the pixel circuit layer PCL may be provided as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines to drive the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may change a wavelength (or color) of light emitted from the display element layer DPL. The light functional layer LFL may further include light scattering patterns having the scattering particles. In embodiments, the light conversion patterns and the light scattering patterns may be omitted.

The light functional layer LFL may further include a color filter layer including color filters. The color filter may selectively transmit light of a given wavelength (or a given color). In embodiments, the color filter layer may be omitted.

A window for protecting an exposure surface (or an upper surface) of the display panel DP may be provided on the light functional layer LFL. The window may protect the display panel DP from external shock. The window may be coupled or connected to the light functional layer LFL through an optically transparent adhesive (or cohesive) member. The window may have a multi-layer structure selected from a glass substrate, a plastic film, and a plastic substrate. The multi-layer structure may be formed through a continuous process or an adhesion process using an adhesive layer. All or a portion of the window may be flexible.

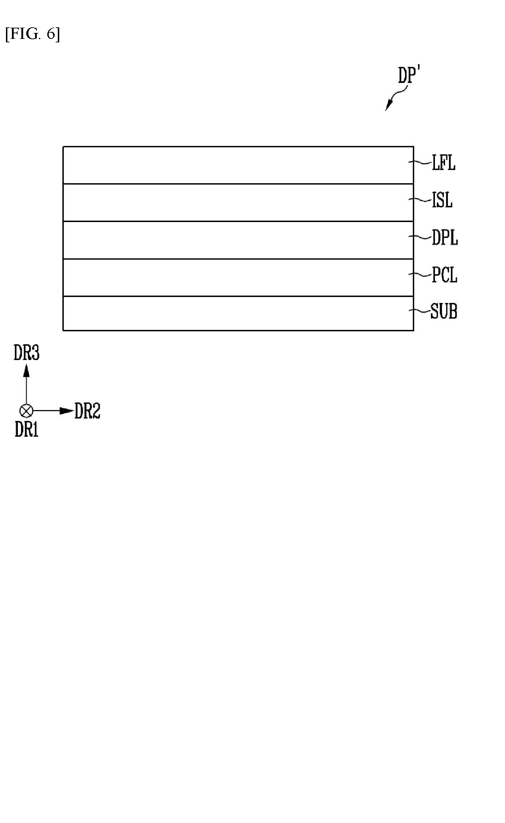

FIG. 6 is a schematic cross-sectional view illustrating an embodiment of the display panel of FIG. 4.

Referring to FIG. 6, the display panel DP' may include the substrate SUB, the pixel circuit layer PCL, the display element layer DPL, an input sensing layer ISL, and the light functional layer LFL. The substrate SUB, the pixel circuit layer PCL, the display element layer DPL, and the light functional layer LFL may be configured equally (or similarly) to the substrate SUB, the pixel circuit layer PCL, the display element layer DPL, and the light functional layer LFL described with reference to FIG. 5. Therefore, a description of an overlapping content may be omitted.

The input sensing layer ISL may sense a user's input on an upper surface (or a display surface) of the display panel DP'. The input sensing layer ISL may include components suitable for sensing an external object such as a user's hand, or a pen. For example, the input sensing layer ISL may include touch electrodes.

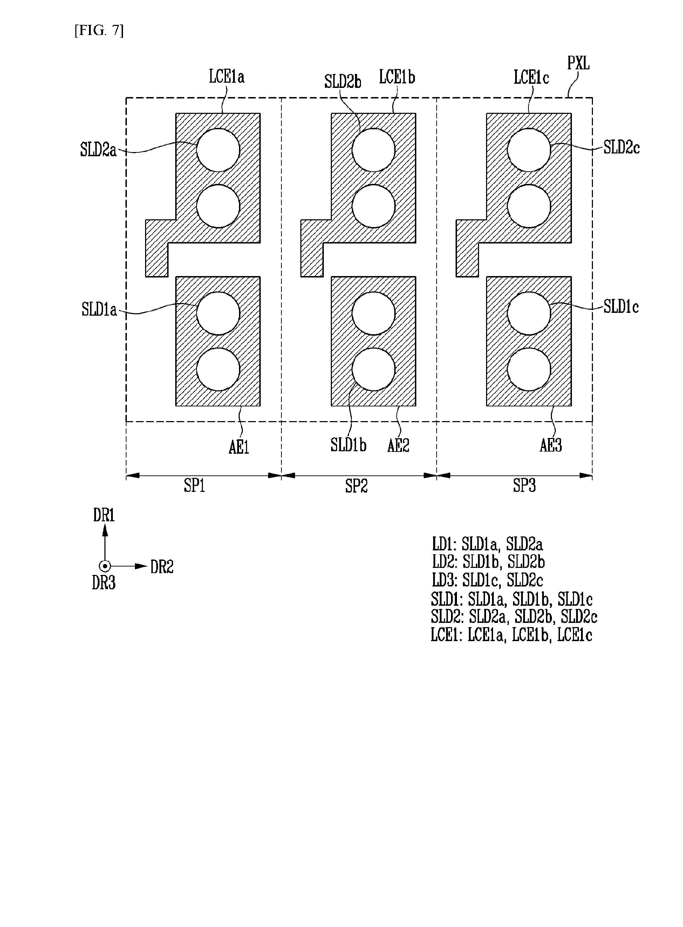

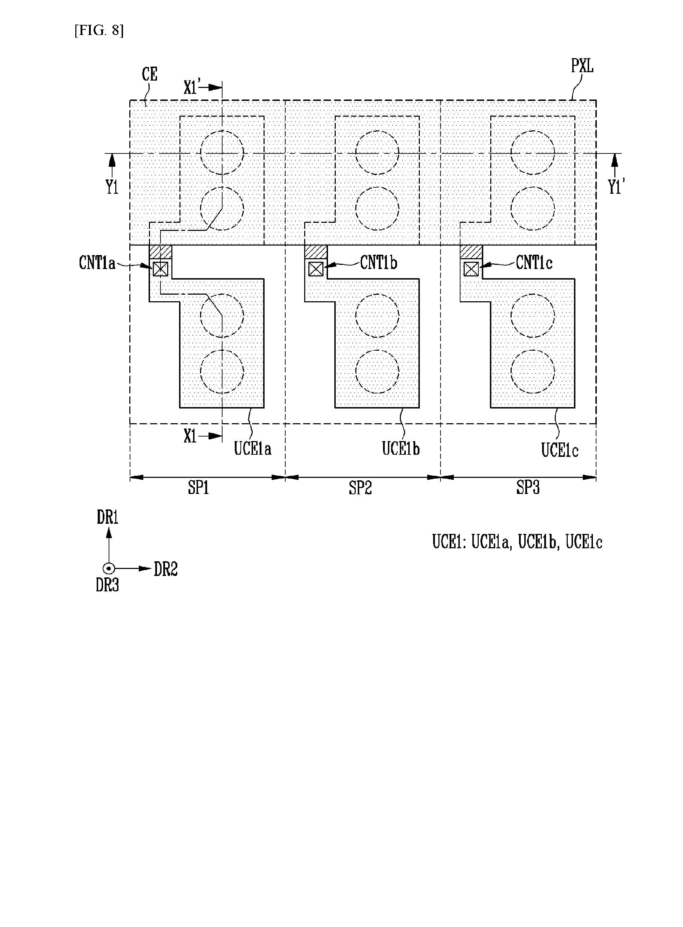

FIGS. 7 and 8 are schematic plan views illustrating a (1-1)-th embodiment of one of the pixels included in the display panel of FIG. 3.

Referring to FIG. 7, the pixel PXL may include the first to third sub-pixels SP1, SP2, and SP3. The first to third sub-pixels SP1, SP2, and SP3 may be arranged in the second direction DR2. However, an arrangement of the pixel PXL is not limited thereto and may variously change according to embodiments. For example, the first to third sub-pixels SP1, SP2, and SP3 may be arranged in a zigzag.

First to third anode electrodes AE1, AE2, and AE3 may be disposed in the first to third sub-pixels SP1, SP2, and SP3, respectively. The first anode electrode AE1 may be provided as the anode electrode AE (refer to FIG. 3) included in the sub-pixel circuit SPC (refer to FIG. 3) of the first sub-pixel SP1. The second anode electrode AE2 may be provided as the anode electrode AE included in the sub-pixel circuit SPC of the second sub-pixel SP2. The third anode electrode AE3 may be provided as the anode electrode AE included in the sub-pixel circuit SPC of the third sub-pixel SP3.

A first lower connection electrode LCE1 may be disposed in the first to third sub-pixels SP1, SP2, and SP3, respectively. The first lower connection electrode LCE1 may include a (1-1)-th lower connection electrode LCE1a, a (1-2)-th lower connection electrode LCE1b, and a (1-3)-th lower connection electrode LCE1c. The (1-1)-th lower connection electrode LCE1a may be provided in the first sub-pixel SP1 and may be spaced apart from the first anode electrode AE1. The (1-2)-th lower connection electrode LCE1b may be provided in the second sub-pixel SP2 and may be spaced apart from the second anode electrode AE2. The (1-3)-th lower connection electrode LCE1c may be provided in the third sub-pixel SP3 and may be spaced apart from the third anode electrode AE3. In embodiments, the (1-1)-th to (1-3)-th lower connection electrodes LCE1a, LCE1b, and LCE1c may be disposed in a same layer as the first to third anode electrodes AE1, AE2, and AE3. In this case, the (1-1)-th to (1-3)-th lower connection electrodes LCE1a, LCE1b, and LCE1c may be formed through a same formation process as the first to third anode electrodes AE1, AE2, and AE3.

The first sub light emitting element SLD1 may be disposed on the first to third anode electrodes AE1, AE2, and AE3, respectively. The first sub light emitting element SLD1 may include a (1-1)-th sub light emitting element SLD1a, a (1-2)-th sub light emitting element SLD1b, and a (1-3)-th sub light emitting element SLD1c. The (1-1)-th sub light emitting element SLD1a may be disposed on the first anode electrode AE1 to overlap the first anode electrode AE1. The (1-1)-th sub light emitting element SLD1a may be connected to the first anode electrode AE1. The (1-2)-th sub light emitting element SLD1b may be disposed on the second anode electrode AE2 to overlap the second anode electrode AE2. The (1-2)-th sub light emitting element SLD1b may be connected to the second anode electrode AE2. The (1-3)-th sub light emitting element SLD1c may be disposed on the third anode electrode AE3 to overlap the third anode electrode AE3. The (1-3)-th sub light emitting element SLD1c may be connected to the third anode electrode AE3.

In embodiments, each of the (1-1)-th to (1-3)-th sub light emitting elements SLD1a, SLD1b, and SLD1c may be provided. For example, as shown in FIG. 7, two (1-1)-th sub light emitting elements SLD1a may be provided on the first anode electrode AE1, two (1-2)-th sub light emitting elements SLD1b may be provided on the second anode electrode AE2, and two (1-3)-th sub light emitting elements SLD1c may be provided on the third anode electrode AE3. However, the disclosure is not limited thereto, and the number of the (1-1)-th to (1-3)-th sub light emitting elements SLD1a, SLD1b, and SLD1c disposed on the first to third anode electrodes AE1, AE2, and AE3 may variously change according to embodiments.

The second sub light emitting element SLD2 may be disposed on the (1-1)-th to (1-3)-th lower connection electrodes LCE1a, LCE1b, and LCE1c, respectively. The second sub light emitting element SLD2 may include a (2-1)-th sub light emitting element SLD2a, a (2-2)-th sub light emitting element SLD2b, and a (2-3)-th sub light emitting element SLD2c. The (2-1)-th sub light emitting element SLD2a may be disposed on the (1-1)-th lower connection electrode LCE1a to overlap the (1-1)-th lower connection electrode LCE1a. The (2-1)-th sub light emitting element SLD2a may be connected to the (1-1)-th lower connection electrode LCE1a. The (2-2)-th sub light emitting element SLD2b may be disposed on the (1-2)-th lower connection electrode LCE1b to overlap the (1-2)-th lower connection electrode LCE1b. The (2-2)-th sub light emitting element SLD2b may be connected to the (1-2)-th lower connection electrode LCE1b. The (2-3)-th sub light emitting element SLD2c may be disposed on the (1-3)-th lower connection electrode LCE1c to overlap the (1-3)-th lower connection electrode LCE1c. The (2-3)-th sub light emitting element SLD2c may be connected to the (1-3)-th lower connection electrode LCE1c.

In embodiments, each of the (2-1)-th to (2-3)-th sub light emitting elements SLD2a, SLD2b, and SLD2c may be provided. For example, as shown in FIG. 7, two (2-1)-th sub light emitting elements SLD2a may be provided on the (1-1)-th lower connection electrode LCE1a, two (2-2)-th sub light emitting elements SLD2b may be provided on the (1-2)-th lower connection electrode LCE1b, and two (2-3)-th sub light emitting elements SLD2c may be provided on the (1-3)-th lower connection electrode LCE1c. However, the disclosure is not limited thereto, and the number of the (2-1)-th to (2-3)-th sub light emitting elements SLD2a, SLD2b, and SLD2c may variously change according to embodiments.

The (1-1)-th sub light emitting element SLD1a and the (2-1)-th sub light emitting element SLD2a may be provided as the light emitting element LD (refer to FIG. 3) included in the first sub-pixel SP1. The (1-2)-th sub light emitting element SLD1b and the (2-2)-th sub light emitting element SLD2b may be provided as the light emitting element LD included in the second sub-pixel SP2. The (1-3)-th sub light emitting element SLD1c and the (2-3)-th sub light emitting element SLD2c may be provided as the light emitting element LD included in the third sub-pixel SP3. In this case, the (1-1)-th sub light emitting element SLD1a and the (2-1)-th sub light emitting element SLD2a may configure the first light emitting element LD1 of the first sub-pixel SP1, the (1-2)-th sub light emitting element SLD1b and the (2-2)-th sub light emitting element SLD2b may configure the second light emitting element LD2 of the second sub-pixel SP2, and the (1-3)-th sub light emitting element SLD1c and the (2-3)-th sub light emitting element SLD2c may configure the third light emitting element LD3 of the third sub-pixel SP3.

Each of the first to third light emitting elements LD1, LD2, and LD3 may be inorganic light emitting diodes including an inorganic light emitting material. However, embodiments are not limited thereto, and for example, organic light emitting diodes may be used.

Referring to FIG. 8, a first upper connection electrode UCE1 may be disposed in the first to third sub-pixels SP1, SP2, and SP3, respectively. The first upper connection electrode UCE1 may include a (1-1)-th upper connection electrode UCE1a, a (1-2)-th upper connection electrode UCE1b, and a (1-3)-th upper connection electrode UCE1c. The (1-1)-th upper connection electrode UCE1a may be provided in the first sub-pixel SP1 and may be disposed on the first anode electrode AE1 to face the first anode electrode AE1. The (1-2)-th upper connection electrode UCE1b may be provided in the second sub-pixel SP2 and may be disposed on the second anode electrode AE2 to face the second anode electrode AE2. The (1-3)-th upper connection electrode UCE1c may be provided in the third sub-pixel SP3 and may be disposed on the third anode electrode AE3 to face the third anode electrode AE3.

The (1-1)-th sub light emitting element SLD1a may be connected between the first anode electrode AE1 and the (1-1)-th upper connection electrode UCE1a. According to embodiments, in the case that (1-1)-th sub light emitting elements SLD1a are provided, the (1-1)-th sub light emitting elements SLD1a may be connected to each other in parallel between the first anode electrode AE1 and the (1-1)-th upper connection electrode UCE1a.

The (1-2)-th sub light emitting element SLD1b may be connected between the second anode electrode AE2 and the (1-2)-th upper connection electrode UCE1b. According to embodiments, in the case that (1-2)-th sub light emitting elements SLD1b are provided, the (1-2)-th sub light emitting elements SLD1b may be connected to each other in parallel between the second anode electrode AE2 and the (1-2)-th upper connection electrode UCE1b.

The (1-3)-th sub light emitting element SLD1c may be connected between the third anode electrode AE3 and the (1-3)-th upper connection electrode UCE1c. According to embodiments, in the case that (1-3)-th sub light emitting elements SLD1c are provided, the (1-3)-th sub light emitting elements SLD1c may be connected to each other in parallel between the third anode electrode AE3 and the (1-3)-th upper connection electrode UCE1c.

The cathode electrode CE may be commonly provided to the first to third sub-pixels SP1, SP2, and SP3. For example, the cathode electrode CE may be provided as a common electrode. For example, the cathode electrode CE may extend in the second direction DR2 and may be used as a common electrode for the pixel PXL and other pixels adjacent to the pixel PXL. Although not shown, the cathode electrode CE may extend not only in the second direction DR2 but also in the first direction DR1 and may be used as a common electrode for all of the sub-pixels SP of FIG. 4. As described above, the cathode electrode CE may have various shapes.

The cathode electrode CE may be disposed in the same layer as the (1-1)-th to (1-3)-th upper connection electrodes UCE1a, UCE1b, and UCE1c. For example, the cathode electrode CE may be formed through a same formation process as the (1-1)-th to (1-3)-th upper connection electrodes UCE1a, UCE1b, and UCE1c. The cathode electrode CE may be disposed on the (1-1)-th to (1-3)-th lower connection electrodes LCE1a, LCE1b, and LCE1c to face the (1-1)-th to (1-3)-th lower connection electrodes LCE1a, LCE1b, and LCE1c.

The (2-1)-th sub light emitting element SLD2a may be connected between the cathode electrode CE and the (1-1)-th lower connection electrode LCE1a. According to embodiments, in the case that (2-1)-th sub light emitting elements SLD2a are provided, the (2-1)-th sub light emitting elements SLD2a may be connected to each other in parallel between the (1-1)-th lower connection electrode LCE1a and the cathode electrode CE.

The (2-2)-th sub light emitting element SLD2b may be connected between the cathode electrode CE and the (1-2)-th lower connection electrode LCE1b. According to embodiments, in the case that (2-2)-th sub light emitting elements SLD2b are provided, the (2-2)-th sub light emitting elements SLD2b may be connected to each other in parallel between the (1-2)-th lower connection electrode LCE1b and the cathode electrode CE.

The (2-3)-th sub light emitting element SLD2c may be connected between the cathode electrode CE and the (1-3)-th lower connection electrode LCE1c. According to embodiments, in the case that (2-3)-th sub light emitting elements SLD2c are provided, the (2-3)-th sub light emitting elements SLD2c may be connected to each other in parallel between the (1-3)-th lower connection electrode LCE1c and the cathode electrode CE.

The (1-1)-th upper connection electrode UCE1a may be electrically connected to the (1-1)-th lower connection electrode LCE1a through a (1-1)-th contact hole CNT1a. In this case, between the first anode electrode AE1 and the cathode electrode CE, the (1-1)-th sub light emitting element SLD1a and the (2-1)-th sub light emitting element SLD2a may be connected to each other in series through the (1-1)-th upper connection electrode UCE1a and the (1-1)-th lower connection electrode LCE1a.

The (1-2)-th upper connection electrode UCE1b may be electrically connected to the (1-2)-th lower connection electrode LCE1b through a (1-2)-th contact hole CNT1b. In this case, between the second anode electrode AE2 and the cathode electrode CE, the (1-2)-th sub light emitting element SLD1b and the (2-2)-th sub light emitting element SLD2b may be connected to each other in series through the (1-2)-th upper connection electrode UCE1b and the (1-2)-th lower connection electrode LCE1b.

The (1-3)-th upper connection electrode UCE1c may be electrically connected to the (1-3)-th lower connection electrode LCE1c through a (1-3)-th contact hole CNT1b. In this case, between the third anode electrode AE3 and the cathode electrode CE, the (1-3)-th sub light emitting element SLD1c and the (2-3)-th sub light emitting elements SLD2c may be connected to each other in series through the (1-3)-th upper connection electrode UCE1c and the (1-3)-th lower connection electrode LCE1c.

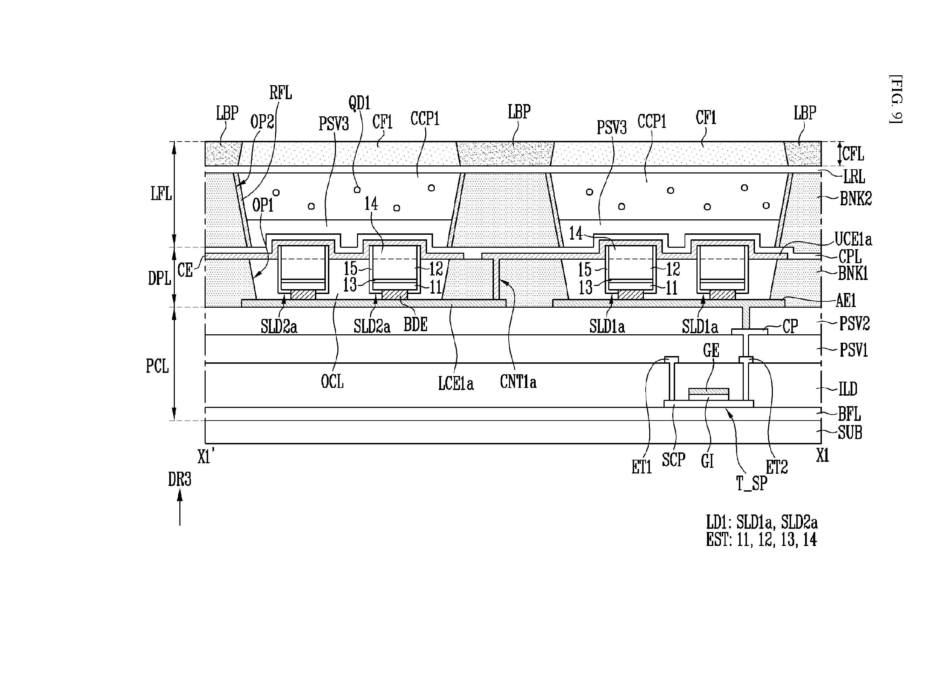

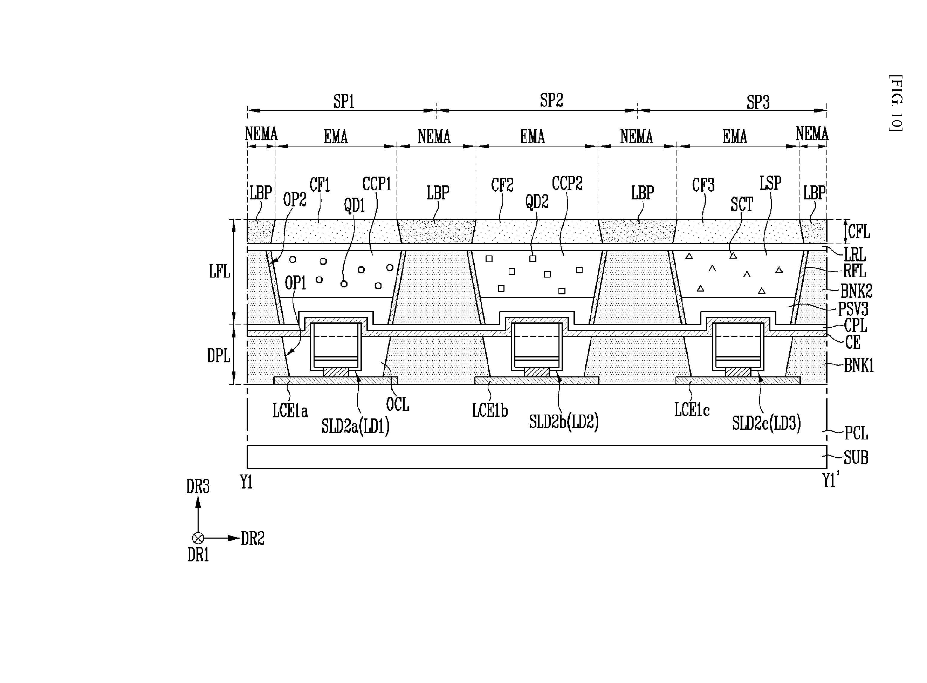

FIGS. 9 and 10 are schematic cross-sectional views illustrating a pixel according to the (1-1)-th embodiment of FIG. 8. FIG. 9 is a schematic cross-sectional view taken along line X1-X1' of FIG. 8, and FIG. 10 is a schematic cross-sectional view taken along line Y1-Y1' of FIG. 8.

Referring to FIGS. 7 to 9, the pixel circuit layer PCL, the display element layer DPL, and the light functional layer LFL may be sequentially disposed on the substrate SUB.

The pixel circuit layer PCL may include insulating layers, semiconductor patterns, and conductive patterns stacked each other on the substrate SUB. The insulating layers may include a buffer layer BFL, one or more interlayer insulating layers ILD, and one or more passivation layers PSV1 and PSV2. The semiconductor patterns and the conductive patterns may be positioned between the insulating layers. The conductive patterns may include at least one material among copper (Cu), molybdenum (Mo), tungsten (W), aluminium neodymium (AlNd), titanium (Ti), aluminium (Al), and silver (Ag).

As described with reference to FIGS. 2 and 3, the sub-pixel circuit SPC of each of the first to third sub-pixels SP1, SP2, and SP3 may include transistors and capacitors. The semiconductor patterns and the conductive patterns of the pixel circuit layer PCL may function as the transistors and the capacitors of the sub-pixel circuit SPC. The conductive patterns of the pixel circuit layer PCL may further functions as the lines, for example, the first to m-th gate lines GL1 to GLm, the first to n-th data lines DL1 to DLn, the power lines PL, and the pixel control lines PXCL of FIG. 1.

The buffer layer BFL may be disposed on one surface or a surface of the substrate SUB. The buffer layer BFL may serve to prevent an impurity from diffusing into the circuit elements and the lines included in the pixel circuit layer PCL. The buffer layer BFL may include an inorganic insulating layer including an inorganic material. In embodiments, the buffer layer BFL may include at least one of silicon nitride, silicon oxide, silicon oxynitride, and a metal oxide such as aluminium oxide. The buffer layer BFL may be provided as a single layer or multiple layers. In the case that the buffer layer BFL is provided as the multiple layers, each layer may be formed of a same material or may be formed of different materials.

In embodiments, one or more barrier layers may be disposed between the substrate SUB and the buffer layer BFL. Each of the barrier layers may include polyimide.

A transistor T_SP may be disposed on the buffer layer BFL. The transistor T_SP may be one of the transistors of the sub-pixel circuit SPC included in the first sub-pixel SP1. For example, the transistor T_SP may be a transistor connected to the first anode electrode AE1 among the transistors of the sub-pixel circuit SPC.

The transistor T_SP may include a semiconductor pattern SCP, a gate electrode GE, a first terminal ET1, and a second terminal ET2. The first terminal ET1 may be one of a source electrode and a drain electrode, and the second terminal ET2 may be the other one of the source electrode and the drain electrode. For example, the first terminal ET1 may be the source electrode, and the second terminal ET2 may be the drain electrode.

The semiconductor pattern SCP may be disposed on the buffer layer BFL. The semiconductor pattern SCP may include a first contact area contacting the first terminal ET1 and a second contact area contacting the second terminal ET2. An area between the first contact area and the second contact area may be a channel area. The channel area may overlap the gate electrode GE of the transistor T_SP. The channel area may be a semiconductor pattern that is not substantially doped with an impurity and may be an intrinsic semiconductor. The first contact area and the second contact area may be a semiconductor pattern doped with an impurity. As the impurity, for example, a p-type impurity may be used, but embodiments are not limited thereto.

The semiconductor pattern SCP may include one of various types of semiconductors, for example, an amorphous silicon semiconductor, a monocrystalline silicon semiconductor, a polycrystalline silicon semiconductor, a low temperature poly silicon semiconductor, and an oxide semiconductor.

The interlayer insulating layers ILD sequentially stacked each other may be disposed on the semiconductor pattern SCP. The interlayer insulating layers ILD may be inorganic insulating layers including an inorganic material. For example, each of the interlayer insulating layers ILD may include at least one of silicon nitride, silicon oxide, silicon oxynitride, and a metal oxide such as aluminium oxide. However, the interlayer insulating layers ILD are not limited thereto. For example, one of the interlayer insulating layers ILD may include an organic insulating layer including an organic material.

The interlayer insulating layers ILD may electrically separate conductive patterns and/or semiconductor patterns disposed between the interlayer insulating layers ILD from each other. For example, the interlayer insulating layers ILD may include a gate insulating layer GI disposed on the semiconductor pattern SCP. The gate insulating layer GI may be disposed between the semiconductor pattern SCP and the gate electrode GE so that the gate electrode GE is spaced apart from the semiconductor pattern SCP. In embodiments, the gate insulating layer GI may be provided entirely on the semiconductor pattern SCP and the buffer layer BFL to cover the semiconductor pattern SCP and the buffer layer BFL. As the number of layers required to form the conductive patterns and/or the semiconductor patterns increases, the number of interlayer insulating layers ILD may increase.

The gate electrode GE may be disposed on the gate insulating layer GI. The gate electrode GE may overlap the channel area of the semiconductor pattern SCP. In embodiments, the gate electrode GE may be provided as a single layer including at least one material among copper (Cu), molybdenum (Mo), tungsten (W), aluminium neodymium (AlNd), titanium (Ti), aluminium (Al), and silver (Ag). In embodiments, the gate electrode GE may be provided as multiple layers including at least one material among molybdenum (Mo), titanium (Ti), copper (Cu), aluminium (Al), and silver (Ag), which are low-resistance materials.

The first and second terminals ET1 and ET2 may be disposed on the interlayer insulating layers ILD. The first and second terminals ET1 and ET2 may contact the semiconductor pattern SCP through contact holes passing through the interlayer insulating layers ILD. The first and second terminals ET1 and ET2 may respectively contact the first and second contact areas of the semiconductor pattern SCP. Each of the first and second terminals ET1 and ET2 may include at least one material among copper (Cu), molybdenum (Mo), tungsten (W), aluminium neodymium (AlNd), titanium (Ti), aluminium (Al), and silver (Ag).

In embodiments, the transistor T_SP may be configured of a low-temperature polysilicon transistor. However, embodiments are not limited thereto. For example, the transistor T_SP may be configured of an oxide semiconductor transistor. In embodiments, the sub-pixel circuit SPC of the first sub-pixel SP1 may include different types of transistors. For example, the transistor T_SP may be configured of a low-temperature polysilicon transistor, and another transistor included in the sub-pixel circuit SPC of the first sub-pixel SP1 may be configured of an oxide semiconductor transistor. In this case, the oxide semiconductor of the corresponding oxide semiconductor transistor may be disposed on one of the interlayer insulating layers ILD rather than the insulating layer on which the semiconductor pattern SCP of the transistor T_SP is disposed.

In embodiments, a case where the transistor T_SP is a transistor of a top gate structure is described as an example, but embodiments are not limited thereto. For example, the transistor T_SP may be a transistor of a bottom gate structure. A structure of the transistor T_SP may be variously changed.

At least some of the various lines of the display panel DP and/or the display device DD may be further disposed on the interlayer insulating layers ILD.

The first passivation layer PSV1 may be disposed on the interlayer insulating layers ILD and the first and second terminals ET1 and ET2. The first passivation layer PSV1 may be referred to as a protective layer or a via layer. The first passivation layer PSV1 may protect components disposed under (or below) the first passivation layer PSV1 and may provide a flat upper surface.

A connection pattern CP may be disposed on the first passivation layer PSV1. The connection pattern CP may be connected to the second terminal ET2 of the transistor T_SP by passing through the first passivation layer PSV1. The connection pattern CP may include at least one material among copper (Cu), molybdenum (Mo), tungsten (W), aluminium neodymium (AlNd), titanium (Ti), aluminium (Al), and silver (Ag).

At least some of the various lines of the display panel DP and/or the display device DD may be further disposed on the first passivation layer PSV1.

The second passivation layer PSV2 may be disposed on the connection pattern CP and the first passivation layer PSV1. The second passivation layer PSV2 may protect components disposed under the second passivation layer PSV2 and may provide a flat upper surface.

Each of the first and second passivation layers PSV1 and PSV2 may include an inorganic insulating layer including an inorganic material and/or an organic insulating layer including an organic material. The inorganic insulating layer may include, for example, at least one of silicon oxide, silicon nitride, silicon oxynitride, and a metal oxide such as aluminium oxide. The organic insulating layer may include, for example, at least one of acrylic resin, epoxy resin, phenol resin, polyamide resin, polyimide resin, unsaturated polyester resin, poly-phenylene ether resin, poly-phenylene sulfide resin, and benzocyclobutene resin.

The first and second passivation layers PSV1 and PSV2 may include a same material as one of the interlayer insulating layers ILD, but embodiments are not limited thereto. Each of the first and second passivation layers PSV1 and PSV2 may be provided as a single layer, but may also be provided as multiple layers.

The display element layer DPL may be disposed on the second passivation layer PSV2. The display element layer DPL may include the first anode electrode AE1, the (1-1)-th lower connection electrode LCE1a, a first bank BNK1, the first light emitting element LD1, the (1-1)-th upper connection electrode UCE1a, the cathode electrode CE, an overcoat layer OCL, and a capping layer CPL.

The first anode electrode AE1 and the (1-1)-th lower connection electrode LCE1a may be disposed on the pixel circuit layer PCL. The first anode electrode AE1 may be electrically connected to the connection pattern CP through a contact hole passing through the second passivation layer PSV2. As described above, the first anode electrode AE1 may be electrically connected to the transistor T_SP. The (1-1)-th lower connection electrode LCE1a may be spaced apart from the first anode electrode AE1.

The first bank BNK1 may be disposed on the pixel circuit layer PCL, the first anode electrode AE1, and the (1-1)-th lower connection electrode LCE1a. The first bank BNK1 may have a first opening OP1 exposing portions of the first anode electrode AE1 and the (1-1)-th lower connection electrode LCE1a. The (1-1)-th sub light emitting element SLD1a may be disposed on the first anode electrode AE1 exposed by the first opening OP1 of the first bank BNK1. The (2-1)-th sub light emitting element SLD2a may be disposed on the (1-1)-th lower connection electrode LCE1a exposed by the first opening OP1 of the first bank BNK1. As described above, the first bank BNK1 may be provided as a pixel defining layer that defines an area where the first light emitting element LD1 is positioned.

The first bank BNK1 may be configured to include a light blocking material to prevent light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first light emitting element LD1 may include a light emitting stack EST and a bonding electrode BDE. The light emitting stack EST may include a first semiconductor layer 11, a second semiconductor layer 12, an active layer 13, and an auxiliary layer 14. The first light emitting element LD1 may be implemented as a vertical light emitting stack in which the bonding electrode BDE, the first semiconductor layer 11, the active layer 13, the second semiconductor layer 12, and the auxiliary layer 14 may be sequentially stacked each other along the third direction DR3.

The first semiconductor layer 11 may be configured to provide a hole. The first semiconductor layer 11 may have a first polarity. For example, the first semiconductor layer 11 may include at least one p-type semiconductor layer. For example, the first semiconductor layer 11 may include at least one semiconductor material among gallium nitride (GaN), aluminium gallium nitride (AlGaN), indium gallium nitride (InGaN), aluminium nitride (AlN), and indium nitride (InN), and may be a p-type semiconductor layer doped with a first conductive dopant (or a p-type dopant), such as magnesium (Mg), zinc (Zn), calcium (Ca), strontium (Sr), and barium (Ba). However, a material configuring the first semiconductor layer 11 is not limited thereto, and various other materials may configure the first semiconductor layer 11. In an embodiment of the disclosure, the first semiconductor layer 11 may include a gallium nitride (GaN) semiconductor material doped with the first conductive dopant (or the p-type dopant).

The second semiconductor layer 12 is disposed on the first semiconductor layer 11 and may be configured to provide an electron. The second semiconductor layer 12 may have a second polarity different from the first polarity. For example, the second semiconductor layer 12 may include at least one n-type semiconductor layer. For example, the second semiconductor layer 12 may include one semiconductor material among gallium nitride (GaN), aluminium gallium nitride (AlGaN), indium gallium nitride (InGaN), aluminium nitride (AlN), and indium nitride (InN), and may be an n-type semiconductor layer doped with a second conductive dopant (or an n-type dopant) such as silicon (Si), germanium (Ge), and tin (Sn). However, a material configuring the second semiconductor layer 12 is not limited thereto, and various other materials may configure the second semiconductor layer 12. In an embodiment of the disclosure, the second semiconductor layer 12 may include a gallium nitride (GaN) semiconductor material doped with the second conductive dopant (or the n-type dopant). According to an embodiment, the second semiconductor layer 12 may configure the n-type semiconductor layer together with the auxiliary layer 14.

The active layer 13 may be between the first semiconductor layer 11 and the second semiconductor layer 12 and may provide an area where the electron and the hole are recombined. As the electron and the hole recombine in the active layer 13, the electron and the hole may transit to a lower energy level, and thus light having a wavelength corresponding thereto may be generated. The active layer 13 may be formed as a single or multiple quantum wells structure. In the case that the active layer 13 is formed as the multiple quantum wells structure, a unit including a barrier layer, a strain reinforcing layer, and a well layer may be repeatedly stacked each other to form the active layer 13. However, the active layer 13 is not limited to the above-described structure.

The auxiliary layer 14 may include a gallium nitride (GaN) semiconductor material in which an impurity is not substantially doped or an impurity is doped with a relatively low concentration. The auxiliary layer 14 may configure the n-type semiconductor layer together with the second semiconductor layer 12.

The bonding electrode BDE may be disposed under the first semiconductor layer 11. The bonding electrode BDE may be electrically connected to the first semiconductor layer 11. In embodiments, the bonding electrode BDE of the (1-1)-th sub light emitting element SLD1a may be electrically connected to the first anode electrode AE1. The bonding electrode BDE of the (2-1)-th sub light emitting element SLD2a may be electrically connected to the (1-1)-th lower connection electrode LCE1a. The bonding electrode BDE may include a eutectic metal.

The first light emitting element LD1 may further include an insulating layer 15 covering an outer peripheral surface of the vertical light emitting stack. The insulating layer 15 may serve to prevent an electrical short circuit that may occur in the case that the active layer 13 comes into contact with a conductive material other than the first and second semiconductor layers 11 and 12. The insulating layer 15 may include a transparent insulating material. The insulating layer 15 may be configured to expose at least a portion of the bonding electrode BDE for an electrical connection with the first anode electrode AE1 or the (1-1)-th lower connection electrode LCE1a. The insulating layer 15 may be configured to expose an upper surface of the auxiliary layer 14 for an electrical connection with the cathode electrode CE or the (1-1)-th upper connection electrode UCE1a.

In embodiments, a reflective electrode may be further disposed between the bonding electrode BDE and the first semiconductor layer 11. In this case, light emitted from the first light emitting element LD1 may be more efficiently output toward the light functional layer LFL. The reflective electrode may be configured of a conductive material having a selectable reflectance. The conductive material may include an opaque metal. The opaque metal may include, for example, a metal such as silver (Ag), magnesium (Mg), aluminium (Al), platinum (Pt), palladium (Pd), gold (Au), nickel (Ni), neodymium (Nd), iridium (Ir), chromium (Cr), titanium (Ti), and an alloy thereof. However, a material of the reflective electrode is not limited thereto.

The overcoat layer OCL may be disposed in the first openings OP1 where the first light emitting element LD1 is disposed. The overcoat layer OCL may fix the first light emitting element LD1 bonded to the first anode electrode AE1 and the (1-1)-th lower connection electrode LCE1a so that the first light emitting element LD1 does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

In embodiments, the overcoat layer OCL may not be disposed on an upper surface of the first light emitting element LD1. For example, the first light emitting element LD1 may protrude to the light functional layer LFL. The first light emitting element LD1 may be positioned at least partially in the second opening OP2 of the second bank BNK2. For example, a height of the upper surface of the first light emitting element LD1 from the substrate SUB may be higher than the lowermost end of a reflective layer RFL. Accordingly, the light emitted from the first light emitting element LD1 may be provided to the light functional layer LFL at a relatively high rate.

The (1-1)-th upper connection electrode UCE1a may be disposed on the (1-1)-th sub light emitting element SLD1a. The (1-1)-th upper connection electrode UCE1a may be disposed to face the first anode electrode AE1. The (1-1)-th upper connection electrode UCE1a may cover an upper surface of the (1-1)-th sub light emitting element SLD1a. Accordingly, the (1-1)-th upper connection electrode UCE1a may contact the auxiliary layer 14 of the (1-1)-th sub light emitting element SLD1a.

The cathode electrode CE may be disposed on the (2-1)-th sub light emitting element SLD2a. The cathode electrode CE may be disposed to face the (1-1)-th lower connection electrode LCE1a. The cathode electrode CE may cover an upper surface of the (2-1)-th sub light emitting element SLD2a. Accordingly, the cathode electrode CE may contact the auxiliary layer 14 of the (2-1)-th sub light emitting element SLD2a.

The cathode electrode CE may be electrically connected to the second power voltage node VSSN (refer to FIG. 2). Accordingly, the second power voltage applied to the second power voltage node VSSN may be transmitted to the (2-1)-th sub light emitting element SLD2a through the cathode electrode CE.

The (1-1)-th upper connection electrode UCE1a may be electrically connected to the (1-1)-th lower connection electrode LCE1a. For example, the (1-1)-th upper connection electrode UCE1a may be electrically connected to the (1-1)-th lower connection electrode LCE1a through the (1-1)-th contact hole CNT1a formed in the first bank BNK1. The auxiliary layer 14 of the (1-1)-th sub light emitting element SLD1a and the bonding electrode BDE of the (2-1)-th sub light emitting element SLD2a may be connected through the (1-1)-th upper connection electrode UCE1a and the (1-1)-th lower connection electrode LCE1a. Accordingly, the (1-1)-th sub light emitting element SLD1a and the (2-1)-th sub light emitting element SLD2a may be connected to each other in series between the cathode electrode CE and the first anode electrode AE1.

The (1-1)-th upper connection electrode UCE1a and the cathode electrode CE may be configured to be substantially transparent or translucent to satisfy a selectable light transmittance. In embodiments, the (1-1)-th upper connection electrode UCE1a and the cathode electrode CE may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, a material of the (1-1)-th upper connection electrode UCE1a and the cathode electrode CE is not limited thereto.

The capping layer CPL may be disposed on the (1-1)-th upper connection electrode UCE1a and the cathode electrode CE. The capping layer CPL may protect components under the capping layer CPL, such as the (1-1)-th upper connection electrode UCE1a, the cathode electrode CE, and the first light emitting element LD1, from external water, moisture, and the like within the spirit and the scope of the disclosure. The capping layer CPL may include at least one of silicon nitride, silicon oxide, silicon oxynitride, and a metal oxide such as aluminium oxide. However, a material of the capping layer CPL is not limited thereto.

Above, the pixel circuit layer PCL and the display element layer DPL of the first sub-pixel SP1 are described. Each of the second and third sub-pixels SP2 and SP3 of FIGS. 7 and 8 may be configured similarly to the first sub-pixel SP1 unless otherwise described herein.

The light functional layer LFL may be disposed on the capping layer CPL. The light functional layer LFL may include a second bank BNK2, a reflective layer RFL, a third passivation layer PSV3, a first light conversion pattern CCP1, a low refractive layer LRL, and a color filter layer CFL.

The second bank BNK2 may be disposed on the capping layer CPL. The second bank BNK2 may overlap the first bank BNK1. The second bank BNK2 may have a second opening OP2 overlapping the first opening OP1.

The second bank BNK2 may be configured to include a light blocking material, thereby preventing light mixing between adjacent sub-pixels. In embodiments, the second bank BNK2 may include an organic material. For example, the second bank BNK2 may include an organic insulating material such as acryl resin, epoxy resin, phenol resin, polyamide resin, and polyimide resin.

The reflective layer RFL may be disposed on side surfaces of the second bank BNK2 adjacent to the second opening OP2. The reflective layer RFL may be configured to reflect incident light, and thus light output efficiency may be improved. The reflective layer RFL may include a material suitable for reflecting light. The reflective layer RFL may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The third passivation layer PSV3 may be disposed in the second opening OP2, on the capping layer CPL. The third passivation layer PSV3 may protect components disposed under the third passivation layer PSV3 and may provide a flat upper surface. The third passivation layer PSV3 may include a same material as one of the first and second passivation layers PSV1 and PSV2, but embodiments are not limited thereto.

The first light conversion pattern CCP1 may be disposed in the second opening OP2, on the third passivation layer PSV3. The first light conversion pattern CCP1 may include color conversion particles and/or scattering particles. The color conversion particles may change a wavelength of incident light and convert the incident light into light of another color. The color conversion particles may scatter the incident light. In embodiments, the color conversion particles may be quantum dots. The scattering particles may scatter the incident light.

The first sub-pixel SP1 may be a red sub-pixel. In the case that the first light emitting element LD1 emits light of a blue color, the first light conversion pattern CCP1 may include first color conversion particles QD1 configured to convert the light of the blue color into light of a red color. In the case that the first light emitting element LD1 emits the light of the red color, the first light conversion pattern CCP1 may include the scattering particles. As described above, particles included in the first light conversion pattern CCP1 may be variously changed according to a color of the light emitted by the first light emitting element LD1.

The low refractive layer LRL may be disposed on the second bank BNK2, the reflective layer RFL, and the first light conversion pattern CCP1. The low refractive layer LRL may have a refractive index lower than that of the first light conversion pattern CCP1. The low refractive layer LRL may be configured to refract or totally reflect corresponding light according to an incidence angle of the light. For example, the low refractive layer LRL may provide light passing through the first light conversion pattern CCP1 back to the first light conversion pattern CCP1. Accordingly, light conversion efficiency of the first light conversion pattern CCP1 may be improved.

The color filter layer CFL may be disposed on the low refractive layer LRL. The color filter layer CFL may include a first color filter CF1 and light blocking patterns LBP. The first color filter CF1 may overlap the first light conversion pattern CCP1. The first color filter CF1 may selectively transmit light of a desired wavelength range. In the case that the first sub-pixel SP1 is a red sub-pixel, the first color filter CF1 may include a red color filter. The light blocking patterns LBP may include at least one of various types of light blocking materials.

Referring to FIGS. 7, 8, and 10, the pixel circuit layer PCL, the display element layer DPL, and the light functional layer LFL may be sequentially provided on the substrate SUB.

The pixel circuit layer PCL and the display element layer DPL are described similarly to those described with reference to FIG. 9. In the pixel circuit layer PCL, the sub-pixel circuits respectively corresponding to the first to third sub-pixels SP1, SP2, and SP3 may be provided. In the display element layer DPL, the first to third light emitting elements LD1, LD2, and LD3 respectively corresponding to the first to third sub-pixels SP1, SP2, and SP3 may be provided. The first to third light emitting elements LD1, LD2, and LD3 may overlap the first openings OP1 of the first bank BNK1. The first light emitting element LD1 may be connected between the cathode electrode CE (refer to FIG. 9) and the transistor T_SP (refer to FIG. 9) included in the sub-pixel circuit of the first sub-pixel SP1. The second light emitting element LD2 may be connected between the cathode electrode CE and the transistor included in the sub-pixel circuit of the second sub-pixel SP2. The third light emitting element LD3 may be connected between the cathode electrode CE and the transistor included in the sub-pixel circuit of the third sub-pixel SP3. Below, a description of an overlapping content may be omitted.

The light functional layer LFL may be provided on the display element layer DPL. The light functional layer LFL is described similarly to that described with reference to FIG. 9. Below, a description of an overlapping content may be omitted.

The second bank BNK2 may have second openings OP2. It may be understood that the emission area EMA and the non-emission area NEMA for the first to third sub-pixels SP1, SP2, and SP3 are defined by the second bank BNK2. An area overlapping the second bank BNK2 may correspond to the non-emission area NEMA. An area overlapping the second openings OP2 of the second bank BNK2 may correspond to the emission area EMA of the first to third sub-pixels SP1, SP2, and SP3.

The third passivation layer PSV3 may be disposed in the second openings OP2, on the capping layer CPL. First and second light conversion patterns CCP1 and CCP2 and a light scattering pattern LSP may be disposed in the second openings OP2, on the third passivation layer PSV3.

In embodiments, the first to third light emitting elements LD1, LD2, and LD3 may be configured to emit light of a blue color. In this case, the first light conversion pattern CCP1 may include first color conversion particles QD1 configured to convert the light of the blue color into light of a red color. The second light conversion pattern CCP2 may include second color conversion particles QD2 configured to convert the light of the blue color into light of a green color. The light scattering pattern LSP may include scattering particles SCT that scatter the light of the blue color to improve light output efficiency. Accordingly, the first to third sub-pixels SP1, SP2, and SP3 may be provided as a red sub-pixel, a green sub-pixel, and a blue sub-pixel, respectively. In embodiments, at least one of the first and second light conversion patterns CCP1 and CCP2 and the light scattering pattern LSP may further include color conversion particles that convert the light of the blue color into light of a white color.

In embodiments, the first to third light emitting elements LD1, LD2, and LD3 may be configured to emit the light of the red color, the green color, and the blue color, respectively. In this case, each of the first and second light conversion patterns CCP1 and CCP2 and the light scattering pattern LSP may include scattering particles SCT. As described above, according to a color of light emitted from the first to third light emitting elements LD1, LD2, and LD3, particles included in the first and second light conversion patterns CCP1 and CCP2 and the light scattering pattern LSP may be variously changed.

In embodiments, the first and second light conversion patterns CCP1 and CCP2 and the light scattering pattern LSP may be omitted.

The low refractive layer LRL may be disposed on the second bank BNK2, the reflective layer RFL, the first and second light conversion patterns CCP1 and CCP2, and the light scattering pattern LSP. The low refractive layer LRL may have a refractive index lower than that of the first and second light conversion patterns CCP1 and CCP2 and the light scattering pattern LSP. In embodiments, the low refractive layer LRL may be omitted in an area corresponding to the third sub-pixel SP3.

The color filter layer CFL may be disposed on the low refractive layer LRL. The color filter layer CFL may include first to third color filters CF1, CF2, and CF3, and light blocking patterns LBP.

Each of the first to third color filters CF1, CF2, and CF3 may selectively transmit light of a desired wavelength range. In the case that the first sub-pixel SP1 is a red sub-pixel, the first color filter CF1 may include a red color filter. In the case that the second sub-pixel SP2 is a green sub-pixel, the second color filter CF2 may include a green color filter. In the case that the third sub-pixel SP3 is a blue sub-pixel, the third color filter CF3 may include a blue color filter. The first to third color filters CF1, CF2, and CF3 may have a refractive index higher than that of the low refractive layer LRL. However, embodiments are not limited thereto, and the first to third color filters CF1, CF2, and CF3 may have a refractive index lower than or equal to that of the low refractive layer LRL.

The light blocking patterns LBP may be disposed between the first to third color filters CF1, CF2, and CF3. It may be understood that the emission area (or a light output area) EMA and the non-emission area NEMA for the first to third sub-pixels SP1, SP2, and SP3 are defined by the light blocking patterns LBP. An area overlapping the light blocking patterns LBP may correspond to the non-emission area NEMA. An area that does not overlap the light blocking patterns LBP may correspond to the emission area EMA.

In embodiments, the light blocking patterns LBP may include at least one of various types of light blocking materials. In embodiments, each of the light blocking patterns LBP may be provided in a form of multiple layers in which at least two color filters among the first to third color filters CF1, CF2, and CF3 overlap. For example, each of the light blocking patterns LBP may be formed by overlapping the first to third color filters CF1, CF2, and CF3. As another example, a light blocking pattern between the first and second color filters CF1 and CF2 among the light blocking patterns LBP may be formed as multiple layers in which the first and second color filters CF1 and CF2 overlap, a light blocking pattern between the second and third color filters CF2 and CF3 among the light blocking patterns LBP may be formed as multiple layers in which the second and third color filters CF2 and CF3 overlap, and a light blocking pattern between the first color filter CF1 and the third color filter CF3 of a neighboring pixel may be formed as multiple layers in which the first and third color filters CF1 and CF3 overlap. As described above, each of the first to third color filters CF1, CF2, and CF3 may extend to the non-emission area NEMA to form the light blocking patterns LBP.

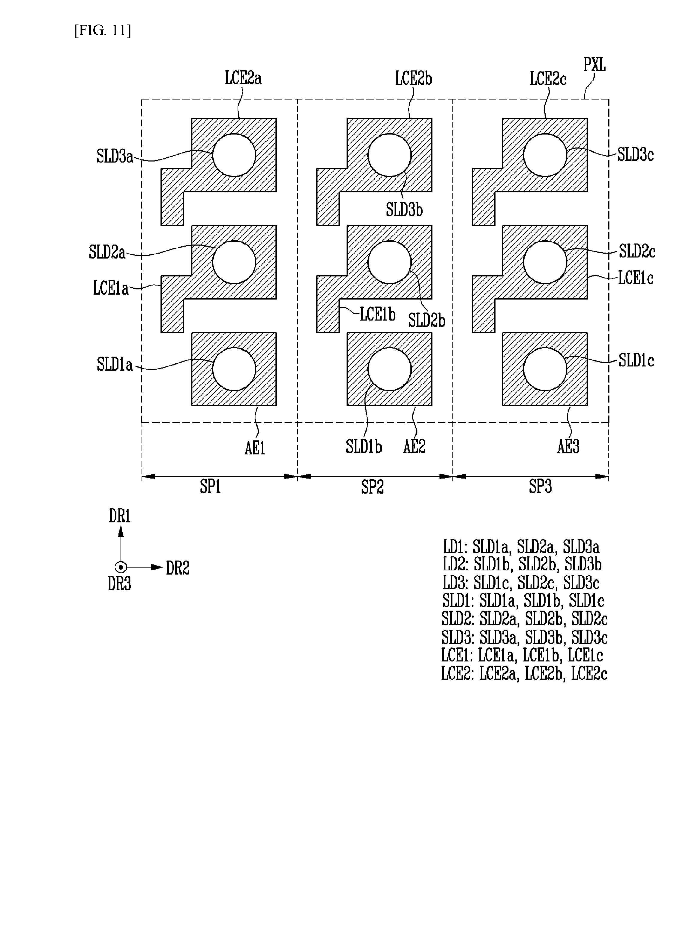

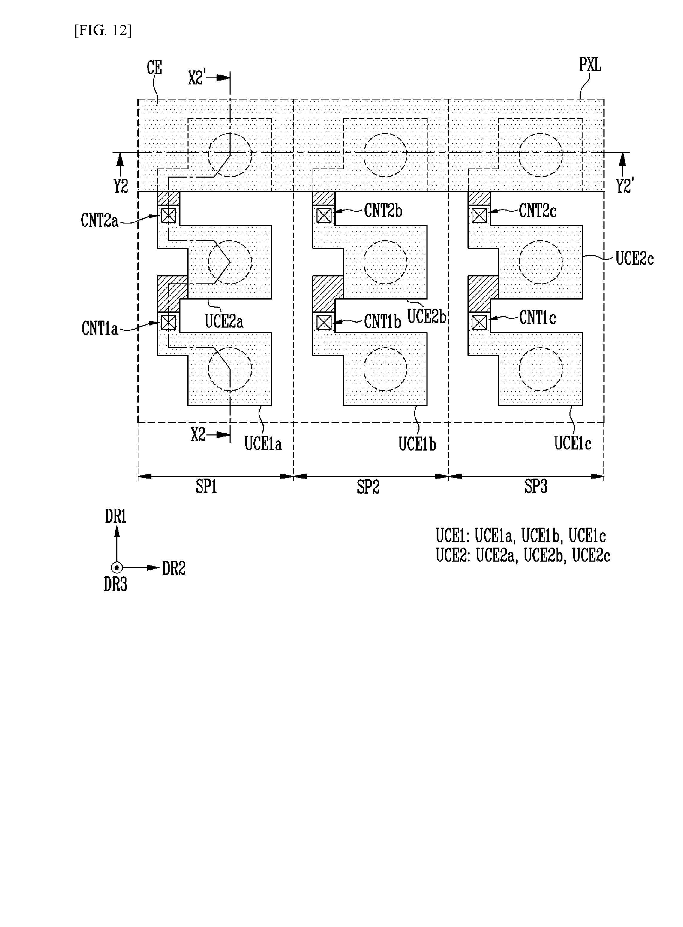

FIGS. 11 and 12 are schematic plan views illustrating a (1-2)-th embodiment of one of the pixels included in the display panel of FIG. 3.

Referring to FIG. 11, the pixel PXL may include the first to third sub-pixels SP1, SP2, and SP3. The first to third sub-pixels SP1, SP2, and SP3 may be arranged in the second direction DR2. However, an arrangement of the pixel PXL is not limited thereto and may variously change according to embodiments. For example, the first to third sub-pixels SP1, SP2, and SP3 may be arranged in a zigzag.

First to third anode electrodes AE1, AE2, and AE3 may be disposed in the first to third sub-pixels SP1, SP2, and SP3, respectively. The first to third anode electrodes AE1, AE2, and AE3 may be configured similarly to those described with reference to FIG. 7.

A first lower connection electrode LCE1 may be disposed in the first to third sub-pixels SP1, SP2, and SP3, respectively. The first lower connection electrode LCE1 may include a (1-1)-th lower connection electrode LCE1a, a (1-2)-th lower connection electrode LCE1b, and a (1-3)-th lower connection electrode LCE1c. The (1-1)-th to (1-3)-th lower connection electrodes LCE1a, LCE1b, and LCE1c may be configured similarly to those described with reference to FIG. 7.

A second lower connection electrode LCE2 may be disposed in the first to third sub-pixels SP1, SP2, and SP3, respectively. The second lower connection electrode LCE2 may include a (2-1)-th lower connection electrode LCE2a, a (2-2)-th lower connection electrode LCE2b, and a (2-3)-th lower connection electrode LCE2c. The (2-1)-th lower connection electrode LCE2a may be provided in the first sub-pixel SP1 and may be spaced apart from the first anode electrode AE1 and the (1-1)-th lower connection electrode LCE1a. The (2-2)-th lower connection electrode LCE2b may be provided in the second sub-pixel SP2 and may be spaced apart from the second anode electrode AE2 and the (1-2)-th lower connection electrode LCE1b. The (2-3)-th lower connection electrode LCE2c may be provided in the third sub-pixel SP3 and may be spaced apart from the third anode electrode AE3 and the (1-3)-th lower connection electrode LCE1c. In embodiments, the (2-1)-th to (2-3)-th lower connection electrodes LCE2a, LCE2b, and LCE2c may be disposed in a same layer as the first to third anode electrodes AE1, AE2, and AE3 and the (1-1)-th to (1-3)-th lower connection electrodes LCE1a, LCE1b, and LCE1c. In this case, the (2-1)-th to (2-3)-th lower connection electrodes LCE2a, LCE2b, and LCE2c may be formed through a same formation process as the first to third anode electrodes AE1, AE2, and AE3 and the (1-1)-th to (1-3)-th lower connection electrodes LCE1a, LCE1b, and LCE1c.

The first sub light emitting element SLD1 may be disposed on the first to third anode electrodes AE1, AE2, and AE3, respectively. The first sub light emitting element SLD1 may include a (1-1)-th sub light emitting element SLD1a, a (1-2)-th sub light emitting element SLD1b, and a (1-3)-th sub light emitting element SLD1c. The (1-1)-th to (1-3)-th sub light emitting elements SLD1a, SLD1b, and SLD1c may be configured similarly to those described with reference to FIG. 7.

In FIG. 11, each of the (1-1)-th to (1-3)-th sub light emitting elements SLD1a, SLD1b, and SLD1c is provided one by one, but the disclosure is not limited thereto. For example, as described with reference to FIG. 7, each of the (1-1)-th to (1-3)-th sub light emitting elements SLD1a, SLD1b, and SLD1c may be provided.

The second sub light emitting element SLD2 may be disposed on the (1-1)-th to (1-3)-th lower connection electrodes LCE1a, LCE1b, and LCE1c, respectively. The second sub light emitting element SLD2 may include a (2-1)-th sub light emitting element SLD2a, a (2-2)-th sub light emitting element SLD2b, and a (2-3)-th sub light emitting element SLD2c. The (2-1)-th to (2-3)-th sub light emitting elements SLD2a, SLD2b, and SLD2c may be configured similarly to those described with reference to FIG. 7.

In FIG. 11, each of the (2-1)-th to (2-3)-th sub light emitting elements SLD2a, SLD2b, and SLD2c is provided one by one, but the disclosure is not limited thereto. For example, as described with reference to FIG. 7, each of the (2-1)-th to (2-3)-th sub light emitting elements SLD2a, SLD2b, and SLD2c may be provided.

A third sub light emitting element SLD3 may be disposed on the (2-1)-th to (2-3)-th lower connection electrodes LCE2a, LCE2b, and LCE2c, respectively. The third sub light emitting element SLD3 may include a (3-1)-th sub light emitting element SLD3a, a (3-2)-th sub light emitting element SLD3b, and a (3-3)-th sub light emitting element SLD3c. The (3-1)-th sub light emitting element SLD3a may be disposed on the (2-1)-th lower connection electrode LCE2a to overlap the (2-1)-th lower connection electrode LCE2a. The (3-1)-th sub light emitting element SLD3a may be connected to the (2-1)-th lower connection electrode LCE2a. The (3-2)-th sub light emitting element SLD3b may be disposed on the (2-2)-th lower connection electrode LCE2b to overlap the (2-2)-th lower connection electrode LCE2b. The (3-2)-th sub light emitting element SLD3b may be connected to the (2-2)-th lower connection electrode LCE2b. The (3-3)-th sub light emitting element SLD3c may be disposed on the (2-3)-th lower connection electrode LCE2c to overlap the (2-3)-th lower connection electrode LCE2c. The (3-3)-th sub light emitting element SLD3c may be connected to the (2-3)-th lower connection electrode LCE2c.

In FIG. 11, each of the (3-1)-th to (3-3)-th sub light emitting elements SLD3a, SLD3b, and SLD3c is provided one by one, but the disclosure is not limited thereto. Each of the (3-1)-th to (3-3)-th sub light emitting elements SLD3a, SLD3b, and SLD3c may be provided. For example, two or more (3-1)-th sub light emitting elements SLD3a may be provided on the (2-1)-th lower connection electrode LCE2a, and in this case, each of the (3-1)-th sub light emitting elements SLD3a may overlap the (2-1)-th lower connection electrode LCE2a and may be connected to the (2-1)-th lower connection electrode LCE2a.

The (1-1)-th sub light emitting element SLD1a, the (2-1)-th sub light emitting element SLD2a, and the (3-1)-th sub light emitting element SLD3a may be provided as the light emitting element LD (refer to FIG. 2) included in the first sub-pixel SP1. The (1-2)-th sub light emitting element SLD1b, the (2-2)-th sub light emitting element SLD2b, and the (3-2)-th sub light emitting element SLD3b may be provided as the light emitting element LD included in the second sub-pixel SP2. The (1-3)-th sub light emitting element SLD1c, the (2-3)-th sub light emitting element SLD2c, and the (3-3)-th sub light emitting element SLD3c may be provided as the light emitting element LD included in the third sub-pixel SP3. In this case, the (1-1)-th sub light emitting element SLD1a, the (2-1)-th sub light emitting element SLD2a, and the (3-1)-th sub light emitting element SLD3a may configure the first light emitting element LD1 of the first sub-pixel SP1, the (1-2)-th sub light emitting element SLD1b, the (2-2)-th sub light emitting element SLD2b, and the (3-2)-th sub light emitting element SLD3b may configure the second light emitting element LD2 of the second sub-pixel SP2, and the (1-3)-th sub light emitting element SLD1c, the (2-3)-th sub light emitting element SLD2c, and the (3-3)-th sub light emitting element SLD3c may configure the third light emitting element LD3 of the third sub-pixel SP3.

Each of the first to third light emitting elements LD1, LD2, and LD3 may be inorganic light emitting diodes including an inorganic light emitting material. However, embodiments are not limited thereto, and for example, organic light emitting diodes may be used.

Referring to FIG. 12, a first upper connection electrode UCE1 may be disposed in the first to third sub-pixels SP1, SP2, and SP3, respectively. The first upper connection electrode UCE1 may include a (1-1)-th upper connection electrode UCE1a, a (1-2)-th upper connection electrode UCE1b, and a (1-3)-th upper connection electrode UCE1c. The (1-1)-th to (1-3)-th upper connection electrodes UCE1a, UCE1b, and UCE1c may be configured similarly to those described with reference to FIG. 8.

The (1-1)-th sub light emitting element SLD1a may be connected between the first anode electrode AE1 and the (1-1)-th upper connection electrode UCE1a. According to embodiments, in the case that (1-1)-th sub light emitting elements SLD1a are provided, the (1-1)-th sub light emitting elements SLD1a may be connected to each other in parallel between the first anode electrode AE1 and the (1-1)-th upper connection electrode UCE1a.

The (1-2)-th sub light emitting element SLD1b may be connected between the second anode electrode AE2 and the (1-2)-th upper connection electrode UCE1b. According to embodiments, in the case that (1-2)-th sub light emitting elements SLD1b are provided, the (1-2)-th sub light emitting elements SLD1b may be connected to each other in parallel between the second anode electrode AE2 and the (1-2)-th upper connection electrode UCE1b.

The (1-3)-th sub light emitting element SLD1c may be connected between the third anode electrode AE3 and the (1-3)-th upper connection electrode UCE1c. According to embodiments, in the case that (1-3)-th sub light emitting elements SLD1c are provided, the (1-3)-th sub light emitting elements SLD1c may be connected to each other in parallel between the third anode electrode AE3 and the (1-3)-th upper connection electrode UCE1c.

A second upper connection electrode UCE2 may be disposed in the first to third sub-pixels SP1, SP2, and SP3, respectively. The second upper connection electrode UCE2 may include a (2-1)-th upper connection electrode UCE2a, a (2-2)-th upper connection electrode UCE2b, and a (2-3)-th upper connection electrode UCE2c. The (2-1)-th upper connection electrode UCE2a may be provided in the first sub-pixel SP1 and may be disposed on the (1-1)-th lower connection electrode LCE1a to face the (1-1)-th lower connection electrode LCE1a. The (2-2)-th upper connection electrode UCE2b may be provided in the second sub-pixel SP2 and may be disposed on the (1-2)-th lower connection electrode LCE1b to face the (1-2)-th lower connection electrode LCE1b. The (2-3)-th upper connection electrode UCE2c may be provided in the third sub-pixel SP3 and may be disposed on the (1-3)-th lower connection electrode LCE1c to face the (1-3)-th lower connection electrode LCE1c.

The (2-1)-th sub light emitting element SLD2a may be connected between the (1-1)-th lower connection electrode LCE1a and the (2-1)-th upper connection electrode UCE2a. According to embodiments, in the case that (2-1)-th sub light emitting elements SLD2a are provided, the (2-1)-th sub light emitting elements SLD2a may be connected to each other in parallel between the (1-1)-th lower connection electrode LCE1a and the (2-1)-th upper connection electrode UCE2a.

The (2-2)-th sub light emitting element SLD2b may be connected between the (1-2)-th lower connection electrode LCE1b and the (2-2)-th upper connection electrode UCE2b. According to embodiments, in the case that (2-2)-th sub light emitting elements SLD2b are provided, the (2-2)-th sub light emitting elements SLD2b may be connected to each other in parallel between the (1-2)-th lower connection electrode LCE1b and the (2-2)-th upper connection electrode UCE2b.

The (2-3)-th sub light emitting element SLD2c may be connected between the (1-3)-th lower connection electrode LCE1c and the (2-3)-th upper connection electrode UCE2c. According to embodiments, in the case that (2-3)-th sub light emitting elements SLD2c are provided, the (2-3)-th sub light emitting elements SLD2c may be connected to each other in parallel between the (1-3)-th lower connection electrode LCE1c and the (2-3)-th upper connection electrode UCE2c.

The cathode electrode CE may be commonly provided to the first to third sub-pixels SP1, SP2, and SP3. For example, the cathode electrode CE may be provided as a common electrode. For example, the cathode electrode CE may extend in the second direction DR2 and may be used as a common electrode for the pixel PXL and other pixels adjacent to the pixel PXL. Although not shown, the cathode electrode CE may extend not only in the second direction DR2 but also in the first direction DR1 and may be used as a common electrode for all of the sub-pixels SP of FIG. 4. As described above, the cathode electrode CE may have various shapes.

The cathode electrode CE may be disposed in a same layer as the (1-1)-th to (1-3)-th upper connection electrodes UCE1a, UCE1b, and UCE1c, and the (2-1)-th to (2-3)-th upper connection electrodes UCE2a, UCE2b, and UCE2c. For example, the cathode electrode CE may be formed through a same formation process as the (1-1)-th to (1-3)-th upper connection electrodes UCE1a, UCE1b, and UCE1c, and the (2-1)-th to (2-3)-th upper connection electrodes UCE2a, UCE2b, and UCE2c. The cathode electrode CE may be disposed on the (2-1)-th to (2-3)-th lower connection electrodes LCE2a, LCE2b, and LCE2c to face the (2-1)-th to (2-3)-th lower connection electrodes LCE2a, LCE2b, and LCE2c.

The (3-1)-th sub light emitting element SLD3a may be connected between the cathode electrode CE and the (2-1)-th lower connection electrode LCE2a. According to embodiments, in the case that (3-1)-th sub light emitting elements SLD3a are provided, the (3-1)-th sub light emitting elements SLD3a may be connected to each other in parallel between the (2-1)-th lower connection electrode LCE2a and the cathode electrode CE.

The (3-2)-th sub light emitting element SLD3b may be connected between the cathode electrode CE and the (2-2)-th lower connection electrode LCE2b. According to embodiments, in the case that (3-2)-th sub light emitting elements SLD3b are provided, the (3-2)-th sub light emitting elements SLD3b may be connected to each other in parallel between the (2-2)-th lower connection electrode LCE2b and the cathode electrode CE.

The (3-3)-th sub light emitting element SLD3c may be connected between the cathode electrode CE and the (2-3)-th lower connection electrode LCE2c. According to embodiments, in the case that (3-3)-th sub light emitting elements SLD3c are provided, the (3-3)-th sub light emitting elements SLD3c may be connected to each other in parallel between the (2-3)-th lower connection electrode LCE2c and the cathode electrode CE.

The (1-1)-th upper connection electrode UCE1a may be electrically connected to the (1-1)-th lower connection electrode LCE1a through a (1-1)-th contact hole CNT1a. In this case, between the first anode electrode AE1 and the (2-1)-th upper connection electrode UCE2a, the (1-1)-th sub light emitting element SLD1a and the (2-1)-th sub light emitting element SLD2a may be connected to each other in series through the (1-1)-th upper connection electrode UCE1a and the (1-1)-th lower connection electrode LCE1a.

The (2-1)-th upper connection electrode UCE2a may be electrically connected to the (2-1)-th lower connection electrode LCE2a through a (2-1)-th contact hole CNT2a. In this case, between the (1-1)-th lower connection electrode LCE1a and the cathode electrode CE, the (2-1)-th sub light emitting element SLD2a and the (3-1)-th sub light emitting element SLD3a may be connected to each other in series through the (2-1)-th upper connection electrode UCE2a and the (2-1)-th lower connection electrode LCE2a.

As described above, the (1-1)-th to (3-1)-th sub light emitting elements SLD1a, SLD2a, and SLD3a may be connected to each other in series between the first anode electrode AE1 and the cathode electrode CE.

The (1-2)-th upper connection electrode UCE1b may be electrically connected to the (1-2)-th lower connection electrode LCE1b through a (1-2)-th contact hole CNT1b. In this case, between the second anode electrode AE2 and the (2-2)-th upper connection electrode UCE2b, the (1-2)-th sub light emitting element SLD1b and the (2-2)-th sub light emitting element SLD2b may be connected to each other in series through the (1-2)-th upper connection electrode UCE1b and the (1-2)-th lower connection electrode LCE1b.

The (2-2)-th upper connection electrode UCE2b may be electrically connected to the (2-2)-th lower connection electrode LCE2b through a (2-2)-th contact hole CNT2b. In this case, between the (1-2)-th lower connection electrode LCE1b and the cathode electrode CE, the (2-2)-th sub light emitting element SLD2b and the (3-2)-th sub light emitting element SLD3b may be connected to each other in series through the (2-2)-th upper connection electrode UCE2b and the (2-2)-th lower connection electrode LCE2b.

As described above, the (1-2)-th to (3-2)-th sub light emitting elements SLD1b, SLD2b, and SLD3b may be connected to each other in series between the second anode electrode AE2 and the cathode electrode CE.

The (1-3)-th upper connection electrode UCE1c may be electrically connected to the (1-3)-th lower connection electrode LCE1c through a (1-3)-th contact hole CNT1c. In this case, between the third anode electrode AE3 and the (2-3)-th upper connection electrode UCE2c, the (1-3)-th sub light emitting element SLD1c and the (2-3)-th sub light emitting elements SLD2c may be connected to each other in series through the (1-3)-th upper connection electrode UCE1c and the (1-3)-th lower connection electrode LCE1c.

The (2-3)-th upper connection electrode UCE2c may be electrically connected to the (2-3)-th lower connection electrode LCE2c through a (2-3)-th contact hole CNT2c. In this case, between the (1-3)-th lower connection electrode LCE1c and the cathode electrode CE, the (2-3)-th sub light emitting element SLD2c and the (3-3)-th sub light emitting element SLD3c may be connected to each other in series through the (2-3)-th upper connection electrode UCE2c and the (2-3)-th lower connection electrode LCE2c.

As described above, the (1-3)-th to (3-3)-th sub light emitting elements SLD1c, SLD2c, and SLD3c may be connected to each other in series between the third anode electrode AE3 and the cathode electrode CE.

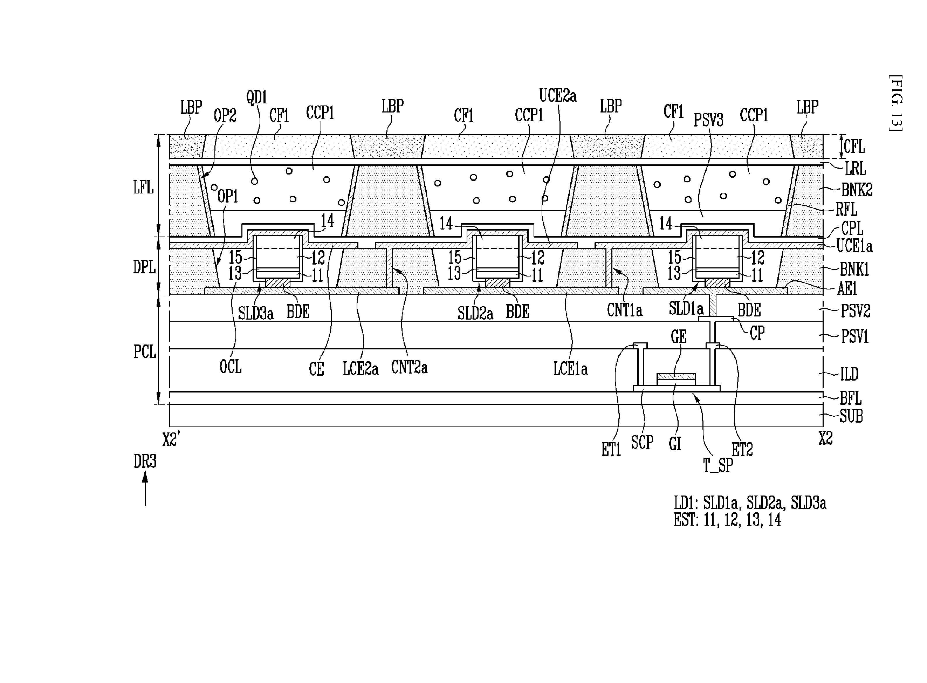

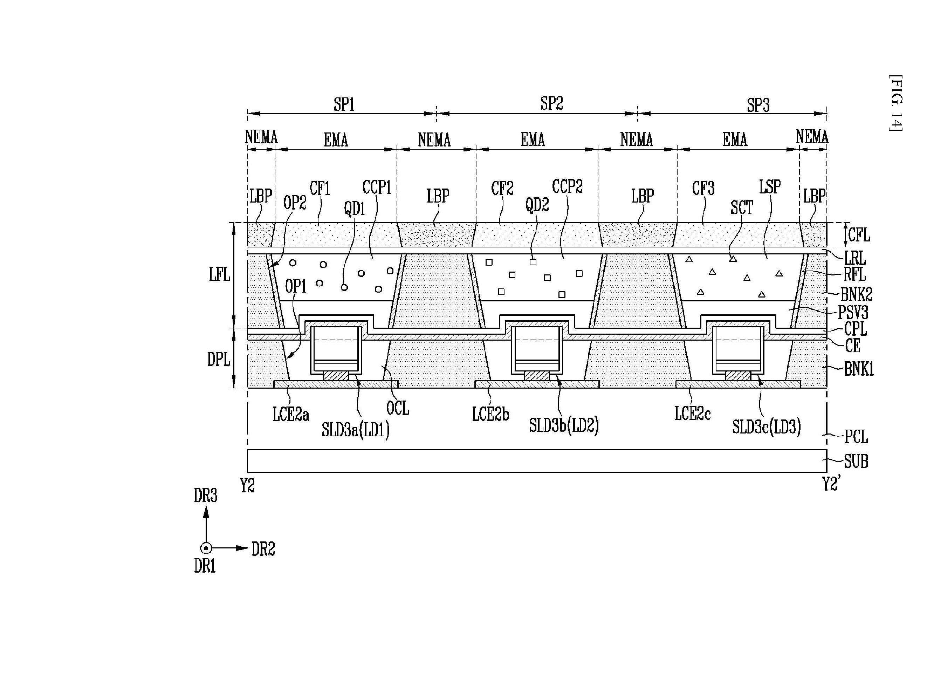

FIGS. 13 and 14 are schematic cross-sectional views illustrating a pixel according to the (1-2)-th embodiment of FIG. 12. FIG. 13 is a schematic cross-sectional view taken along line X2-X2' of FIG. 12, and FIG. 14 is a schematic cross-sectional view taken along line Y2-Y2' of FIG. 12.

Referring to FIGS. 11 to 13, the pixel circuit layer PCL, the display element layer DPL, and the light functional layer LFL may be sequentially disposed on the substrate SUB.

The pixel circuit layer PCL may be configured similarly to that described with reference to FIG. 9. Therefore, a description of an overlapping content may be omitted.

The display element layer DPL may be disposed on the pixel circuit layer PCL. The display element layer DPL may include the first anode electrode AE1, the (1-1)-th lower connection electrode LCE1a, the (2-1)-th lower connection electrode LCE2a, the first bank BNK1, the first light emitting element LD1, the (1-1)-th upper connection electrode UCE1a, the (2-1)-th upper connection electrode UCE2a, the cathode electrode CE, the overcoat layer OCL, and the capping layer CPL.

The first anode electrode AE1, the (1-1)-th lower connection electrode LCE1a, and the (2-1)-th lower connection electrode LCE2a may be disposed on the pixel circuit layer PCL. The first anode electrode AE1 may be electrically connected to the connection pattern CP through a contact hole passing through the second passivation layer PSV2. As described above, the first anode electrode AE1 may be electrically connected to the transistor T_SP. The (1-1)-th lower connection electrode LCE1a may be spaced apart from the first anode electrode AE1, and the (2-1)-th lower connection electrode LCE2a may be spaced apart from the (1-1)-th lower connection electrode LCE1a and the first anode electrode AE1.

The first bank BNK1 may be disposed on the pixel circuit layer PCL, the first anode electrode AE1, the (1-1)-th lower connection electrode LCE1a, and the (2-1)-th lower connection electrode LCE2a. The first bank BNK1 may have a first opening OP1 exposing portions of the first anode electrode AE1, the (1-1)-th lower connection electrode LCE1a, and the (2-1)-th lower connection electrode LCE2a. The (1-1)-th sub light emitting element SLD1a may be disposed on the first anode electrode AE1 exposed by the first opening OP1 of the first bank BNK1. The (2-1)-th sub light emitting element SLD2a may be disposed on the (1-1)-th lower connection electrode LCE1a exposed by the first opening OP1 of the first bank BNK1. The (3-1)-th sub light emitting element SLD3a may be disposed on the (2-1)-th lower connection electrode LCE2a exposed by the first opening OP1 of the first bank BNK1. As described above, the first bank BNK1 may be provided as a pixel defining layer that defines an area where the first light emitting element LD1 is positioned.

The first bank BNK1 may be configured to include a light blocking material to prevent light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first light emitting element LD1 may include a light emitting stack EST and a bonding electrode BDE. The light emitting stack EST may include a first semiconductor layer 11, a second semiconductor layer 12, an active layer 13, and an auxiliary layer 14. The first light emitting element LD1 may be implemented as a vertical light emitting stack in which the bonding electrode BDE, the first semiconductor layer 11, the active layer 13, the second semiconductor layer 12, and the auxiliary layer 14 may be sequentially stacked each other along the third direction DR3.

The first semiconductor layer 11, the second semiconductor layer 12, the active layer 13, and the auxiliary layer 14 may be configured similarly to those described with reference to FIG. 9. Therefore, a description of an overlapping content may be omitted.

The bonding electrode BDE may be disposed under the first semiconductor layer 11, and may be electrically connected to the first semiconductor layer 11. In embodiments, the bonding electrode BDE of the (1-1)-th sub light emitting element SLD1a may be electrically connected to the first anode electrode AE1, the bonding electrode BDE of the (2-1)-th sub light emitting element SLD2a may be electrically connected to the (1-1)-th lower connection electrode LCE1a, and the bonding electrode BDE of the (3-1)-th sub light emitting element SLD3a may be electrically connected to the (2-1)-th lower connection electrode LCE2a. The bonding electrode BDE may include a eutectic metal.

The first light emitting element LD1 may further include an insulating layer 15 covering an outer peripheral surface of the vertical light emitting stack. The insulating layer 15 may serve to prevent an electrical short circuit that may occur in the case that the active layer 13 comes into contact with a conductive material other than the first and second semiconductor layers 11 and 12. The insulating layer 15 may include a transparent insulating material. The insulating layer 15 may be configured to expose at least a portion of the bonding electrode BDE for an electrical connection with the first anode electrode AE1, the (1-1)-th lower connection electrode LCE1a, or the (2-1)-th lower connection electrode LCE2a. The insulating layer 15 may be configured to expose an upper surface of the auxiliary layer 14 for an electrical connection with the cathode electrode CE, the (1-1)-th upper connection electrode UCE1a, or the (2-1)-th upper connection electrode UCE2a.

In embodiments, a reflective electrode may be further disposed between the bonding electrode BDE and the first semiconductor layer 11. In this case, light emitted from the first light emitting element LD1 may be more efficiently output toward the light functional layer LFL. The reflective electrode may be configured of a conductive material having a selectable reflectance. The conductive material may include an opaque metal. The opaque metal may include, for example, a metal such as silver (Ag), magnesium (Mg), aluminium (Al), platinum (Pt), palladium (Pd), gold (Au), nickel (Ni), neodymium (Nd), iridium (Ir), chromium (Cr), titanium (Ti), and an alloy thereof. However, a material of the reflective electrode is not limited thereto.

The overcoat layer OCL may be disposed in the first openings OP1 where the first light emitting element LD1 is disposed. The overcoat layer OCL may fix the first light emitting element LD1 bonded to the first anode electrode AE1, the (1-1)-th lower connection electrode LCE1a, and the (2-1)-th lower connection electrode LCE2a so that the first light emitting element LD1 does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

In embodiments, the overcoat layer OCL may not be disposed on an upper surface of the first light emitting element LD1. For example, the first light emitting element LD1 may protrude to the light functional layer LFL. The first light emitting element LD1 may be positioned at least partially in the second opening OP2 of the second bank BNK2. For example, a height of the upper surface of the first light emitting element LD1 from the substrate SUB may be higher than the lowermost end of a reflective layer RFL. Accordingly, the light emitted from the first light emitting element LD1 may be provided to the light functional layer LFL at a relatively high rate.

The (1-1)-th upper connection electrode UCE1a may be disposed on the (1-1)-th sub light emitting element SLD1a. The (1-1)-th upper connection electrode UCE1a may be disposed to face the first anode electrode AE1. The (1-1)-th upper connection electrode UCE1a may cover an upper surface of the (1-1)-th sub light emitting element SLD1a. Accordingly, the (1-1)-th upper connection electrode UCE1a may contact the auxiliary layer 14 of the (1-1)-th sub light emitting element SLD1a.

The (2-1)-th upper connection electrode UCE2a may be disposed on the (2-1)-th sub light emitting element SLD2a. The (2-1)-th upper connection electrode UCE2a may be disposed to face the (1-1)-th lower connection electrode LCE1a. The (2-1)-th upper connection electrode UCE2a may cover an upper surface of the (2-1)-th sub light emitting element SLD2a. Accordingly, the (2-1)-th upper connection electrode UCE2a may contact the auxiliary layer 14 of the (2-1)-th sub light emitting element SLD2a.

The cathode electrode CE may be disposed on the (3-1)-th sub light emitting element SLD3a. The cathode electrode CE may be disposed to face the (2-1)-th lower connection electrode LCE2a. The cathode electrode CE may cover an upper surface of the (3-1)-th sub light emitting element SLD3a. Accordingly, the cathode electrode CE may contact the auxiliary layer 14 of the (3-1)-th sub light emitting element SLD3a.

The cathode electrode CE may be electrically connected to the second power voltage node VSSN (refer to FIG. 2). Accordingly, the second power voltage applied to the second power voltage node VSSN may be transmitted to the (3-1)-th sub light emitting element SLD3a through the cathode electrode CE.

The (1-1)-th upper connection electrode UCE1a may be electrically connected to the (1-1)-th lower connection electrode LCE1a. For example, the (1-1)-th upper connection electrode UCE1a may be electrically connected to the (1-1)-th lower connection electrode LCE1a through the (1-1)-th contact hole CNT1a formed in the first bank BNK1. The auxiliary layer 14 of the (1-1)-th sub light emitting element SLD1a and the bonding electrode BDE of the (2-1)-th sub light emitting element SLD2a may be connected through the (1-1)-th upper connection electrode UCE1a and the (1-1)-th lower connection electrode LCE1a. Accordingly, the (1-1)-th sub light emitting element SLD1a and the (2-1)-th sub light emitting element SLD2a may be connected to each other in series between the (2-1)-th upper connection electrode UCE2a and the first anode electrode AE1.

The (2-1)-th upper connection electrode UCE2a may be electrically connected to the (2-1)-th lower connection electrode LCE2a. For example, the (2-1)-th upper connection electrode UCE2a may be electrically connected to the (2-1)-th lower connection electrode LCE2a through the (2-1)-th contact hole CNT2a formed in the first bank BNK1. The auxiliary layer 14 of the (2-1)-th sub light emitting element SLD2a and the bonding electrode BDE of the (3-1)-th sub light emitting element SLD3a may be connected through the (2-1)-th upper connection electrode UCE2a and the (2-1)-th lower connection electrode LCE2a. Accordingly, the (2-1)-th sub light emitting element SLD2a and the (3-1)-th sub light emitting element SLD3a may be connected to each other in series between the (1-1)-th lower connection electrode LCE1a and the cathode electrode CE.

The (1-1)-th upper connection electrode UCE1a, the (2-1)-th upper connection electrode UCE2a, and the cathode electrode CE may be configured to be substantially transparent or translucent to satisfy a selectable light transmittance. In embodiments, the (1-1)-th upper connection electrode UCE1a, the (2-1)-th upper connection electrode UCE2a, and the cathode electrode CE may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, a material of the (1-1)-th upper connection electrode UCE1a, the (2-1)-th upper connection electrode UCE2a, and the cathode electrode CE is not limited thereto.

The capping layer CPL may be disposed on the (1-1)-th upper connection electrode UCE1a, the (2-1)-th upper connection electrode UCE2a, and the cathode electrode CE. The capping layer CPL may be configured similarly to that described with reference to FIG. 9.

Above, the pixel circuit layer PCL and the display element layer DPL of the first sub-pixel SP1 are described. Each of the second and third sub-pixels SP2 and SP3 of FIGS. 11 and 12 may be configured similarly to the first sub-pixel SP1 unless otherwise described herein.

The light functional layer LFL may be disposed on the capping layer CPL. The light functional layer LFL may include a second bank BNK2, a reflective layer RFL, a third passivation layer PSV3, a first light conversion pattern CCP1, a low refractive layer LRL, and a color filter layer CFL. The light functional layer LFL may be configured similarly to that described with reference to FIG. 9. Therefore, a description of an overlapping content may be omitted.

Referring to FIGS. 11, 12, and 14, the pixel circuit layer PCL, the display element layer DPL, and the light functional layer LFL may be sequentially provided on the substrate SUB.

The pixel circuit layer PCL and the display element layer DPL are described similarly to those described with reference to FIG. 13. The pixel circuit layer PCL and the display element layer DPL are described similarly to those described with reference to FIG. 9. In the pixel circuit layer PCL, the sub-pixel circuits respectively corresponding to the first to third sub-pixels SP1, SP2, and SP3 may be provided. In the display element layer DPL, the first to third light emitting elements LD1, LD2, and LD3 respectively corresponding to the first to third sub-pixels SP1, SP2, and SP3 may be provided. The first to third light emitting elements LD1, LD2, and LD3 may overlap the first openings OP1 of the first bank BNK1. The first light emitting element LD1 may be connected between the cathode electrode CE (refer to FIG. 13) and the transistor T_SP (refer to FIG. 13) included in the sub-pixel circuit of the first sub-pixel SP1. The second light emitting element LD2 may be connected between the cathode electrode CE and the transistor included in the sub-pixel circuit of the second sub-pixel SP2. The third light emitting element LD3 may be connected between the cathode electrode CE and the transistor included in the sub-pixel circuit of the third sub-pixel SP3. Below, a description of an overlapping content may be omitted.

The light functional layer LFL may be provided on the display element layer DPL. The light functional layer LFL is described similarly to that described with reference to FIG. 10. Therefore, a description of an overlapping content may be omitted.

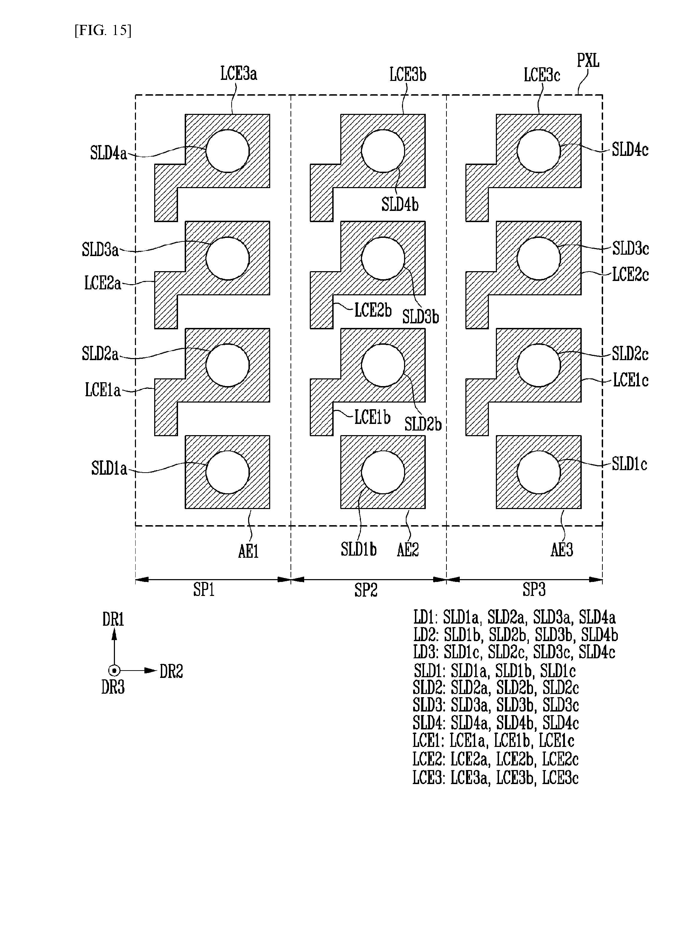

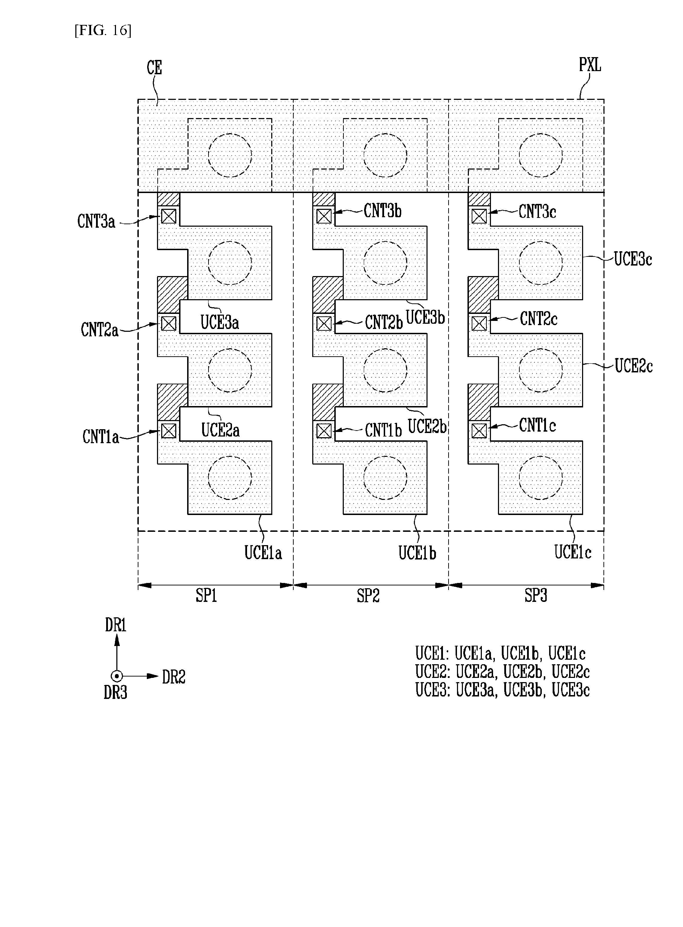

FIGS. 15 and 16 are schematic plan views illustrating a (1-3)-th embodiment of one of the pixels included in the display panel of FIG. 3.

Referring to FIG. 15, the pixel PXL may include the first to third sub-pixels SP1, SP2, and SP3. The first to third sub-pixels SP1, SP2, and SP3 may be arranged in the second direction DR2. However, an arrangement of the pixel PXL is not limited thereto and may variously change according to embodiments. For example, the first to third sub-pixels SP1, SP2, and SP3 may be arranged in a zigzag.

First to third anode electrodes AE1, AE2, and AE3 may be disposed in the first to third sub-pixels SP1, SP2, and SP3, respectively. The first to third anode electrodes AE1, AE2, and AE3 may be configured similarly to those described with reference to FIG. 11.

A first lower connection electrode LCE1 may be disposed in the first to third sub-pixels SP1, SP2, and SP3, respectively. The first lower connection electrode LCE1 may include a (1-1)-th lower connection electrode LCE1a, a (1-2)-th lower connection electrode LCE1b, and a (1-3)-th lower connection electrode LCE1c. The (1-1)-th to (1-3)-th lower connection electrodes LCE1a, LCE1b, and LCE1c may be configured similarly to those described with reference to FIG. 11.

A second lower connection electrode LCE2 may be disposed in the first to third sub-pixels SP1, SP2, and SP3, respectively. The second lower connection electrode LCE2 may include a (2-1)-th lower connection electrode LCE2a, a (2-2)-th lower connection electrode LCE2b, and a (2-3)-th lower connection electrode LCE2c. The (2-1)-th to (2-3)-th lower connection electrodes LCE2a, LCE2b, and LCE2c may be configured similarly to those described with reference to FIG. 11.

A third lower connection electrode LCE3 may be disposed in the first to third sub-pixels SP1, SP2, and SP3, respectively. The third lower connection electrode LCE3 may include a (3-1)-th lower connection electrode LCE3a, a (3-2)-th lower connection electrode LCE3b, and a (3-3)-th lower connection electrode LCE3c. The (3-1)-th lower connection electrode LCE3a may be provided in the first sub-pixel SP1, and may be spaced apart from the first anode electrode AE1, the (1-1)-th lower connection electrode LCE1a, and the (2-1)-th lower connection electrode LCE2a. The (3-2)-th lower connection electrode LCE3b may be provided in the second sub-pixel SP2, and may be spaced apart from the second anode electrode AE2, the (1-2)-th lower connection electrode LCE1b, and the (2-2)-th lower connection electrode LCE2b. The (3-3)-th lower connection electrode LCE3c may be provided in the third sub-pixel SP3, and may be spaced apart from the third anode electrode AE3, the (1-3)-th lower connection electrode LCE1c, and the (2-3)-th lower connection electrode LCE2c.

In embodiments, the (3-1)-th to (3-3)-th lower connection electrodes LCE3a, LCE3b, and LCE3c may be disposed in a same layer as the first to third anode electrodes AE1, AE2, and AE3, the (1-1)-th to (1-3)-th lower connection electrodes LCE1a, LCE1b, and LCE1c and the (2-1)-th to (2-3)-th lower connection electrodes LCE2a, LCE2b, and LCE2c. In this case, the (3-1)-th to (3-3)-th lower connection electrodes LCE3a, LCE3b, and LCE3c may be formed through a same formation process as the first to third anode electrodes AE1, AE2, and AE3, the (1-1)-th to (1-3)-th lower connection electrodes LCE1a, LCE1b, and LCE1c and the (2-1)-th to (2-3)-th lower connection electrodes LCE2a, LCE2b, and LCE2c.

The first sub light emitting element SLD1 may be disposed on the first to third anode electrodes AE1, AE2, and AE3, respectively. The first sub light emitting element SLD1 may include a (1-1)-th sub light emitting element SLD1a, a (1-2)-th sub light emitting element SLD1b, and a (1-3)-th sub light emitting element SLD1c. The (1-1)-th to (1-3)-th sub light emitting elements SLD1a, SLD1b, and SLD1c may be configured similarly to those described with reference to FIG. 11.

In FIG. 15, each of the (1-1)-th to (1-3)-th sub light emitting elements SLD1a, SLD1b, and SLD1c is provided one by one, but the disclosure is not limited thereto. For example, as described with reference to FIG. 7, each of the (1-1)-th to (1-3)-th sub light emitting elements SLD1a, SLD1b, and SLD1c may be provided.

The second sub light emitting element SLD2 may be disposed on the (1-1)-th to (1-3)-th lower connection electrodes LCE1a, LCE1b, and LCE1c, respectively. The second sub light emitting element SLD2 may include a (2-1)-th sub light emitting element SLD2a, a (2-2)-th sub light emitting element SLD2b, and a (2-3)-th sub light emitting element SLD2c. The (2-1)-th to (2-3)-th sub light emitting elements SLD2a, SLD2b, and SLD2c may be configured similarly to those described with reference to FIG. 11.

In FIG. 15, each of the (2-1)-th to (2-3)-th sub light emitting elements SLD2a, SLD2b, and SLD2c is provided one by one, but the disclosure is not limited thereto. For example, as described with reference to FIG. 7, each of the (2-1)-th to (2-3)-th sub light emitting elements SLD2a, SLD2b, and SLD2c may be provided.

A third sub light emitting element SLD3 may be disposed on the (2-1)-th to (2-3)-th lower connection electrodes LCE2a, LCE2b, and LCE2c, respectively. The third sub light emitting element SLD3 may include a (3-1)-th sub light emitting element SLD3a, a (3-2)-th sub light emitting element SLD3b, and a (3-3)-th sub light emitting element SLD3c. The (3-1)-th to (3-3)-th sub light emitting elements SLD3a, SLD3b, and SLD3c may be configured similarly to those described with reference to FIG. 11.

In FIG. 15, each of the (3-1)-th to (3-3)-th sub light emitting elements SLD3a, SLD3b, and SLD3c is provided one by one, but the disclosure is not limited thereto. Each of the (3-1)-th to (3-3)-th sub light emitting elements SLD3a, SLD3b, and SLD3c may be provided. For example, two or more (3-1)-th sub light emitting elements SLD3a may be provided on the (2-1)-th lower connection electrode LCE2a, and in this case, each of the (3-1)-th sub light emitting elements SLD3a may overlap the (2-1)-th lower connection electrode LCE2a and may be connected to the (2-1)-th lower connection electrode LCE2a.

A fourth sub light emitting element SLD4 may be disposed on the (3-1)-th to (3-3)-th lower connection electrodes LCE3a, LCE3b, and LCE3c, respectively. The fourth sub light emitting element SLD4 may include a (4-1)-th sub light emitting element SLD4a, a (4-2)-th sub light emitting element SLD4b, and a (4-3)-th sub light emitting element SLD4c. The (4-1)-th sub light emitting element SLD4a may be disposed on the (3-1)-th lower connection electrode LCE3a to overlap the (3-1)-th lower connection electrode LCE3a. The (4-1)-th sub light emitting element SLD4a may be connected to the (3-1)-th lower connection electrode LCE3a. The (4-2)-th sub light emitting element SLD4b may be disposed on the (3-2)-th lower connection electrode LCE3b to overlap the (3-2)-th lower connection electrode LCE3b. The (4-2)-th sub light emitting element SLD4b may be connected to the (3-2)-th lower connection electrode LCE3b. The (4-3)-th sub light emitting element SLD4c may be disposed on the (3-3)-th lower connection electrode LCE3c to overlap the (3-3)-th lower connection electrode LCE3c. The (4-3)-th sub light emitting element SLD4c may be connected to the (3-3)-th lower connection electrode LCE3c.

In FIG. 15, each of the (4-1)-th to (4-3)-th sub light emitting elements SLD4a, SLD4b, and SLD4c is provided one by one, but the disclosure is not limited thereto. Each of the (4-1)-th to (4-3)-th sub light emitting elements SLD4a, SLD4b, and SLD4c may be provided.

The (1-1)-th sub light emitting element SLD1a, the (2-1)-th sub light emitting element SLD2a, the (3-1)-th sub light emitting element SLD3a, and the (4-1)-th sub light emitting element SLD4a may be provided as the light emitting element LD (refer to FIG. 2) included in the first sub-pixel SP1. The (1-2)-th sub light emitting element SLD1b, the (2-2)-th sub light emitting element SLD2b, the (3-2)-th sub light emitting element SLD3b, and the (4-2)-th sub light emitting element SLD4b may be provided as the light emitting element LD included in the second sub-pixel SP2. The (1-3)-th sub light emitting element SLD1c, the (2-3)-th sub light emitting element SLD2c, the (3-3)-th sub light emitting element SLD3c, and the (4-3)-th sub light emitting element SLD4c may be provided as the light emitting element LD included in the third sub-pixel SP3. In this case, the (1-1)-th sub light emitting element SLD1a, the (2-1)-th sub light emitting element SLD2a, the (3-1)-th sub light emitting element SLD3a, and the (4-1)-th sub light emitting element SLD4a may configure the first light emitting element LD1 of the first sub-pixel SP1, the (1-2)-th sub light emitting element SLD1b, the (2-2)-th sub light emitting element SLD2b, the (3-2)-th sub light emitting element SLD3b, and the (4-2)-th sub light emitting element SLD4b may configure the second light emitting element LD2 of the second sub-pixel SP2, and the (1-3)-th sub light emitting element SLD1c, the (2-3)-th sub light emitting element SLD2c, the (3-3)-th sub light emitting element SLD3c, and the (4-3)-th sub light emitting element SLD4c may configure the third light emitting element LD3 of the third sub-pixel SP3.

Each of the first to third light emitting elements LD1, LD2, and LD3 may be inorganic light emitting diodes including an inorganic light emitting material. However, embodiments are not limited thereto, and for example, organic light emitting diodes may be used.

Referring to FIG. 16, a first upper connection electrode UCE1 may be disposed in the first to third sub-pixels SP1, SP2, and SP3, respectively. The first upper connection electrode UCE1 may include a (1-1)-th upper connection electrode UCE1a, a (1-2)-th upper connection electrode UCE1b, and a (1-3)-th upper connection electrode UCE1c. The (1-1)-th to (1-3)-th upper connection electrodes UCE1a, UCE1b, and UCE1c may be configured similarly to those described with reference to FIG. 12.

The (1-1)-th sub light emitting element SLD1a may be connected between the first anode electrode AE1 and the (1-1)-th upper connection electrode UCE1a. According to embodiments, in the case that (1-1)-th sub light emitting elements SLD1a are provided, the (1-1)-th sub light emitting elements SLD1a may be connected to each other in parallel between the first anode electrode AE1 and the (1-1)-th upper connection electrode UCE1a.

The (1-2)-th sub light emitting element SLD1b may be connected between the second anode electrode AE2 and the (1-2)-th upper connection electrode UCE1b. According to embodiments, in the case that (1-2)-th sub light emitting elements SLD1b are provided, the (1-2)-th sub light emitting elements SLD1b may be connected to each other in parallel between the second anode electrode AE2 and the (1-2)-th upper connection electrode UCE1b.

The (1-3)-th sub light emitting element SLD1c may be connected between the third anode electrode AE3 and the (1-3)-th upper connection electrode UCE1c. According to embodiments, in the case that (1-3)-th sub light emitting elements SLD1c are provided, the (1-3)-th sub light emitting elements SLD1c may be connected to each other in parallel between the third anode electrode AE3 and the (1-3)-th upper connection electrode UCE1c.

A second upper connection electrode UCE2 may be disposed in the first to third sub-pixels SP1, SP2, and SP3, respectively. The second upper connection electrode UCE2 may include a (2-1)-th upper connection electrode UCE2a, a (2-2)-th upper connection electrode UCE2b, and a (2-3)-th upper connection electrode UCE2c. The (2-1)-th to (2-3)-th upper connection electrodes UCE2a, UCE2b, and UCE2c may be configured similarly to those described with reference to FIG. 12.

The (2-1)-th sub light emitting element SLD2a may be connected between the (1-1)-th lower connection electrode LCE1a and the (2-1)-th upper connection electrode UCE2a. According to embodiments, in case that (2-1)-th sub light emitting elements SLD2a are provided, the (2-1)-th sub light emitting elements SLD2a may be connected to each other in parallel between the (1-1)-th lower connection electrode LCE1a and the (2-1)-th upper connection electrode UCE2a.

The (2-2)-th sub light emitting element SLD2b may be connected between the (1-2)-th lower connection electrode LCE1b and the (2-2)-th upper connection electrode UCE2b. According to embodiments, in the case that (2-2)-th sub light emitting elements SLD2b are provided, the (2-2)-th sub light emitting elements SLD2b may be connected to each other in parallel between the (1-2)-th lower connection electrode LCE1b and the (2-2)-th upper connection electrode UCE2b.

The (2-3)-th sub light emitting element SLD2c may be connected between the (1-3)-th lower connection electrode LCE1c and the (2-3)-th upper connection electrode UCE2c. According to embodiments, in the case that (2-3)-th sub light emitting elements SLD2c are provided, the (2-3)-th sub light emitting elements SLD2c may be connected to each other in parallel between the (1-3)-th lower connection electrode LCE1c and the (2-3)-th upper connection electrode UCE2c.

A third upper connection electrode UCE3 may be disposed in the first to third sub-pixels SP1, SP2, and SP3, respectively. The third upper connection electrode UCE3 may include a (3-1)-th upper connection electrode UCE3a, a (3-2)-th upper connection electrode UCE3b, and a (3-3)-th upper connection electrode UCE3c. The (3-1)-th upper connection electrode UCE3a may be provided in the first sub-pixel SP1 and may be disposed on the (2-1)-th lower connection electrode LCE2a to face the (2-1)-th lower connection electrode LCE2a. The (3-2)-th upper connection electrode UCE3b may be provided in the second sub-pixel SP2 and may be disposed on the (2-2)-th lower connection electrode LCE2b to face the (2-2)-th lower connection electrode LCE2b. The (3-3)-th upper connection electrode UCE3c may be provided in the third sub-pixel SP3 and may be disposed on the (2-3)-th lower connection electrode LCE2c to face the (2-3)-th lower connection electrode LCE2c.

The (3-1)-th sub light emitting element SLD3a may be connected between the (2-1)-th lower connection electrode LCE2a and the (3-1)-th upper connection electrode UCE3a. According to embodiments, in the case that (3-1)-th sub light emitting elements SLD3a are provided, the (3-1)-th sub light emitting elements SLD3a may be connected to each other in parallel between the (2-1)-th lower connection electrode LCE2a and the (3-1)-th upper connection electrode UCE3a.

The (3-2)-th sub light emitting element SLD3b may be connected between the (2-2)-th lower connection electrode LCE2b and the (3-2)-th upper connection electrode UCE3b. According to embodiments, in the case that (3-2)-th sub light emitting elements SLD3b are provided, the (3-2)-th sub light emitting elements SLD3b may be connected to each other in parallel between the (2-2)-th lower connection electrode LCE2b and the (3-2)-th upper connection electrode UCE3b.

The (3-3)-th sub light emitting element SLD3c may be connected between the (2-3)-th lower connection electrode LCE2c and the (3-3)-th upper connection electrode UCE3c. According to embodiments, in case that (3-3)-th sub light emitting elements SLD3c are provided, the (3-3)-th sub light emitting elements SLD3c may be connected to each other in parallel between the (2-3)-th lower connection electrode LCE2c and the (3-3)-th upper connection electrode UCE3c.

The cathode electrode CE may be commonly provided to the first to third sub-pixels SP1, SP2, and SP3. For example, the cathode electrode CE may be provided as a common electrode. For example, the cathode electrode CE may extend in the second direction DR2 and may be used as a common electrode for the pixel PXL and other pixels adjacent to the pixel PXL. Although not shown, the cathode electrode CE may extend not only in the second direction DR2 but also in the first direction DR1 and may be used as a common electrode for all of the sub-pixels SP of FIG. 4. As described above, the cathode electrode CE may have various shapes.

The cathode electrode CE may be disposed in a same layer as the (1-1)-th to (1-3)-th upper connection electrodes UCE1a, UCE1b, and UCE1c, the (2-1)-th to (2-3)-th upper connection electrodes UCE2a, UCE2b, and UCE2c, and the (3-1)-th to (3-3)-th upper connection electrodes UCE3a, UCE3b, and UCE3c. The cathode electrode CE may be disposed on the (3-1)-th to (3-3)-th lower connection electrodes LCE3a, LCE3b, and LCE3c to face the (3-1)-th to (3-3)-th lower connection electrodes LCE3a, LCE3b, and LCE3c.

The (4-1)-th sub light emitting element SLD4a may be connected between the cathode electrode CE and the (3-1)-th lower connection electrode LCE3a. According to embodiments, in the case that (4-1)-th sub light emitting elements SLD4a are provided, the (4-1)-th sub light emitting elements SLD4a may be connected to each other in parallel between the (3-1)-th lower connection electrode LCE3a and the cathode electrode CE.

The (4-2)-th sub light emitting element SLD4b may be connected between the cathode electrode CE and the (3-2)-th lower connection electrode LCE3b. According to embodiments, in the case that (4-2)-th sub light emitting elements SLD4b are provided, the (4-2)-th sub light emitting elements SLD4b may be connected to each other in parallel between the (3-2)-th lower connection electrode LCE3b and the cathode electrode CE.

The (4-3)-th sub light emitting element SLD4c may be connected between the cathode electrode CE and the (3-3)-th lower connection electrode LCE3c. According to embodiments, in the case that (4-3)-th sub light emitting elements SLD4c are provided, the (4-3)-th sub light emitting elements SLD4c may be connected to each other in parallel between the (3-3)-th lower connection electrode LCE3c and the cathode electrode CE.

The (1-1)-th upper connection electrode UCE1a may be electrically connected to the (1-1)-th lower connection electrode LCE1a through a (1-1)-th contact hole CNT1a. The (2-1)-th upper connection electrode UCE2a may be electrically connected to the (2-1)-th lower connection electrode LCE2a through a (2-1)-th contact hole CNT2a. The (3-1)-th upper connection electrode UCE3a may be electrically connected to the (3-1)-th lower connection electrode LCE3a through a (3-1)-th contact hole CNT3a. Accordingly, the (1-1)-th sub light emitting element SLD1a, the (2-1)-th sub light emitting element SLD2a, the (3-1)-th sub light emitting element SLD3a, and the (4-1)-th sub light emitting element SLD4a may be connected to each other in series between the first anode electrode AE1 and the cathode electrode CE.

The (1-2)-th upper connection electrode UCE1b may be electrically connected to the (1-2)-th lower connection electrode LCE1b through a (1-2)-th contact hole CNT1b. The (2-2)-th upper connection electrode UCE2b may be electrically connected to the (2-2)-th lower connection electrode LCE2b through a (2-2)-th contact hole CNT2b. The (3-2)-th upper connection electrode UCE3b may be electrically connected to the (3-2)-th lower connection electrode LCE3b through a (3-2)-th contact hole CNT3b. Accordingly, the (1-2)-th sub light emitting element SLD1b, the (2-2)-th sub light emitting element SLD2b, the (3-2)-th sub light emitting element SLD3b, and the (4-2)-th sub light emitting element SLD4b may be connected to each other in series between the second anode electrode AE2 and the cathode electrode CE.

The (1-3)-th upper connection electrode UCE1c may be electrically connected to the (1-3)-th lower connection electrode LCE1c through a (1-3)-th contact hole CNT1c. The (2-3)-th upper connection electrode UCE2c may be electrically connected to the (2-3)-th lower connection electrode LCE2c through a (2-3)-th contact hole CNT2c. The (3-3)-th upper connection electrode UCE3c may be electrically connected to the (3-3)-th lower connection electrode LCE3c through a (3-3)-th contact hole CNT3c. Accordingly, the (1-3)-th sub light emitting element SLD1c, the (2-3)-th sub light emitting element SLD2c, the (3-3)-th sub light emitting element SLD3c, and the (4-3)-th sub light emitting element SLD4c may be connected to each other in series between the third anode electrode AE3 and the cathode electrode CE.

Each of the first to fourth sub light emitting elements SLD1, SLD2, SLD3, and SLD4 shown in FIGS. 15 and 16 may be the vertical light emitting element including the light emitting stack EST and the bonding electrode BDE described with reference to FIGS. 9 and 10. In this case, the first to third sub light emitting elements SLD1, SLD2, and SLD3, and the first and second lower connection electrodes LCE1 and LCE2 and the first and second upper connection electrodes UCE1 and UCE2 disposed therebetween may be configured similarly to those described with reference to FIG. 13. The third and fourth sub light emitting elements SLD3 and SLD4 and the third lower connection electrode LCE3 and the third upper connection electrode UCE3 disposed therebetween may be configured similarly to those described with reference to FIG. 13.

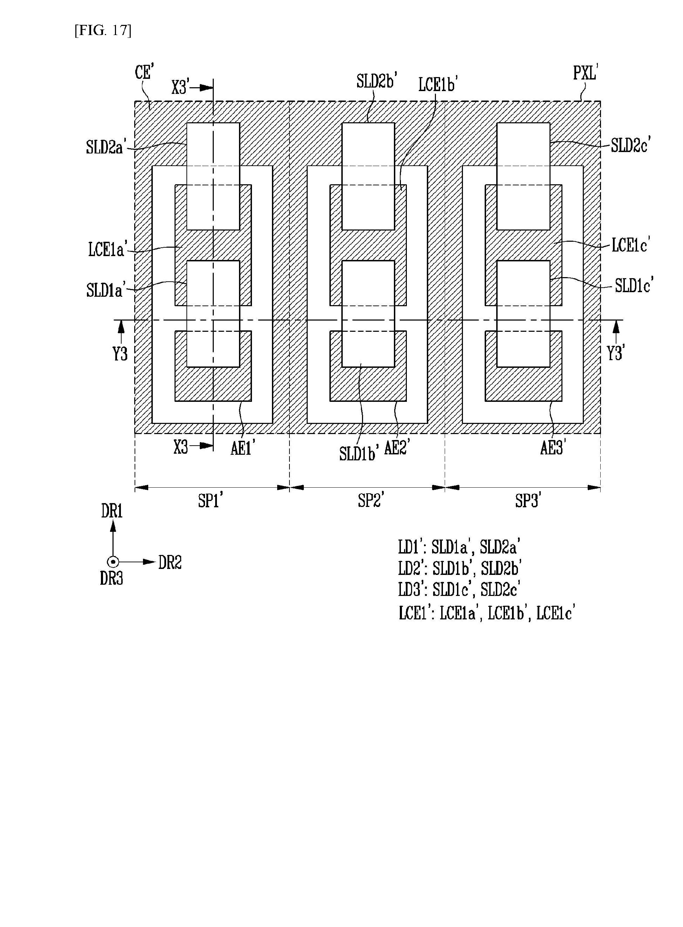

FIG. 17 is a schematic plan view illustrating a (2-1)-th embodiment of one of the pixels included in the display panel of FIG. 3.

Referring to FIG. 17, the pixel PXL' may include first to third sub-pixels SP1', SP2', and SP3'. The first to third sub-pixels SP1', SP2', and SP3' may be arranged in the second direction DR2. However, an arrangement of the pixel PXL' is not limited thereto and may variously change according to embodiments. For example, the first to third sub-pixels SP1', SP2', and SP3' may be arranged in a zigzag.

First to third anode electrodes AE1', AE2', and AE3' may be disposed in the first to third sub-pixels SP1', SP2', and SP3', respectively. The first anode electrode AE1' may be provided as the anode electrode AE (refer to FIG. 3) connected to the sub-pixel circuit SPC (refer to FIG. 2) of the first sub-pixel SP1'. The second anode electrode AE2' may be provided as the anode electrode AE connected to the sub-pixel circuit SPC of the second sub-pixel SP2'. The third anode electrode AE3' may be provided as the anode electrode AE connected to the sub-pixel circuit SPC of the third sub-pixel SP3'.

A first connection electrode LCE1' may be disposed in the first to third sub-pixels SP1', SP2', and SP3', respectively. The first connection electrode LCE1' may include a (1-1)-th connection electrode LCE1a', a (1-2)-th connection electrode LCE1b', and a (1-3)-th connection electrode LCE1c'. The (1-1)-th connection electrode LCE1a' may be provided in the first sub-pixel SP1' and may be spaced apart from the first anode electrode AE1'. The (1-2)-th connection electrode LCE1b' may be provided in the second sub-pixel SP2' and may be spaced apart from the second anode electrode AE2'. The (1-3)-th connection electrode LCE1c' may be provided in the third sub-pixel SP3' and may be spaced apart from the third anode electrode AE3'. In embodiments, the (1-1)-th to (1-3)-th connection electrodes LCE1a', LCE1b', and LCE1c' may be disposed in a same layer as the first to third anode electrodes AE1', AE2', and AE3'. In this case, the (1-1)-th to (1-3)-th connection electrodes LCE1a', LCE1b', and LCE1c' may be formed through a same formation process as the first to third anode electrodes AE1', AE2', and AE3'.

A cathode electrode CE' may be spaced apart from the first to third anode electrodes AE1', AE2', and AE3' and the (1-1)-th to (1-3)-th connection electrodes LCE1a', LCE1b', and LCE1c'. The cathode electrode CE' may be disposed in a same layer as the first to third anode electrodes AE1', AE2', and AE3'. In embodiments, the cathode electrode CE' may extend in the first and second directions DR1 and DR2 and may be used as a common electrode for the pixel PXL' and other pixels adjacent to the pixel PXL'. In embodiments, as shown in FIG. 17, the first anode electrode AE1' and the (1-1)-th connection electrode LCE1a' may be surrounded by the cathode electrode CE', the second anode electrode AE2' and the (1-2)-th connection electrode LCE1b' may be surrounded by the cathode electrode CE', and the third anode electrode AE3' and the (1-3)-th connection electrode LCE1c' may be surrounded by the cathode electrode CE'. As described above, the cathode electrode CE' may have various shapes.

First to third light emitting elements LD1', LD2', and LD3' may be disposed on the first to third anode electrodes AE1', AE2', and AE3', the (1-1)-th to (1-3)-th connection electrodes LCE1a', LCE1b', and LCE1c', and the cathode electrode CE'.

The first light emitting element LD1' may be provided as the light emitting element LD (refer to FIG. 2) connected to the sub-pixel circuit SPC of the first sub-pixel SP1'. The first light emitting element LD1' may include a (1-1)-th sub light emitting element SLD1a' and a (2-1)-th sub light emitting element SLD2a'. The (1-1)-th sub light emitting element SLD1a' may be electrically connected to the first anode electrode AE1' and the (1-1)-th connection electrode LCE1a'. The (2-1)-th sub light emitting element SLD2a' may be electrically connected to the (1-1)-th connection electrode LCE1a' and the cathode electrode CE'. Accordingly, between the first anode electrode AE1' and the cathode electrode CE', the (1-1)-th sub light emitting element SLD1a' and the (2-1)-th sub light emitting element SLD2a' may be connected to each other in series through the (1-1)-th connection electrode LCE1a'.

The second light emitting element LD2' may be provided as the light emitting element LD (refer to FIG. 2) connected to the sub-pixel circuit SPC of the second sub-pixel SP2'. The second light emitting element LD2' may include a (1-2)-th sub light emitting element SLD1b' and a (2-2)-th sub light emitting element SLD2b'. The (1-2)-th sub light emitting element SLD1b' may be electrically connected to the second anode electrode AE2' and the (1-2)-th connection electrode LCE1b'. The (2-2)-th sub light emitting element SLD2b' may be electrically connected to the (1-2)-th connection electrode LCE1b' and the cathode electrode CE'. Accordingly, between the second anode electrode AE2' and the cathode electrode CE', the (1-2)-th sub light emitting element SLD1b' and the (2-2)-th sub light emitting element SLD2b' may be connected to each other in series through the (1-2)-th connection electrode LCE1b'.

The third light emitting element LD3' may be provided as the light emitting element LD (refer to FIG. 2) connected to the sub-pixel circuit SPC of the third sub-pixel SP3'. The third light emitting element LD3' may include a (1-3)-th sub light emitting element SLD1c' and a (2-3)-th sub light emitting element SLD2c'. The (1-3)-th sub light emitting element SLD1c' may be electrically connected to the third anode electrode AE3' and the (1-3)-th connection electrode LCE1c'. The (2-3)-th sub light emitting element SLD2c' may be electrically connected to the (1-3)-th connection electrode LCE1c' and the cathode electrode CE'. Accordingly, between the third anode electrode AE3' and the cathode electrode CE', the (1-3)-th sub light emitting element SLD1c' and the (2-3)-th sub light emitting element SLD2c' may be connected to each other in series through the (1-3)-th connection electrode LCE1c'.

The first light emitting element LD1', the second light emitting element LD2', and the third light emitting element LD3' may be inorganic light emitting diodes including an inorganic light emitting material. However, embodiments are not limited thereto and, for example, organic light emitting diodes may be used.

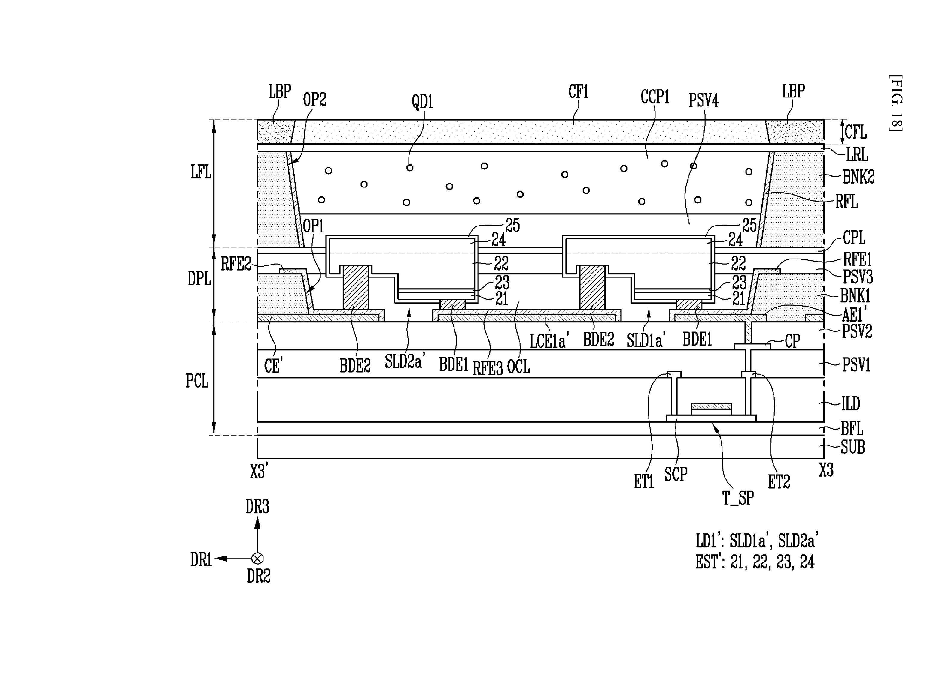

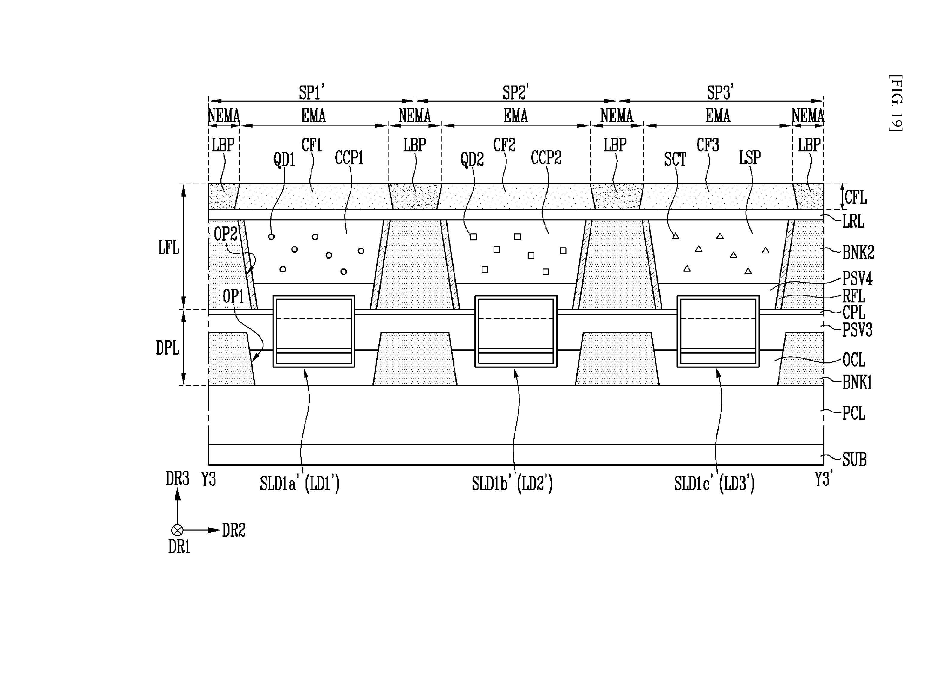

FIGS. 18 and 19 are schematic cross-sectional views illustrating the pixel according to the (2-1)-th embodiment of FIG. 17. FIG. 18 is a schematic cross-sectional view taken along line X3-X3' of FIG. 17, and FIG. 19 is a schematic cross-sectional view taken along line Y3-Y3' of FIG. 17.

Referring to FIGS. 17 and 18, the pixel circuit layer PCL, the display element layer DPL, and the light functional layer LFL may be sequentially disposed on the substrate SUB.

The pixel circuit layer PCL is described similarly to that described with reference to FIG. 9. Therefore, a description of an overlapping content may be omitted.

The display element layer DPL may be disposed on the pixel circuit layer PCL. The display element layer DPL may include the first anode electrode AE1', the (1-1)-th connection electrode LCE1a', the cathode electrode CE', the first bank BNK1, first to third reflective electrodes RFE1, RFE2, and RFE3, the first light emitting element LD1', the overcoat layer OCL, the third passivation layer PSV3, and the capping layer CPL.

The first anode electrode AE1', the (1-1)-th connection electrode LCE1a', and the cathode electrode CE' may be disposed on the pixel circuit layer PCL.

The first anode electrode AE1' may be electrically connected to the connection pattern CP through a contact hole passing through the second passivation layer PSV2. As described above, the first anode electrode AE1' may be electrically connected to the transistor T_SP.

The cathode electrode CE' may be spaced apart from the first anode electrode AE1' in the first direction DR1. The cathode electrode CE' may be electrically connected to the second power voltage node VSSN of FIG. 2. Accordingly, the second power voltage applied to the second power voltage node VSSN may be transmitted to the cathode electrode CE'.

The (1-1)-th connection electrode LCE1a' may be disposed between the cathode electrode CE' and the first anode electrode AE1'. The (1-1)-th connection electrode LCE1a' may be spaced apart from the cathode electrode CE' and the first anode electrode AE1'.

The first bank BNK1 may be disposed on the first anode electrode AE1', the (1-1)-th connection electrode LCE1a', and the cathode electrode CE'. The first bank BNK1 may have a first opening OP1 exposing portions of the first anode electrode AE1', the (1-1)-th connection electrode LCE1a', and the cathode electrode CE'. The first light emitting element LD1' may be disposed in the first opening OP1 of the first bank BNK1. As described above, the first bank BNK1 may be provided as a pixel defining layer that defines an area where the first light emitting element LD1' is positioned.

The first bank BNK1 may be configured to include a light blocking material, thereby preventing light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first reflective electrode RFE1 may be disposed on the exposed portion of the first anode electrode AE1' and on a side surface of the first bank BNK1 adjacent thereto. The second reflective electrode RFE2 may be disposed on the exposed portion of the cathode electrode CE' and on a side surface of the first bank BNK1 adjacent thereto. The third reflective electrode RFE3 may be disposed on the exposed portion of the (1-1)-th connection electrode LCE1a' and on a side surface of the first bank BNK1 adjacent thereto. The first to third reflective electrodes RFE1, RFE2, and RFE3 may include conductive materials suitable for reflecting light. Accordingly, light output efficiency of the first light emitting element LD1' may be improved. In embodiments, the first to third reflective electrodes RFE1, RFE2, and RFE3 may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The first light emitting element LD1' may include a (1-1)-th sub light emitting element SLD1a' and a (2-1)-th sub light emitting element SLD2a'. Each of the (1-1)-th sub light emitting element SLD1a' and the (2-1)-th sub light emitting element SLD2a' may include a light emitting stack EST' in which a first semiconductor layer 21, a second semiconductor layer 22, an active layer 23, and an auxiliary layer 24 may be sequentially stacked each other, and first and second bonding electrodes BDE1 and BDE2. Here, the first and second bonding electrodes BDE1 and BDE2 may protrude in a direction facing the pixel circuit layer PCL, and the first light emitting element LD1' may be referred to as a flip chip type of light emitting element.

The first semiconductor layer 21 may be configured to provide a hole. The first semiconductor layer 21 may have a first polarity. For example, the first semiconductor layer 21 may include at least one p-type semiconductor layer. For example, the first semiconductor layer 21 may include at least one semiconductor material among gallium nitride (GaN), aluminium gallium nitride (AlGaN), indium gallium nitride (InGaN), aluminium nitride (AlN), and indium nitride (InN), and may be a p-type semiconductor layer doped with a first conductive dopant (or a p-type dopant), such as magnesium (Mg), zinc (Zn), calcium (Ca), strontium (Sr), and barium (Ba). However, a material configuring the first semiconductor layer 21 is not limited thereto, and various other materials may configure the first semiconductor layer 21. In an embodiment of the disclosure, the first semiconductor layer 21 may include a gallium nitride (GaN) semiconductor material doped with the first conductive dopant (or the p-type dopant).

The second semiconductor layer 22 is disposed on the first semiconductor layer 21 and may be configured to provide an electron. The second semiconductor layer 22 may have a second polarity different from the first polarity. For example, the second semiconductor layer 22 may include at least one n-type semiconductor layer. For example, the second semiconductor layer 22 may include one semiconductor material among gallium nitride (GaN), aluminium gallium nitride (AlGaN), indium gallium nitride (InGaN), aluminium nitride (AlN), and indium nitride (InN), and may be an n-type semiconductor layer doped with a second conductive dopant (or an n-type dopant) such as silicon (Si), germanium (Ge), and tin (Sn). However, a material configuring the second semiconductor layer 22 is not limited thereto, and various other materials may configure the second semiconductor layer 22. In an embodiment of the disclosure, the second semiconductor layer 22 may include a gallium nitride (GaN) semiconductor material doped with the second conductive dopant (or the n-type dopant). According to an embodiment, the second semiconductor layer 22 may configure the n-type semiconductor layer together with the auxiliary layer 24.

The active layer 23 may be between the first semiconductor layer 21 and the second semiconductor layer 22 and may provide an area where the electron and the hole are recombined. As the electron and the hole recombine in the active layer 23, the electron and the hole transit to a lower energy level, and thus light having a wavelength corresponding thereto may be generated. The active layer 23 may be formed as a single or multiple quantum wells structure. In the case that the active layer 23 is formed as the multiple quantum wells structure, a unit including a barrier layer, a strain reinforcing layer, and a well layer may be repeatedly stacked each other to form the active layer 23. However, the active layer 23 is not limited to the above-described structure.

The auxiliary layer 24 may include a gallium nitride (GaN) semiconductor material in which an impurity is not substantially doped or an impurity is doped with a relatively low concentration. The auxiliary layer 24 may configure the n-type semiconductor layer together with the second semiconductor layer 22.

The first bonding electrode BDE1 may be disposed under the first semiconductor layer 21. The first bonding electrode BDE1 may be electrically connected to the first semiconductor layer 21. In embodiments, the first bonding electrode BDE1 of the (1-1)-th sub light emitting element SLD1a' may be electrically connected to the first anode electrode AE1' by contacting the first reflective electrode RFE1. The first bonding electrode BDE1 of the (2-1)-th sub light emitting element SLD2a' may be electrically connected to the (1-1)-th connection electrode LCE1a' by contacting the third reflective electrode RFE3.

The second bonding electrode BDE2 may be electrically connected to the second semiconductor layer 22. For example, the second bonding electrode BDE2 may contact the second semiconductor layer 22 exposed by removing the first semiconductor layer 21 and the active layer 23. In embodiments, the second bonding electrode BDE2 of the (1-1)-th sub light emitting element SLD1a' may be electrically connected to the (1-1)-th connection electrode LCE1a' by contacting the third reflective electrode RFE3. The second bonding electrode BDE2 of the (2-1)-th sub light emitting element SLD2a' may be electrically connected to the cathode electrode CE' by contacting the second reflective electrode RFE2.

Accordingly, between the first anode electrode AE1' and the cathode electrode CE', the (1-1)-th sub light emitting element SLD1a' and the (2-1)-th sub light emitting element SLD2a' may be connected to each other in series.

In embodiments, the first and second bonding electrodes BDE1 and BDE2 may include a eutectic metal.

The first light emitting element LD1' may further include an insulating layer 25 covering an outer peripheral surface of the light emitting stack EST'. The insulating layer 25 may serve to prevent an electrical short circuit that may occur in the case that the active layer 23 comes into contact with a conductive material other than the first and second semiconductor layers 21 and 22. The insulating layer 25 may include a transparent insulating material. The insulating layer 25 may be configured to expose at least lower surfaces of the first and second bonding electrodes BDE1 and BDE2.

The overcoat layer OCL may be disposed in the first opening OP1 where the first to third reflective electrodes RFE1, RFE2, and RFE3 and the first light emitting element LD1' are disposed. The overcoat layer OCL may fix the first light emitting element LD1' bonded to the first to third reflective electrodes RFE1, RFE2, and RFE3 so that the first light emitting element LD1' does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

The third passivation layer PSV3 may be disposed on the first bank BNK1 and the overcoat layer OCL. The third passivation layer PSV3 may protect components disposed under the third passivation layer PSV3 and may provide a flat upper surface. The third passivation layer PSV3 may include a same material as one of the first and second passivation layers PSV1 and PSV2, but embodiments are not limited thereto.

In embodiments, the third passivation layer PSV3 may not be disposed on an upper surface of the first light emitting element LD1'. The first light emitting element LD1' may protrude to the light functional layer LFL. The first light emitting element LD1' may be positioned at least partially in the second opening OP2 of the second bank BNK2. For example, a height of the upper surface of the first light emitting element LD1' from the substrate SUB may be higher than the lowermost end of the reflective layer RFL. Accordingly, light emitted from the first light emitting element LD1' may be provided to the light functional layer LFL at a relatively high rate.

The capping layer CPL may be disposed on the third passivation layer PSV3. The capping layer CPL may protect components under the capping layer CPL, such as the first light emitting element LD1', from external water, moisture, and the like within the spirit and the scope of the disclosure. In embodiments, the capping layer CPL may not be disposed on the upper surface of the first light emitting element LD1'. In other embodiments, the capping layer CPL may entirely cover the first light emitting element LD1' and the third passivation layer PSV3. The capping layer CPL may include at least one of silicon nitride, silicon oxide, silicon oxynitride, and a metal oxide such as aluminium oxide. However, a material of the capping layer CPL is not limited thereto.

Above, the pixel circuit layer PCL and the display element layer DPL of the first sub-pixel SP1' are described. Each of the second and third sub-pixels SP2' and SP3' of FIG. 17 may be configured similarly to the first sub-pixel SP1' unless otherwise described herein.

The light functional layer LFL may be disposed on the capping layer CPL. The light functional layer LFL may include the second bank BNK2, the reflective layer RFL, a fourth passivation layer PSV4, the first light conversion pattern CCP1, the low refractive layer LRL, and the color filter layer CFL.

The second bank BNK2 may be disposed on the capping layer CPL. The second bank BNK2 may overlap the first bank BNK1. The second bank BNK2 may have a second opening OP2 overlapping the first opening OP1.

The second bank BNK2 may be configured to include a light blocking material, thereby preventing light mixing between adjacent sub-pixels. In embodiments, the second bank BNK2 may include an organic material. For example, the second bank BNK2 may include an organic insulating material such as acryl resin, epoxy resin, phenol resin, polyamide resin, and polyimide resin.

The reflective layer RFL may be disposed on side surfaces of the second bank BNK2 adjacent to the second opening OP2. The reflective layer RFL may be configured to reflect incident light, and thus light output efficiency may be improved. The reflective layer RFL may include a material suitable for reflecting light. The reflective layer RFL may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The fourth passivation layer PSV4 may be disposed in the second opening OP2, on the capping layer CPL. The fourth passivation layer PSV4 may protect components disposed under the fourth passivation layer PSV4 and may provide a flat upper surface. The fourth passivation layer PSV4 may include a same material as one of the first to third passivation layers PSV1, PSV2, and PSV3, but embodiments are not limited thereto.

The first light conversion pattern CCP1 may be disposed in the second opening OP2, on the fourth passivation layer PSV4.

The first light conversion pattern CCP1 may include color conversion particles and/or scattering particles. The color conversion particles may change a wavelength of incident light and convert the incident light into light of another color. The color conversion particles may scatter the incident light. In embodiments, the color conversion particles may be quantum dots. The scattering particles may scatter the incident light.

The first sub-pixel SP1' may be a red sub-pixel. In case that the first light emitting element LD1' emits light of a blue color, the first light conversion pattern CCP1 may include first color conversion particles QD1 configured to convert the light of the blue color into light of a red color. In case that the first light emitting element LD1' emits the light of the red color, the first light conversion pattern CCP1 may include the scattering particles. As described above, particles included in the first light conversion pattern CCP1 may be variously changed according to a color of the light emitted by the first light emitting element LD1'.

The low refractive layer LRL may be disposed on the second bank BNK2, the reflective layer RFL, and the first light conversion pattern CCP1. The low refractive layer LRL may have a refractive index lower than that of the first light conversion pattern CCP1 and the first color filter CF1. The low refractive layer LRL may be configured to refract or totally reflect corresponding light according to an incidence angle of the light. For example, the low refractive layer LRL may provide light passing through the first light conversion pattern CCP1 back to the first light conversion pattern CCP1. Accordingly, light conversion efficiency of the first light conversion pattern CCP1 may be improved.

The color filter layer CFL may be disposed on the low refractive layer LRL. The color filter layer CFL may include the first color filter CF1 and the light blocking patterns LBP. The first color filter CF1 may overlap the first light conversion pattern CCP1. The first color filter CF1 may selectively transmit light of a desired wavelength range. In the case that the first sub-pixel SP1 is a red sub-pixel, the first color filter CF1 may include a red color filter. The light blocking patterns LBP may include at least one of various types of light blocking materials.

Referring to FIGS. 17 and 19, the pixel circuit layer PCL, the display element layer DPL, and the light functional layer LFL may be sequentially provided on the substrate SUB.

The pixel circuit layer PCL and the display element layer DPL are described similarly to those described with reference to FIG. 18. In the pixel circuit layer PCL, the sub-pixel circuits respectively corresponding to the first to third sub-pixels SP1', SP2', and SP3' may be provided. In the display element layer DPL, the first to third light emitting elements LD1', LD2', and LD3' respectively corresponding to the first to third sub-pixels SP1', SP2', and SP3' may be provided. The first to third light emitting elements LD1', LD2', and LD3' may overlap the first openings OP1 of the first bank BNK1. The first light emitting element LD1' may be connected between the cathode electrode CE' (refer to FIG. 18) and the transistor T_SP (refer to FIG. 18) included in the sub-pixel circuit of the first sub-pixel SP1'. The second light emitting element LD2' may be connected between the cathode electrode CE' and the transistor included in the sub-pixel circuit of the second sub-pixel SP2'. The third light emitting element LD3' may be connected between the cathode electrode CE' and the transistor included in the sub-pixel circuit of the third sub-pixel SP3'. Below, an overlapping description may be omitted.

The light functional layer LFL may be provided on the display element layer DPL. The light functional layer LFL is described similarly to that described with reference to FIG. 18. Below, an overlapping description may be omitted.

The second bank BNK2 may have second openings OP2. It may be understood that the emission area EMA and the non-emission area NEMA for the first to third sub-pixels SP1', SP2', and SP3' are defined by the second bank BNK2. An area overlapping the second bank BNK2 may correspond to the non-emission area NEMA. An area overlapping the second openings OP2 of the second bank BNK2 may correspond to the emission area EMA of the first to third sub-pixels SP1', SP2', and SP3'.

The fourth passivation layer PSV4 may be disposed in the second openings OP2, on the capping layer CPL. The first and second light conversion patterns CCP1 and CCP2 and the light scattering pattern LSP may be disposed in the second openings OP2, on the fourth passivation layer PSV4.

In embodiments, the first to third light emitting elements LD1', LD2', and LD3' may be configured to emit light of a blue color. In this case, the first light conversion pattern CCP1 may include first color conversion particles QD1 configured to convert the light of the blue color into light of a red color. The second light conversion pattern CCP2 may include second color conversion particles QD2 configured to convert the light of the blue color into light of a green color. The light scattering pattern LSP may include scattering particles SCT that scatter the light of the blue color to improve light output efficiency. Accordingly, the first to third sub-pixels SP1', SP2', and SP3' may be provided as a red sub-pixel, a green sub-pixel, and a blue sub-pixel, respectively. In embodiments, at least one of the first and second light conversion patterns CCP1 and CCP2 and the light scattering pattern LSP may further include color conversion particles that convert the light of the blue color into light of a white color.

In embodiments, the first to third light emitting elements LD1', LD2', and LD3' may be configured to emit the light of the red color, the green color, and the blue color, respectively. In this case, each of the first and second light conversion patterns CCP1 and CCP2 and the light scattering pattern LSP may include scattering particles SCT. As described above, according to a color of light emitted from the first to third light emitting elements LD1', LD2', and LD3', particles included in the first and second light conversion patterns CCP1 and CCP2 and the light scattering pattern LSP may be variously changed.

In embodiments, the first and second light conversion patterns CCP1 and CCP2 and the light scattering pattern LSP may be omitted.

The low refractive layer LRL may be disposed on the second bank BNK2, the reflective layer RFL, the first and second light conversion patterns CCP1 and CCP2, and the light scattering pattern LSP. The low refractive layer LRL may have a refractive index lower than that of the first and second light conversion patterns CCP1 and CCP2 and the light scattering pattern LSP. In embodiments, the low refractive layer LRL may be omitted in an area corresponding to the third sub-pixel SP3'.

The color filter layer CFL may be disposed on the low refractive layer LRL. The color filter layer CFL may include the first to third color filters CF1, CF2, and CF3, and the light blocking patterns LBP.

Each of the first to third color filters CF1, CF2, and CF3 may selectively transmit light of a desired wavelength range. In the case that the first sub-pixel SP1' is a red sub-pixel, the first color filter CF1 may include a red color filter. In the case that the second sub-pixel SP2' is a green sub-pixel, the second color filter CF2 may include a green color filter. In the case that the third sub-pixel SP3' is a blue sub-pixel, the third color filter CF3 may include a blue color filter. The first to third color filters CF1, CF2, and CF3 may have a refractive index higher than that of the low refractive layer LRL. However, embodiments are not limited thereto, and the first to third color filters CF1, CF2, and CF3 may have a refractive index lower than or equal to that of the low refractive layer LRL.

The light blocking patterns LBP may be disposed between the first to third color filters CF1, CF2, and CF3. It may be understood that the emission area (or a light output area) EMA and the non-emission area NEMA for the first to third sub-pixels SP1', SP2', and SP3' are defined by the light blocking patterns LBP. An area overlapping the light blocking patterns LBP may correspond to the non-emission area NEMA. An area that does not overlap the light blocking patterns LBP may correspond to the emission area EMA.

In embodiments, the light blocking patterns LBP may include at least one of various types of light blocking materials. In embodiments, each of the light blocking patterns LBP may be provided in a form of multiple layers in which at least two color filters among the first to third color filters CF1, CF2, and CF3 overlap. For example, each of the light blocking patterns LBP may be formed by overlapping the first to third color filters CF1, CF2, and CF3. As another example, a light blocking pattern between the first and second color filters CF1 and CF2 among the light blocking patterns LBP may be formed as multiple layers in which the first and second color filters CF1 and CF2 overlap, a light blocking pattern between the second and third color filters CF2 and CF3 among the light blocking patterns LBP may be formed as multiple layers in which the second and third color filters CF2 and CF3 overlap, and a light blocking pattern between the first color filter CF1 and the third color filter CF3 of a neighboring pixel may be formed as multiple layers in which the first and third color filters CF1 and CF3 overlap. As described above, each of the first to third color filters CF1, CF2, and CF3 may extend to the non-emission area NEMA to form the light blocking patterns LBP.

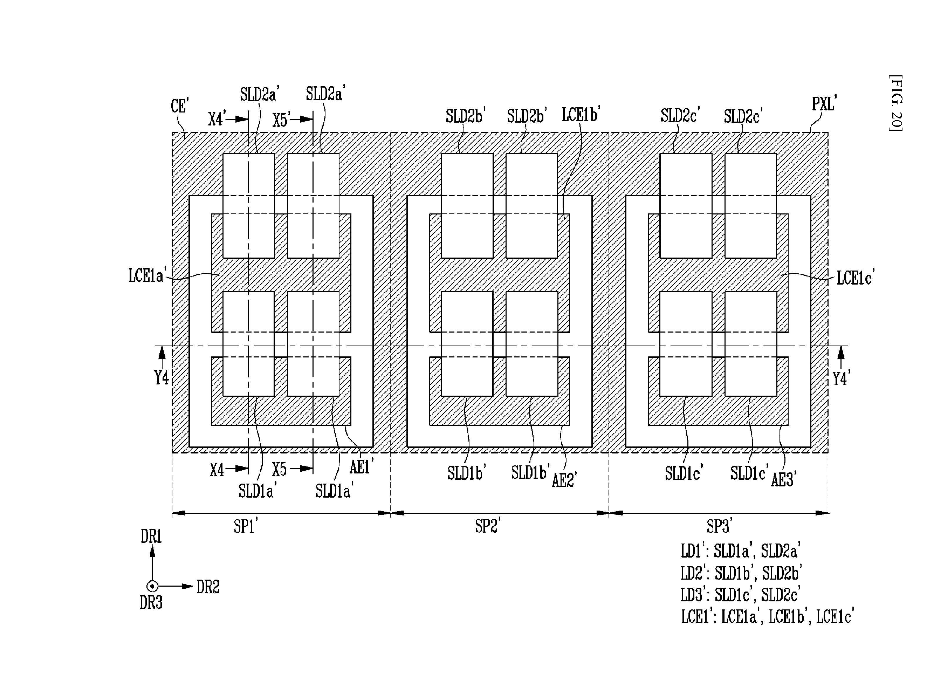

FIG. 20 is a schematic plan view illustrating a (2-2)-th embodiment of one of the pixels included in the display panel of FIG. 3.

Referring to FIG. 20, the pixel PXL' according to the (2-2)-th embodiment of the disclosure may be substantially the same as the pixel PXL' according to the (2-1)-th embodiment of the disclosure described with reference to FIG. 17, except that each of the (1-1)-th to (1-3)-th sub light emitting elements SLD1a', SLD1b', and SLD1c' and the (2-1)-th to (2-3)-th sub light emitting elements SLD2a', SLD2b', and SLD2c' are provided. Therefore, a description of an overlapping content may be omitted.

The (1-1)-th sub light emitting elements SLD1a' may be provided. For example, two (1-1)-th sub light emitting elements SLD1a' may be provided, but the disclosure is not limited thereto. Three or more (1-1)-th sub light emitting elements SLD1a' may be provided. Each of the (1-1)-th sub light emitting elements SLD1a' may be electrically connected to the first anode electrode AE1' and the (1-1)-th connection electrode LCE1a'. In this case, the (1-1)-th sub light emitting elements SLD1a' may be connected to each other in parallel between the first anode electrode AE1' and the (1-1)-th connection electrode LCE1a'.

The (2-1)-th sub light emitting elements SLD2a' may be provided. For example, two (2-1)-th sub light emitting elements SLD2a' may be provided, but the disclosure is not limited thereto. Three or more (2-1)-th sub light emitting elements SLD2a' may be provided. Each of the (2-1)-th sub light emitting elements SLD2a' may be electrically connected to the (1-1)-th connection electrode LCE1a' and the cathode electrode CE'. In this case, the (2-1)-th sub light emitting elements SLD2a' may be connected to each other in parallel between the (1-1)-th connection electrode LCE1a' and the cathode electrode CE'.

Between the first anode electrode AE1' and the cathode electrode CE', the (1-1)-th sub light emitting elements SLD1a' and the (2-1)-th sub light emitting elements SLD2a' may be connected to each other in series through the (1-1)-th connection electrode LCE1a'.

Similarly, the (1-2)-th and (1-3)-th sub light emitting elements SLD1b' and SLD1c' and the (2-2)-th and (2-3)-th sub light emitting elements SLD2b' and SLD2c' may also be provided. In this case, the (1-2)-th sub light emitting elements SLD1b' may be connected to each other in parallel, the (1-3)-th sub light emitting elements SLD1c' may be connected to each other in parallel, the (2-2)-th sub light emitting elements SLD2b' may be connected to each other in parallel, and the (2-3)-th sub light emitting elements SLD2c' may be connected to each other in parallel. The (1-2)-th sub light emitting elements SLD1b' and the (2-2)-th sub light emitting elements SLD2b' may be connected to each other in series, and the (1-3)-th sub light emitting elements SLD1c' and the (2-3)-th sub light emitting elements SLD2c' may be connected to each other in series.

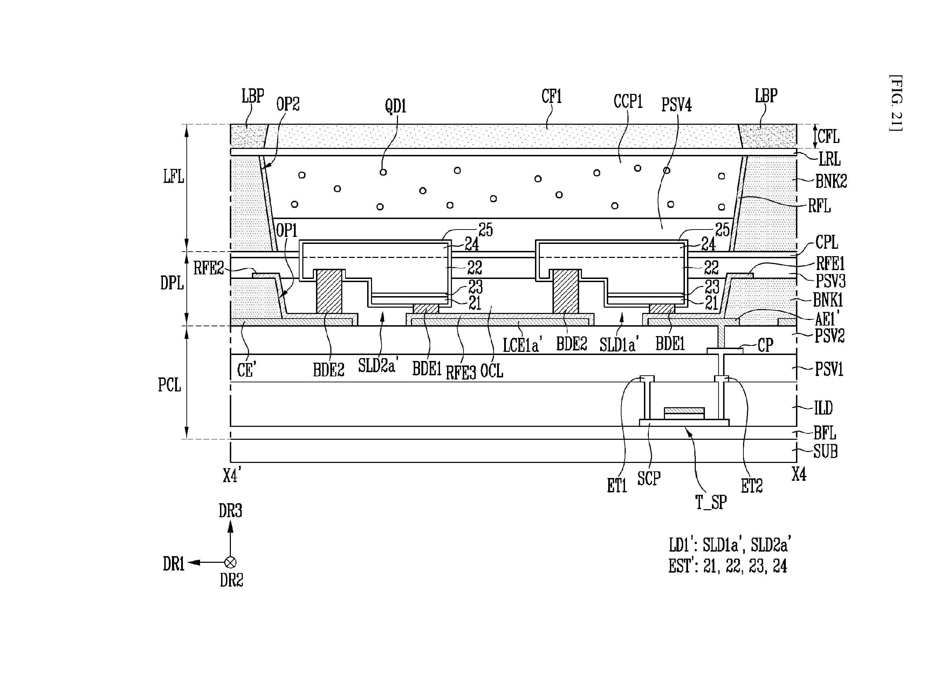

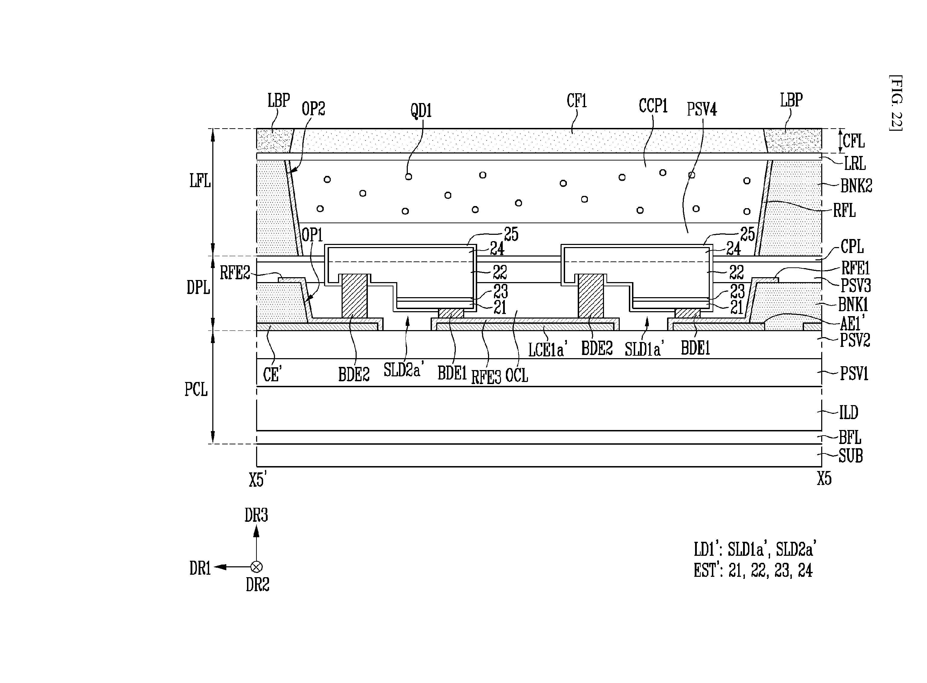

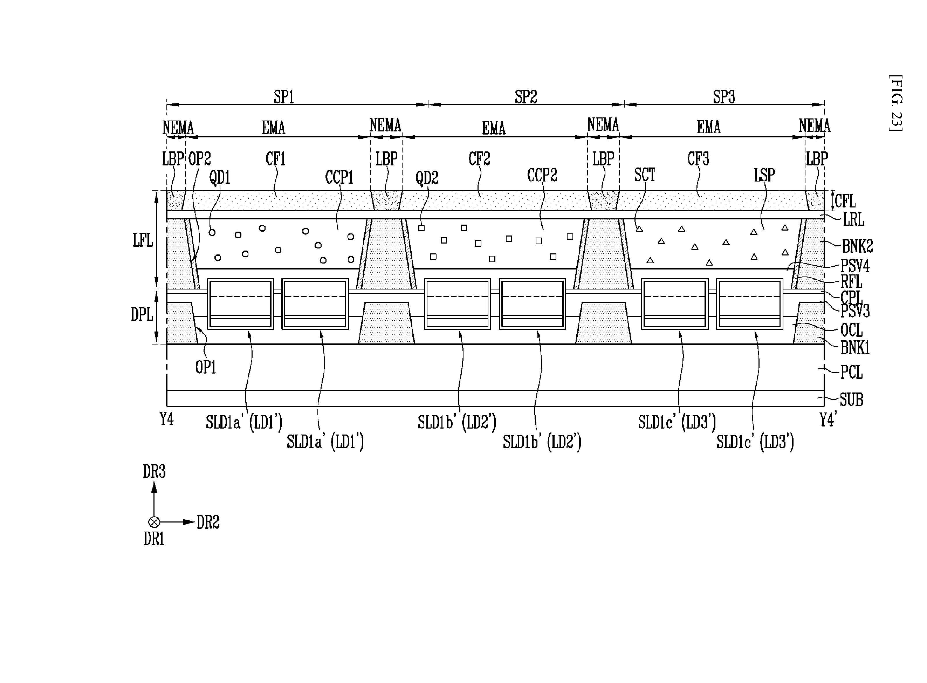

FIGS. 21 to 23 are schematic cross-sectional views illustrating the pixel according to the (2-2)-th embodiment of FIG. 20. FIG. 21 is a schematic cross-sectional view taken along line X4-X4' of FIG. 20, FIG. 22 is a schematic cross-sectional view taken along line X5-X5' of FIG. 20, and FIG. 23 is a schematic cross-sectional view taken along line Y4-Y4' of FIG. 20.

Referring to FIGS. 20 to 23, the each of the (1-1)-th to (1-3)-th sub light emitting elements SLD1a', SLD1b', and SLD1c' and the (2-1)-th to (2-3)-th sub light emitting elements SLD2a', SLD2b', and SLD2c' may be provided. In this case, each of the (1-1)-th to (1-3)-th sub light emitting elements SLD1a', SLD1b', and SLD1c' and the (2-1)-th to (2-3)-th sub light emitting elements SLD2a', SLD2b', and SLD2c' may be a flip chip type of light emitting element as described with reference to FIG. 18. Hereinafter, a description of a content overlapping that described with reference to FIGS. 18 and 19 may be omitted.

In embodiments, the first bonding electrodes BDE1 of the (1-1)-th sub light emitting elements SLD1a' may be electrically connected to the first anode electrode AE1' by contacting the first reflective electrode RFE1. The second bonding electrodes BDE2 of the (1-1)-th sub light emitting elements SLD1a' may be electrically connected to the (1-1)-th connection electrode LCE1a' by contacting the third reflective electrode RFE3.

In embodiments, the first bonding electrodes BDE1 of the (2-1)-th sub light emitting elements SLD2a' may be electrically connected to the (1-1)-th connection electrode LCE1a' by contacting the third reflective electrode RFE3. The second bonding electrodes BDE2 of the (2-1)-th sub light emitting elements SLD2a' may be electrically connected to the cathode electrode CE' by contacting the second reflective electrode RFE2.

Accordingly, between the first anode electrode AE1' and the cathode electrode CE', the (1-1)-th sub light emitting elements SLD1a' and the (2-1)-th sub light emitting elements SLD2a' may be connected to each other in series. The (1-1)-th sub light emitting elements SLD1a' may be connected to each other in parallel between the first anode electrode AE1' and the (1-1)-th connection electrode LCE1a', and the (2-1)-th sub light emitting elements SLD2a' may be connected to each other in parallel between the (1-1)-th connection electrode LCE1a' and the cathode electrode CE'.

Above, the first light emitting element LD1' included in the first sub-pixel SP1' is described, but each of the second and third light emitting elements LD2' and LD3' included in the second and third sub-pixels SP2' and SP3' of FIG. 20 may be configured similarly to the first light emitting element LD1' unless otherwise described herein.

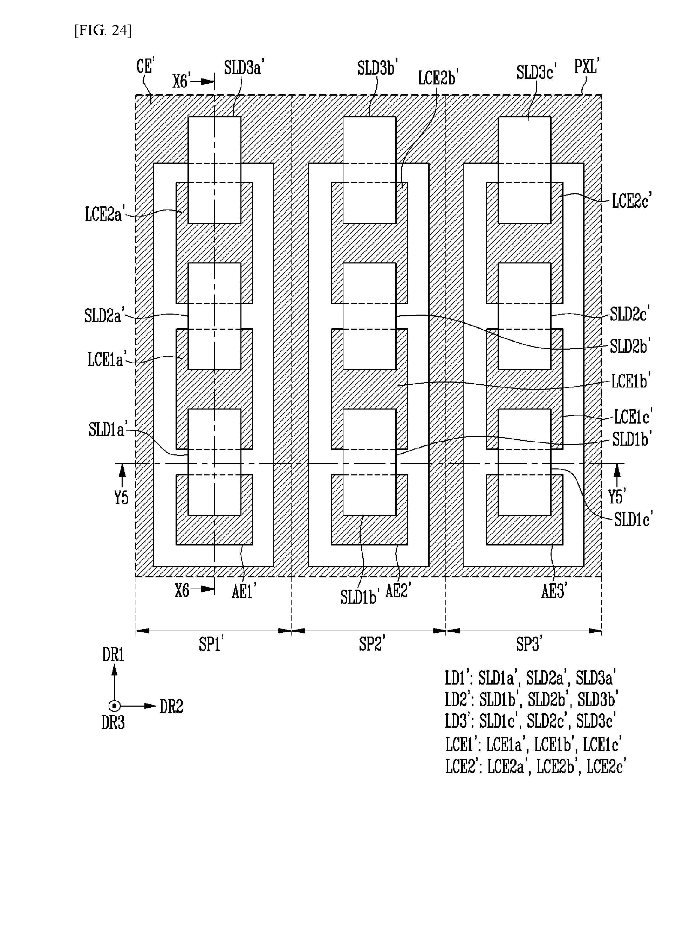

FIG. 24 is a schematic plan view illustrating a (2-3)-th embodiment of one of the pixels included in the display panel of FIG. 3.

Referring to FIG. 24, the pixel PXL' may include first to third sub-pixels SP1', SP2', and SP3'. The first to third sub-pixels SP1', SP2', and SP3' may be arranged in the second direction DR2. However, an arrangement of the pixel PXL' is not limited thereto and may variously change according to embodiments. For example, the first to third sub-pixels SP1', SP2', and SP3' may be arranged in a zigzag.

First to third anode electrodes AE1', AE2', and AE3' may be disposed in the first to third sub-pixels SP1', SP2', and SP3', respectively. The first to third anode electrodes AE1', AE2', and AE3' may be configured similarly to those described with reference to FIG. 17.

A first connection electrode LCE1' may be disposed in the first to third sub-pixels SP1', SP2', and SP3'. The first connection electrode LCE1' may include a (1-1)-th connection electrode LCE1a', a (1-2)-th connection electrode LCE1b', and a (1-3)-th connection electrode LCE1c'. The (1-1)-th to (1-3)-th connection electrodes LCE1a', LCE1b', and LCE1c' may be configured similarly to those described with reference to FIG. 17.

A second connection electrode LCE2' may be disposed in the first to third sub-pixels SP1', SP2', and SP3'. The second connection electrode LCE2' may include a (2-1)-th connection electrode LCE2a', a (2-2)-th connection electrode LCE2b', and a (2-3)-th connection electrode LCE2c'. The (2-1)-th connection electrode LCE2a' may be provided in the first sub-pixel SP1' and may be spaced apart from the first anode electrode AE1' and the (1-1)-th connection electrode LCE1a'. The (2-2)-th connection electrode LCE2b' may be provided in the second sub-pixel SP2' and may be spaced apart from the second anode electrode AE2' and the (1-2)-th connection electrode LCE1b'. The (2-3)-th connection electrode LCE2c' may be provided in the third sub-pixel SP3' and may be spaced apart from the third anode electrode AE3' and the (1-3)-th connection electrode LCE1c'. In embodiments, the (2-1)-th to (2-3)-th connection electrodes LCE2a', LCE2b', and LCE2c' may be disposed in the same layers as the first to third anode electrodes AE1', AE2', and AE3' and the (1-1)-th to (1-3)-th connection electrodes LCE1a', LCE1b', and LCE1c'. In this case, the (2-1)-th to (2-3)-th connection electrodes LCE2a', LCE2b', and LCE2c' may be formed through a same formation process as the first to third anode electrodes AE1', AE2', and AE3' and the (1-1)-th to (1-3)-th connection electrodes LCE1a', LCE1b', and LCE1c'.

A cathode electrode CE' may be spaced apart from the first to third anode electrodes AE1', AE2', and AE3', the (1-1)-th to (1-3)-th connection electrodes LCE1a', LCE1b', and LCE1c', and the (2-1)-th to (2-3)-th connection electrodes LCE2a', LCE2b', and LCE2c'. The cathode electrode CE' may be disposed in a same layer as the first to third anode electrodes AE1', AE2', and AE3'. In embodiments, the cathode electrode CE' may extend in the first and second directions DR1 and DR2 and may be used as a common electrode for the pixel PXL' and other pixels adjacent to the pixel PXL'. In embodiments, as shown in FIG. 24, the first anode electrode AE1', the (1-1)-th connection electrode LCE1a', and the (2-1)-th connection electrode LCE2a' may be surrounded by the cathode electrode CE', the second anode electrode AE2', the (1-2)-th connection electrode LCE1b', and the (2-2)-th connection electrode LCE2b' may be surrounded by the cathode electrode CE', and the third anode electrode AE3', the (1-3)-th connection electrode LCE1c', and the (2-3)-th connection electrode LCE2c' may be surrounded by the cathode electrode CE'. As described above, the cathode electrode CE' may have various shapes.

First to third light emitting elements LD1', LD2', and LD3' may be disposed on the first to third anode electrodes AE1', AE2', and AE3', the (1-1)-th to (1-3)-th connection electrodes LCE1a', LCE1b', and LCE1c', the (2-1)-th to (2-3)-th connection electrodes LCE2a', LCE2b', and LCE2c', and the cathode electrode CE'.

The first light emitting element LD1' may be provided as the light emitting element LD (refer to FIG. 2) connected to the sub-pixel circuit SPC of the first sub-pixel SP1'. The first light emitting element LD1' may include a (1-1)-th sub light emitting element SLD1a', a (2-1)-th sub light emitting element SLD2a', and a (3-1)-th sub light emitting element SLD3a'. The (1-1)-th sub light emitting element SLD1a' may be electrically connected to the first anode electrode AE1' and the (1-1)-th connection electrode LCE1a'. The (2-1)-th sub light emitting element SLD2a' may be electrically connected to the (1-1)-th connection electrode LCE1a' and the (2-1)-th connection electrode LCE2a'. The (3-1)-th sub light emitting element SLD3a' may be electrically connected to the (2-1)-th connection electrode LCE2a' and the cathode electrode CE'. Accordingly, between the first anode electrode AE1' and the cathode electrode CE', the (1-1)-th sub light emitting element SLD1a', the (2-1)-th sub light emitting element SLD2a', and the (3-1)-th sub light emitting element SLD3a' may be connected to each other in series through the (1-1)-th connection electrode LCE1a' and the (2-1)-th connection electrode LCE2a'.

The second light emitting element LD2' may be provided as the light emitting element LD (refer to FIG. 2) connected to the sub-pixel circuit SPC of the second sub-pixel SP2'. The second light emitting element LD2' may include a (1-2)-th sub light emitting element SLD1b', a (2-2)-th sub light emitting element SLD2b', and a (3-2)-th sub light emitting element SLD3b'. The (1-2)-th sub light emitting element SLD1b' may be electrically connected to the second anode electrode AE2' and the (1-2)-th connection electrode LCE1b'. The (2-2)-th sub light emitting element SLD2b' may be electrically connected to the (1-2)-th connection electrode LCE1b' and the (2-2)-th connection electrode LCE2b'. The (3-2)-th sub light emitting element SLD3b' may be electrically connected to the (2-2)-th connection electrode LCE2b' and the cathode electrode CE'. Accordingly, between the second anode electrode AE2' and the cathode electrode CE', the (1-2)-th sub light emitting element SLD1b', the (2-2)-th sub light emitting element SLD2b', and the (3-2)-th sub light emitting element SLD3b' may be connected to each other in series through the (1-2)-th connection electrode LCE1b' and the (2-2)-th connection electrode LCE2b'.

The third light emitting element LD3' may be provided as the light emitting element LD (refer to FIG. 2) connected to the sub-pixel circuit SPC of the third sub-pixel SP3'. The third light emitting element LD3' may include a (1-3)-th sub light emitting element SLD1c', a (2-3)-th sub light emitting element SLD2c', and a (3-3)-th sub light emitting element SLD3c'. The (1-3)-th sub light emitting element SLD1c' may be electrically connected to the third anode electrode AE3' and the (1-3)-th connection electrode LCE1c'. The (2-3)-th sub light emitting element SLD2c' may be electrically connected to the (1-3)-th connection electrode LCE1c' and the (2-3)-th connection electrode LCE2c'. The (3-3)-th sub light emitting element SLD3c' may be electrically connected to the (2-3)-th connection electrode LCE2c' and the cathode electrode CE'. Accordingly, between the third anode electrode AE3' and the cathode electrode CE', the (1-3)-th sub light emitting element SLD1c', the (2-3)-th sub light emitting element SLD2c', and the (3-3)-th sub light emitting element SLD3c' may be connected to each other in series through the (1-3)-th connection electrode LCE1c' and the (2-3)-th connection electrode LCE2c'.

The first light emitting element LD1', the second light emitting element LD2', and the third light emitting element LD3' may be inorganic light emitting diodes including an inorganic light emitting material. However, embodiments are not limited thereto and, for example, organic light emitting diodes may be used.

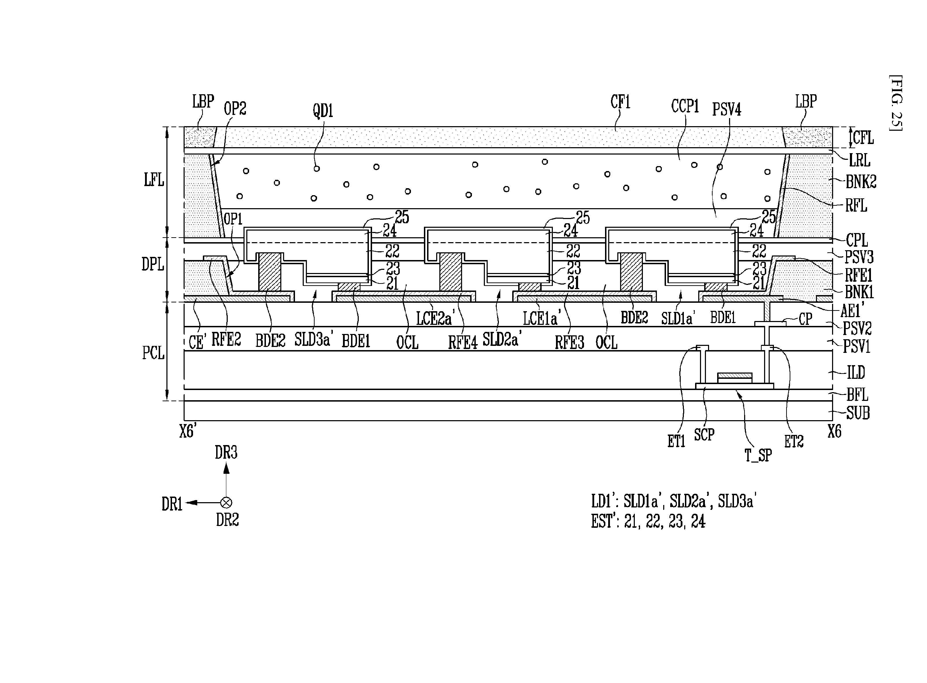

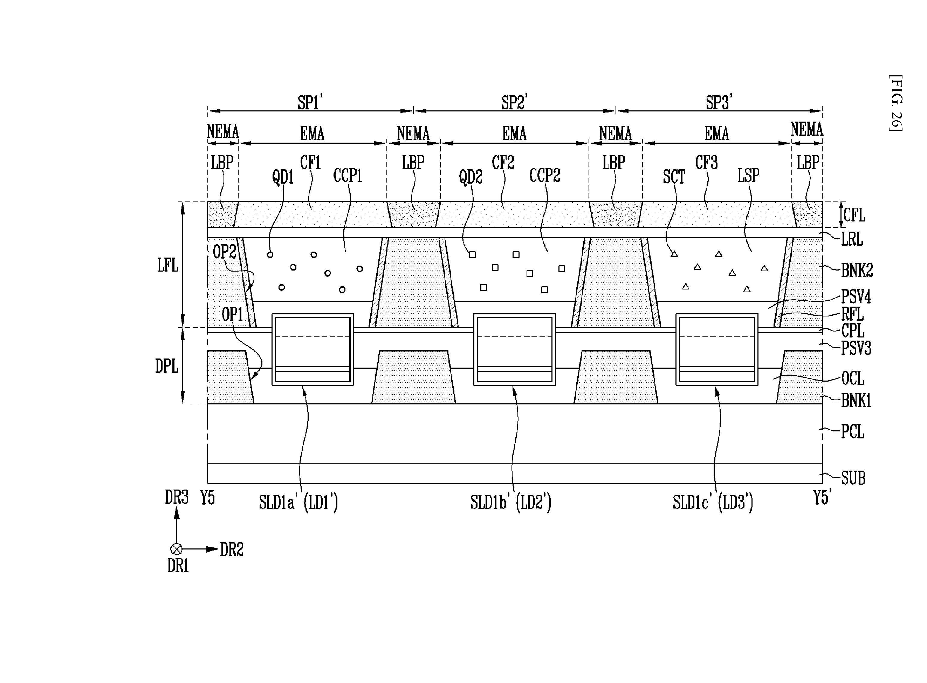

FIGS. 25 and 26 are schematic cross-sectional views illustrating the pixel according to the (2-3)-th embodiment of FIG. 24. FIG. 25 is a schematic cross-sectional view taken along line X6-X6' of FIG. 24, and FIG. 26 is a schematic cross-sectional view taken along line Y5-Y5' of FIG. 24.

Referring to FIGS. 24 and 25, the pixel circuit layer PCL, the display element layer DPL, and the light functional layer LFL may be sequentially disposed on the substrate SUB.

The pixel circuit layer PCL is described similarly to that described with reference to FIG. 18. Therefore, a description of an overlapping content may be omitted.

The display element layer DPL may be disposed on the pixel circuit layer PCL. The display element layer DPL may include the first anode electrode AE1', the (1-1)-th connection electrode LCE1a', the (2-1)-th connection electrode LCE2a', the cathode electrode CE', the first bank BNK1, first to fourth reflective electrodes RFE1, RFE2, RFE3, and RFE4, the first light emitting element LD1', the overcoat layer OCL, the third passivation layer PSV3, and the capping layer CPL.

The first anode electrode AE1', the (1-1)-th connection electrode LCE1a', the (2-1)-th connection electrode LCE2a', and the cathode electrode CE' may be disposed on the pixel circuit layer PCL.

The first anode electrode AE1' may be electrically connected to the connection pattern CP through a contact hole passing through the second passivation layer PSV2. As described above, the first anode electrode AE1' may be electrically connected to the transistor T_SP.

The cathode electrode CE' may be spaced apart from the first anode electrode AE1' in the first direction DR1. The cathode electrode CE' may be electrically connected to the second power voltage node VSSN of FIG. 2. Accordingly, the second power voltage applied to the second power voltage node VSSN may be transmitted to the cathode electrode CE'.

The (1-1)-th connection electrode LCE1a' may be disposed between the cathode electrode CE' and the first anode electrode AE1'. The (1-1)-th connection electrode LCE1a' may be spaced apart from the cathode electrode CE' and the first anode electrode AE1'.

The (2-1)-th connection electrode LCE2a' may be disposed between the (1-1)-th connection electrode LCE1a' and the cathode electrode CE'. The (2-1)-th connection electrode LCE2a' may be spaced apart from the cathode electrode CE', the (1-1)-th connection electrode LCE1a', and the first anode electrode AE1'.

The first bank BNK1 may be disposed on the first anode electrode AE1', the (1-1)-th connection electrode LCE1a', the (2-1)-th connection electrode LCE2a', and the cathode electrode CE'. The first bank BNK1 may have a first opening OP1 exposing portions of the first anode electrode AE1', the (1-1)-th connection electrode LCE1a', (2-1)-th connection electrode LCE2a' and the cathode electrode CE'. The first light emitting element LD1' may be disposed in the first opening OP1 of the first bank BNK1. As described above, the first bank BNK1 may be provided as a pixel defining layer that defines an area where the first light emitting element LD1' is positioned.

The first bank BNK1 may be configured to include a light blocking material, thereby preventing light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first reflective electrode RFE1 may be disposed on the exposed portion of the first anode electrode AE1' and on a side surface of the first bank BNK1 adjacent thereto. The second reflective electrode RFE2 may be disposed on the exposed portion of the cathode electrode CE' and on a side surface of the first bank BNK1 adjacent thereto. The third reflective electrode RFE3 may be disposed on the exposed portion of the (1-1)-th connection electrode LCE1a' and on a side surface of the first bank BNK1 adjacent thereto. The fourth reflective electrode RFE4 may be disposed on the exposed portion of the (2-1)-th connection electrode LCE2a' and on a side surface of the first bank BNK1 adjacent thereto. The first to fourth reflective electrodes RFE1, RFE2, RFE3, and RFE4 may include conductive materials suitable for reflecting light. Accordingly, light output efficiency of the first light emitting element LD1' may be improved. In embodiments, the first to fourth reflective electrodes RFE1, RFE2, RFE3, and RFE4 may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The first light emitting element LD1' may include a (1-1)-th sub light emitting element SLD1a', a (2-1)-th sub light emitting element SLD2a', and a (3-1)-th sub light emitting element SLD3a'. Each of the (1-1)-th sub light emitting element SLD1a', the (2-1)-th sub light emitting element SLD2a', and the (3-1)-th sub light emitting element SLD3a' may include a light emitting stack EST' in which a first semiconductor layer 21, a second semiconductor layer 22, an active layer 23, and an auxiliary layer 24 may be sequentially stacked each other, and first and second bonding electrodes BDE1 and BDE2. Here, the first and second bonding electrodes BDE1 and BDE2 may protrude in a direction facing the pixel circuit layer PCL, and the first light emitting element LD1' may be referred to as a flip chip type of light emitting element. Here, the content described with reference to FIG. 17 may be applied substantially identically to the flip chip type of light emitting element. Therefore, a description of an overlapping content may be omitted.

In embodiments, the first bonding electrode BDE1 of the (1-1)-th sub light emitting element SLD1a' may be electrically connected to the first anode electrode AE1' by contacting the first reflective electrode RFE1. The second bonding electrode BDE2 of the (1-1)-th sub light emitting element SLD1a' may be electrically connected to the (1-1)-th connection electrode LCE1a' by contacting the third reflective electrode RFE3.

In embodiments, the first bonding electrode BDE1 of the (2-1)-th sub light emitting element SLD2a' may be electrically connected to the (1-1)-th connection electrode LCE1a' by contacting the third reflective electrode RFE3. The second bonding electrode BDE2 of the (2-1)-th sub light emitting element SLD2a' may be electrically connected to the (2-1)-th connection electrode LCE2a' by contacting the fourth reflective electrode RFE3.

In embodiments, the first bonding electrode BDE1 of the (3-1)-th sub light emitting element SLD3a' may be electrically connected to the (2-1)-th connection electrode LCE2a' by contacting the fourth reflective electrode RFE4. The second bonding electrode BDE2 of the (3-1)-th sub light emitting element SLD3a' may be electrically connected to the cathode electrode CE' by contacting the second reflective electrode RFE2.

Accordingly, between the first anode electrode AE1' and the cathode electrode CE', the (1-1)-th sub light emitting element SLD1a', the (2-1)-th sub light emitting element SLD2a', and the (3-1)-th sub light emitting elements SLD3a' may be connected to each other in series.

In embodiments, the first and second bonding electrodes BDE1 and BDE2 may include a eutectic metal.

The first light emitting element LD1' may further include an insulating layer 25 covering an outer peripheral surface of the light emitting stack EST'. The insulating layer 25 may serve to prevent an electrical short circuit that may occur in the case that the active layer 23 comes into contact with a conductive material other than the first and second semiconductor layers 21 and 22. The insulating layer 25 may include a transparent insulating material. The insulating layer 25 may be configured to expose at least lower surfaces of the first and second bonding electrodes BDE1 and BDE2.

The overcoat layer OCL may be disposed in the first opening OP1 where the first to third reflective electrodes RFE1, RFE2, and RFE3 and the first light emitting element LD1' are disposed. The overcoat layer OCL may fix the first light emitting element LD1' bonded to the first to fourth reflective electrodes RFE1, RFE2, RFE3, and RFE4 so that the first light emitting element LD1' does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

The third passivation layer PSV3 may be disposed on the first bank BNK1 and the overcoat layer OCL. The third passivation layer PSV3 may protect components disposed under the third passivation layer PSV3 and may provide a flat upper surface. The third passivation layer PSV3 may include a same material as one of the first and second passivation layers PSV1 and PSV2, but embodiments are not limited thereto.

In embodiments, the third passivation layer PSV3 may not be disposed on an upper surface of the first light emitting element LD1'. The first light emitting element LD1' may protrude to the light functional layer LFL. The first light emitting element LD1' may be positioned at least partially in the second opening OP2 of the second bank BNK2. For example, a height of the upper surface of the first light emitting element LD1' from the substrate SUB may be higher than the lowermost end of the reflective layer RFL. Accordingly, light emitted from the first light emitting element LD1' may be provided to the light functional layer LFL at a relatively high rate.

The capping layer CPL may be disposed on the third passivation layer PSV3. The capping layer CPL may protect components under the capping layer CPL, such as the first light emitting element LD1', from external water, moisture, and the like within the spirit and the scope of the disclosure. In embodiments, the capping layer CPL may not be disposed on the upper surface of the first light emitting element LD1'. In other embodiments, the capping layer CPL may entirely cover the first light emitting element LD1' and the third passivation layer PSV3. The capping layer CPL may include at least one of silicon nitride, silicon oxide, silicon oxynitride, and a metal oxide such as aluminium oxide. However, a material of the capping layer CPL is not limited thereto.

Above, the pixel circuit layer PCL and the display element layer DPL of the first sub-pixel SP1' are described. Each of the second and third sub-pixels SP2' and SP3' of FIG. 24 may be configured similarly to the first sub-pixel SP1' unless otherwise described herein.

The light functional layer LFL may be disposed on the capping layer CPL. The light functional layer LFL may include the second bank BNK2, the reflective layer RFL, a fourth passivation layer PSV4, the first light conversion pattern CCP1, the low refractive layer LRL, and the color filter layer CFL. The light functional layer LFL may be described similarly to that described with reference to FIG. 17. Therefore, a description of an overlapping content may be omitted.

Referring to FIGS. 24 and 26, the pixel circuit layer PCL, the display element layer DPL, and the light functional layer LFL may be sequentially provided on the substrate SUB.

The pixel circuit layer PCL and the display element layer DPL are described similarly to those described with reference to FIG. 25. In the pixel circuit layer PCL, the sub-pixel circuits respectively corresponding to the first to third sub-pixels SP1', SP2', and SP3' may be provided. In the display element layer DPL, the first to third light emitting elements LD1', LD2', and LD3' respectively corresponding to the first to third sub-pixels SP1', SP2', and SP3' may be provided. The first to third light emitting elements LD1', LD2', and LD3' may overlap the first openings OP1 of the first bank BNK1. The first light emitting element LD1' may be connected between the cathode electrode CE' (refer to FIG. 25) and the transistor T_SP (refer to FIG. 25) included in the sub-pixel circuit of the first sub-pixel SP1'. The second light emitting element LD2' may be connected between the cathode electrode CE' and the transistor included in the sub-pixel circuit of the second sub-pixel SP2'. The third light emitting element LD3' may be connected between the cathode electrode CE' and the transistor included in the sub-pixel circuit of the third sub-pixel SP3'. Below, an overlapping description may be omitted.

The light functional layer LFL may be provided on the display element layer DPL. The light functional layer LFL is described similarly to that described with reference to FIG. 19. Therefore, a description of an overlapping content may be omitted.

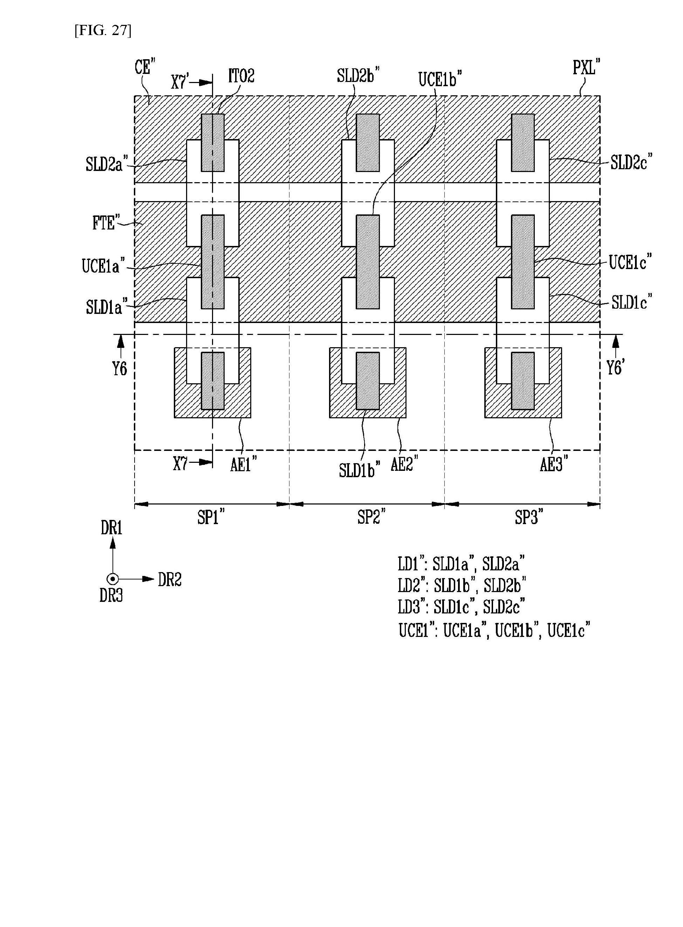

FIG. 27 is a schematic plan view illustrating a (3-1)-th embodiment of one of the pixels included in the display panel of FIG. 3.

Referring to FIG. 27, the pixel PXL" may include first to third sub-pixels SP1", SP2", and SP3". The first to third sub-pixels SP1", SP2", and SP3" may be arranged in the second direction DR2. However, an arrangement of the pixel PXL" is not limited thereto and may variously change according to embodiments. For example, the first to third sub-pixels SP1", SP2", and SP3" may be arranged in a zigzag.

First to third anode electrodes AE1", AE2", and AE3" may be disposed in the first to third sub-pixels SP1", SP2", and SP3", respectively. The first anode electrode AE1" may be provided as the anode electrode AE (refer to FIG. 3) of the sub-pixel circuit SPC (refer to FIG. 2) included in the first sub-pixel SP1". The second anode electrode AE2" may be provided as the anode electrode AE of the sub-pixel circuit SPC included in the second sub-pixel SP2". The third anode electrode AE3" may be provided as the anode electrode AE of the sub-pixel circuit SPC included in the third sub-pixel SP3".

The cathode electrode CE" may be spaced apart from the first to third anode electrodes AE1", AE2", and AE3". The cathode electrode CE" may be disposed in a same layer as the first to third anode electrodes AE1", AE2", and AE3". The cathode electrode CE" may be spaced apart from the first to third anode electrodes AE1", AE2", and AE3" in the first direction DR1. In embodiments, the cathode electrode CE" may extend in the second direction DR2 and may be used as a common electrode for the pixel PXL" and other pixels adjacent to the pixel PXL". Although not shown, the cathode electrode CE" may extend not only in the second direction DR2 but also in the first direction DR1 and may be used as a common electrode for all of the sub-pixels SP of FIG. 4. As described above, the cathode electrode CE" may have various shapes.

In embodiments, a floating electrode FTE" may be further disposed between the first to third anode electrodes AE1", AE2", AE3" and the cathode electrode CE". The floating electrode FTE" may be spaced apart from the first to third anode electrodes AE1", AE2", and AE3" and the cathode electrode CE". The floating electrode FTE" may be disposed in a same layer as the first to third anode electrodes AE1", AE2", and AE3".

According to embodiments, the floating electrode FTE" may be connected to one of the first to third anode electrodes AE1", AE2", and AE3" to function as a repair line.

According to embodiments, the floating electrode FTE" may be connected to the cathode electrode CE" to function as an auxiliary line for reducing a resistance of the cathode electrode CE".

According to embodiments, floating electrodes FTE" may be provided. For example, between the first to third anode electrodes AE1", AE2", and AE3" and the cathode electrode CE", first and second floating electrodes extending in the second direction DR2 and arranged in the first direction DR1 may be disposed. In this case, one of the first and second floating electrodes may be connected to one of the first to third anode electrodes AE1", AE2", and AE3" to function as the repair line, and the remaining one of the first and second floating electrodes may be connected to the cathode electrode CE" to function as the auxiliary line for reducing the resistance of the cathode electrode CE".

According to embodiments, the floating electrode FTE" may be omitted. In this case, the cathode electrode CE" may extend and may be disposed in an area where the floating electrode FTE" shown in FIG. 27 is disposed. Accordingly, the resistance of the cathode electrode CE" may be reduced.

First to third light emitting elements LD1", LD2", and LD3" may be disposed on the first to third anode electrodes AE1", AE2", and AE3", the cathode electrode CE", and the floating electrode FTE".

The first light emitting element LD1" may be provided as the light emitting element LD (refer to FIG. 2) connected to the sub-pixel circuit SPC of the first sub-pixel SP1". The first light emitting element LD1" may include a (1-1)-th sub light emitting element SLD1a" and a (2-1)-th sub light emitting element SLD2a". The (1-1)-th sub light emitting element SLD1a" may be electrically connected to the first anode electrode AE1" and a (1-1)-th connection electrode UCE1a" described later. The (2-1)-th sub light emitting element SLD2a" may be electrically connected to the (1-1)-th connection electrode UCE1a" and the cathode electrode CE". Accordingly, between the first anode electrode AE1" and the cathode electrode CE", the (1-1)-th sub light emitting element SLD1a" and the (2-1)-th sub light emitting element SLD2a" may be connected to each other in series through the (1-1)-th connection electrode UCE1a".

The second light emitting element LD2" may be provided as the light emitting element LD (refer to FIG. 2) connected to the sub-pixel circuit SPC of the second sub-pixel SP2". The second light emitting element LD2" may include a (1-2)-th sub light emitting element SLD1b" and a (2-2)-th sub light emitting element SLD2b". The (1-2)-th sub light emitting element SLD1b" may be electrically connected to the second anode electrode AE2" and a (1-2)-th connection electrode UCE1b" described later. The (2-2)-th sub light emitting element SLD2b" may be electrically connected to the (1-2)-th connection electrode UCE1b" and the cathode electrode CE". Accordingly, between the second anode electrode AE2" and the cathode electrode CE", the (1-2)-th sub light emitting element SLD1b" and the (2-2)-th sub light emitting element SLD2b" may be connected to each other in series through the (1-2)-th connection electrode UCE1b".

The third light emitting element LD3" may be provided as the light emitting element LD (refer to FIG. 2) connected to the sub-pixel circuit SPC of the third sub-pixel SP3". The third light emitting element LD3" may include a (1-3)-th sub light emitting element SLD1c" and a (2-3)-th sub light emitting element SLD2c". The (1-3)-th sub light emitting element SLD1c" may be electrically connected to the third anode electrode AE3" and a (1-3)-th connection electrode UCE1c" described later. The (2-3)-th sub light emitting element SLD2c" may be electrically connected to the (1-3)-th connection electrode UCE1c" and the cathode electrode CE". Accordingly, between the third anode electrode AE3" and the cathode electrode CE", the (1-3)-th sub light emitting element SLD1c" and the (2-3)-th sub light emitting element SLD2c" may be connected to each other in series through the (1-3)-th connection electrode UCE1c".

The first light emitting element LD1", the second light emitting element LD2", and the third light emitting element LD3" may be inorganic light emitting diodes including an inorganic light emitting material. However, embodiments are not limited thereto, and for example, organic light emitting diodes may be used.

A first transparent electrode ITO1, a second transparent electrode ITO2, and a first connection electrode UCE1" may be disposed on the first light emitting element LD1", the second light emitting element LD2", and the third light emitting element LD3".

The first transparent electrode ITO1 may be disposed in the first to third sub-pixels SP1", SP2", and SP3", respectively. In the first sub-pixel SP1", the first anode electrode AE1" and the (1-1)-th sub light emitting element SLD1a" may be electrically connected to each other through the first transparent electrode ITO1. In the second sub-pixel SP2", the second anode electrode AE2" and the (1-2)-th sub light emitting element SLD1b" may be electrically connected to each other through the first transparent electrode ITO1. In the third sub-pixel SP3", the third anode electrode AE3" and the (1-3)-th sub light emitting elements SLD1c" may be electrically connected to each other through the first transparent electrode ITO1.

The second transparent electrode ITO2 may be disposed in the first to third sub-pixels SP1", SP2", and SP3", respectively. In the first sub-pixel SP1", the cathode electrode CE" and the (2-1)-th sub light emitting elements SLD2a" may be electrically connected to each other through the second transparent electrode ITO2. In the second sub-pixel SP2", the cathode electrode CE" and the (2-2)-th sub light emitting element SLD2b" may be electrically connected to each other through the second transparent electrode ITO2. In the third sub-pixel SP3", the cathode electrode CE" and the (2-3)-th sub light emitting elements SLD2c" may be electrically connected to each other through the second transparent electrode ITO1.

The first connection electrode UCE1" may be spaced apart from the first and second transparent electrodes ITO1 and ITO2. In embodiments, the first connection electrode UCE1" may be disposed in a same layer as the first and second transparent electrodes ITO1 and ITO2. The first connection electrode UCE1" may include a (1-1)-th connection electrode UCE1a", a (1-2)-th connection electrode UCE1b", and a (1-3)-th connection electrode UCE1c".

The (1-1)-th connection electrode UCE1a" may be provided in the first sub-pixel SP1". The (1-1)-th connection electrode UCE1a" may be electrically connected to the (1-1)-th sub light emitting element SLD1a" and the (2-1)-th sub light emitting element SLD2a".

The (1-2)-th connection electrode UCE1b" may be provided in the second sub-pixel SP2". The (1-2)-th connection electrode UCE1b" may be electrically connected to the (1-2)-th sub light emitting element SLD1b" and the (2-2)-th sub light emitting element SLD2b".

The (1-3)-th connection electrode UCE1c" may be provided in the third sub-pixel SP3". The (1-3)-th connection electrode UCE1c" may be electrically connected to the (1-3)-th sub light emitting element SLD1c" and the (2-3)-th sub light emitting element SLD2c".

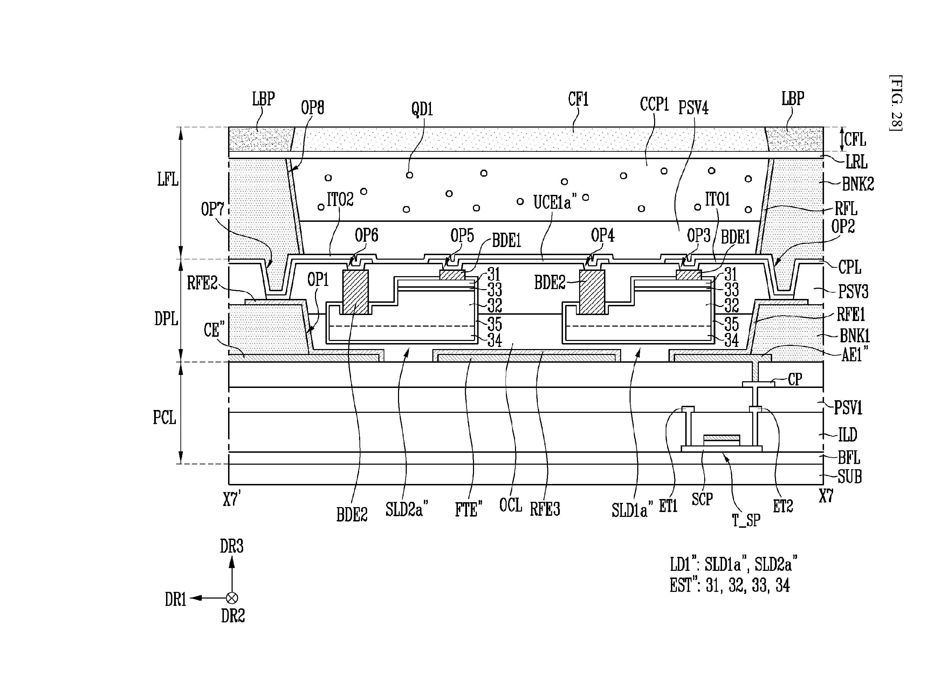

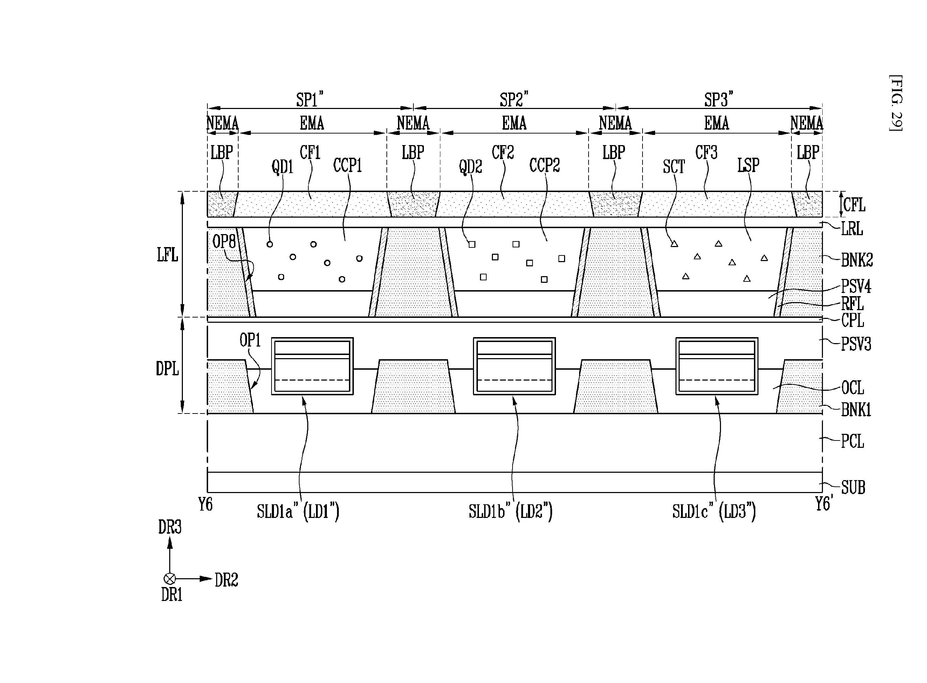

FIGS. 28 and 29 are schematic cross-sectional views illustrating the pixel according to the (3-1)-th embodiment of FIG. 27. FIG. 28 is a schematic cross-sectional view taken along line X7-X7' of FIG. 27, and FIG. 29 is a schematic cross-sectional view taken along line Y6-Y6' of FIG. 27.

Referring to FIGS. 27 and 28, the pixel circuit layer PCL, the display element layer DPL, and the light functional layer LFL may be sequentially disposed on the substrate SUB.

The pixel circuit layer PCL may be configured similarly to that described with reference to FIG. 9. Therefore, a description of an overlapping content may be omitted.

The display element layer DPL may be disposed on the pixel circuit layer PCL. The display element layer DPL may include the first anode electrode AE1", the floating electrode FTE", the cathode electrode CE", the first bank BNK1, the first to third reflective electrodes RFE1, RFE2, and RFE3, the overcoat layer OCL, the first light emitting element LD1", the third passivation layer PSV3, the first and second transparent electrodes ITO1 and ITO2, the (1-1)-th connection electrode UCE1a", and the capping layer CPL.

The first anode electrode AE1", the floating electrode FTE", and the cathode electrode CE" may be disposed on the pixel circuit layer PCL.

The first anode electrode AE1" may be electrically connected to the connection pattern CP through a contact hole passing through the second passivation layer PSV2. As described above, the first anode electrode AE1" may be electrically connected to the transistor T_SP.

The cathode electrode CE" may be spaced apart from the first anode electrode AE1" in the first direction DR1. The cathode electrode CE" may be electrically connected to the second power voltage node VSSN of FIG. 2. Accordingly, the second power voltage applied to the second power voltage node VSSN may be transmitted to the cathode electrode CE".

The floating electrode FTE" may be disposed between the first anode electrode AE1" and the cathode electrode CE". The floating electrode FTE" may be spaced apart from the first anode electrode AE1" and the cathode electrode CE".

The first bank BNK1 may be disposed on the first anode electrode AE1", the floating electrode FTE", and the cathode electrode CE". The first bank BNK1 may have a first opening OP1 exposing portions of the first anode electrode AE1", the floating electrode FTE", and the cathode electrode CE". The first light emitting element LD1" may be disposed in the first opening OP1 of the first bank BNK1. As described above, the first bank BNK1 may be provided as a pixel defining layer that defines an area where the first light emitting element LD1" is positioned.

The first bank BNK1 may be configured to include a light blocking material, thereby preventing light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first reflective electrode RFE1 may be disposed on the exposed portion of the first anode electrode AE1" and on a side surface of the first bank BNK1 adjacent thereto. The second reflective electrode RFE2 may be disposed on the exposed portion of the cathode electrode CE" and on a side surface of the first bank BNK1 adjacent thereto. The third reflective electrode RFE3 may be disposed on the exposed portion of the floating electrode FTE" and on a side surface of the first bank BNK1 adjacent thereto. The first to third reflective electrodes RFE1, RFE2, and RFE3 may include conductive materials suitable for reflecting light. Accordingly, light output efficiency of the first light emitting element LD1" may be improved. In embodiments, the first to third reflective electrodes RFE1, RFE2, and RFE3 may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The overcoat layer OCL may be disposed in the first opening OP1 of the first bank BNK1, on the first to third reflective electrodes RFE1, RFE2, and RFE3 and the second passivation layer PSV2. The first light emitting element LD1" may be disposed on the overcoat layer OCL. The first light emitting element LD1" may be partially buried in the overcoat layer OCL.

The overcoat layer OCL may fix the first light emitting element LD1" so that the first light emitting element LD1" does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

The first light emitting element LD1" may include a (1-1)-th sub light emitting element SLD1a" and a (2-1)-th sub light emitting element SLD2a". Each of the (1-1)-th sub light emitting element SLD1a" and the (2-1)-th sub light emitting element SLD2a" may include a light emitting stack EST" in which an auxiliary layer 34, a second semiconductor layer 32, an active layer 33, and a first semiconductor layer 31 may be sequentially stacked each other, and first and second bonding electrodes BDE1 and BDE2. Here, the first and second bonding electrodes BDE1 and BDE2 may protrude in a direction far from the pixel circuit layer PCL, and the first light emitting element LD1" may be referred to as a lateral chip type of light emitting element.

The first semiconductor layer 31 may be configured to provide a hole. The first semiconductor layer 31 may have a first polarity. For example, the first semiconductor layer 31 may include at least one p-type semiconductor layer. For example, the first semiconductor layer 31 may include at least one semiconductor material among gallium nitride (GaN), aluminium gallium nitride (AlGaN), indium gallium nitride (InGaN), aluminium nitride (AlN), and indium nitride (InN), and may be a p-type semiconductor layer doped with a first conductive dopant (or a p-type dopant), such as magnesium (Mg), zinc (Zn), calcium (Ca), strontium (Sr), and barium (Ba). However, a material configuring the first semiconductor layer 31 is not limited thereto, and various other materials may configure the first semiconductor layer 31. In an embodiment of the disclosure, the first semiconductor layer 31 may include a gallium nitride (GaN) semiconductor material doped with the first conductive dopant (or the p-type dopant).

The second semiconductor layer 32 is disposed under the first semiconductor layer 31 and may be configured to provide an electron. The second semiconductor layer 32 may have a second polarity different from the first polarity. For example, the second semiconductor layer 32 may include at least one n-type semiconductor layer. For example, the second semiconductor layer 32 may include one semiconductor material among gallium nitride (GaN), aluminium gallium nitride (AlGaN), indium gallium nitride (InGaN), aluminium nitride (AlN), and indium nitride (InN), and may be an n-type semiconductor layer doped with a second conductive dopant (or an n-type dopant) such as silicon (Si), germanium (Ge), and tin (Sn). However, a material configuring the second semiconductor layer 32 is not limited thereto, and various other materials may configure the second semiconductor layer 32. In an embodiment of the disclosure, the second semiconductor layer 32 may include a gallium nitride (GaN) semiconductor material doped with the second conductive dopant (or the n-type dopant). According to an embodiment, the second semiconductor layer 32 may configure the n-type semiconductor layer together with the auxiliary layer 34.

The active layer 33 may be between the first semiconductor layer 31 and the second semiconductor layer 32 and may provide an area where the electron and the hole are recombined. As the electron and the hole recombine in the active layer 33, the electron and the hole transit to a lower energy level, and thus light having a wavelength corresponding thereto may be generated. The active layer 33 may be formed as a single or multiple quantum wells structure. In the case that the active layer 33 is formed as the multiple quantum wells structure, a unit including a barrier layer, a strain reinforcing layer, and a well layer may be repeatedly stacked each other to form the active layer 23. However, the active layer 33 is not limited to the above-described structure.

The auxiliary layer 34 may include a gallium nitride (GaN) semiconductor material in which an impurity is not substantially doped or an impurity is doped with a relatively low concentration. The auxiliary layer 34 may configure the n-type semiconductor layer together with the second semiconductor layer 32.

The first bonding electrode BDE1 may be disposed on the first semiconductor layer 31. The first bonding electrode BDE1 may be electrically connected to the first semiconductor layer 31. The second bonding electrode BDE2 may be electrically connected to the second semiconductor layer 32. For example, the second bonding electrode BDE2 may contact the second semiconductor layer 32 exposed by removing the first semiconductor layer 31 and the active layer 33. In embodiments, the first and second bonding electrodes BDE1 and BDE2 may include a eutectic metal.

The first light emitting element LD1" may further include an insulating layer 35 covering an outer peripheral surface of the light emitting stack EST". The insulating layer 35 may serve to prevent an electrical short circuit that may occur in the case that the active layer 33 comes into contact with a conductive material other than the first and second semiconductor layers 31 and 32. The insulating layer 35 may include a transparent insulating material. The insulating layer 35 may be configured to expose at least upper surfaces of the first and second bonding electrodes BDE1 and BDE2.

The third passivation layer PSV3 may be disposed on the first to third reflective electrodes RFE1, RFE2, and RFE3, the first light emitting element LD1", and the overcoat layer OCL. The third passivation layer PSV3 may protect components disposed under the third passivation layer PSV3 and may provide a flat upper surface. The third passivation layer PSV3 may include a same material as one of the first and second passivation layers PSV1 and PSV2, but embodiments are not limited thereto.

The third passivation layer PSV3 may have second to seventh openings OP2, OP3, OP4, OP5, OP6, and OP7. The second opening OP2 may expose a portion of the first reflective electrode RFE1. The third opening OP3 may expose an upper surface of the first bonding electrode BDE1 of the (1-1)-th sub light emitting element SLD1a". The fourth opening OP4 may expose an upper surface of the second bonding electrode BDE2 of the (1-1)-th sub light emitting element SLD1a". The fifth opening OP5 may expose an upper surface of the first bonding electrode BDE1 of the (2-1)-th sub light emitting element SLD2a". The sixth opening OP6 may expose an upper surface of the second bonding electrode BDE2 of the (2-1)-th sub light emitting element SLD2a". The seventh opening OP7 may expose a portion of the second reflective electrode RFE2.

The first transparent electrode ITO1, the second transparent electrode ITO2, and the (1-1)-th connection electrode UCE1a" may be disposed on the third passivation layer PSV3.

The first transparent electrode ITO1 may electrically connect the first reflective electrode RFE1 exposed by the second opening OP2 to the first bonding electrode BDE1 of the (1-1)-th sub light emitting element SLD1a" exposed by the third opening OP3. Accordingly, the first bonding electrode BDE1 of the (1-1)-th sub light emitting element SLD1a" may be electrically connected to the first anode electrode AE1" through the first transparent electrode ITO1 and the first reflective electrode RFE1.

The second transparent electrode ITO2 may electrically connect the second reflective electrode RFE2 exposed by the seventh opening OP7 to the second bonding electrode BDE2 of the (2-1)-th sub light emitting element SLD2a" exposed by the sixth opening OP6. Accordingly, the second bonding electrode BDE2 of the (2-1)-th sub light emitting element SLD2a" may be electrically connected to the cathode electrode CE" through the second transparent electrode ITO2 and the second reflective electrode RFE2.

The (1-1)-th connection electrode UCE1a" may electrically connect the second bonding electrode BDE2 of the (1-1)-th sub light emitting element SLD1a" exposed by the fourth opening OP4 to the first bonding electrode BDE1 of the (2-1)-th sub light emitting element SLD2a" exposed by the fifth opening OP5. Accordingly, the second bonding electrode BDE2 of the (1-1)-th sub light emitting element SLD1a" may be electrically connected to the first bonding electrode BDE1 of the (2-1)-th sub light emitting element SLD2a" through the (1-1)-th connection electrode UCE1a".

As described above, between the first anode electrode AE1" and the cathode electrode CE", the (1-1)-th sub light emitting element SLD1a" and the (2-1)-th sub light emitting element SLD2a" may be connected to each other in series through the (1-1)-th connection electrode UCE1a".

In embodiments, the first transparent electrode ITO1, the second transparent electrode ITO2, and the (1-1)-th connection electrode UCE1a" may be configured to be substantially transparent or translucent to satisfy a selectable light transmittance. In embodiments, the first transparent electrode ITO1, the second transparent electrode ITO2, and the (1-1)-th connection electrode UCE1a" may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, a material of the first transparent electrode ITO1, the second transparent electrode ITO2, and the (1-1)-th connection electrode UCE1a" is not limited thereto.

The capping layer CPL may be disposed on the third passivation layer PSV3. The capping layer CPL may protect components under the capping layer CPL, such as the first and second transparent electrodes ITO1 and ITO2, the (1-1)-th connection electrode UCE1a", the first light emitting element LD1", and the like within the spirit and the scope of the disclosure. The capping layer CPL may include at least one of silicon nitride, silicon oxide, silicon oxynitride, and a metal oxide such as aluminium oxide. However, a material of the capping layer CPL is not limited thereto.

Above, the pixel circuit layer PCL and the display element layer DPL of the first sub-pixel SP1" are described. Each of the second and third sub-pixels SP2" and SP3" of FIG. 27 may be configured similarly to the first sub-pixel SP1" unless otherwise described herein.

The light functional layer LFL may be disposed on the capping layer CPL. The light functional layer LFL may include the second bank BNK2, the reflective layer RFL, a fourth passivation layer PSV4, the first light conversion pattern CCP1, the low refractive layer LRL, and the color filter layer CFL.

The second bank BNK2 may be disposed on the capping layer CPL. The second bank BNK2 may overlap the first bank BNK1. The second bank BNK2 may have an eighth opening OP8 overlapping the first opening OP1.

The second bank BNK2 may be configured to include a light blocking material, thereby preventing light mixing between adjacent sub-pixels. In embodiments, the second bank BNK2 may include an organic material. For example, the second bank BNK2 may include an organic insulating material such as acryl resin, epoxy resin, phenol resin, polyamide resin, and polyimide resin.

The reflective layer RFL may be disposed on side surfaces of the second bank BNK2 adjacent to the eighth opening OP8. The reflective layer RFL may be configured to reflect incident light, and thus light output efficiency may be improved. The reflective layer RFL may include a material suitable for reflecting light. The reflective layer RFL may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The fourth passivation layer PSV4 may be disposed in the eighth opening OP8, on the capping layer CPL. The fourth passivation layer PSV4 may protect components disposed under the fourth passivation layer PSV4 and may provide a flat upper surface. The fourth passivation layer PSV4 may include a same material as one of the first to third passivation layers PSV1, PSV2, and PSV3, but embodiments are not limited thereto.

The first light conversion pattern CCP1 may be disposed in the eighth opening OP8, on the fourth passivation layer PSV4.

The first light conversion pattern CCP1 may include color conversion particles and/or scattering particles. The color conversion particles may change a wavelength of incident light and convert the incident light into light of another color. The color conversion particles may scatter the incident light. In embodiments, the color conversion particles may be quantum dots. The scattering particles may scatter the incident light.

The first sub-pixel SP1" may be a red sub-pixel. In the case that the first light emitting element LD1" emits light of a blue color, the first light conversion pattern CCP1 may include first color conversion particles QD1 configured to convert the light of the blue color into light of a red color. In the case that the first light emitting element LD1" emits the light of the red color, the first light conversion pattern CCP1 may include the scattering particles. As described above, particles included in the first light conversion pattern CCP1 may be variously changed according to a color of the light emitted by the first light emitting element LD1".

The low refractive layer LRL may be disposed on the second bank BNK2, the reflective layer RFL, and the first light conversion pattern CCP1. The low refractive layer LRL may have a refractive index lower than that of the first light conversion pattern CCP1 and the first color filter CF1. The low refractive layer LRL may be configured to refract or totally reflect corresponding light according to an incidence angle of the light. For example, the low refractive layer LRL may provide light passing through the first light conversion pattern CCP1 back to the first light conversion pattern CCP1. Accordingly, light conversion efficiency of the first light conversion pattern CCP1 may be improved.

The color filter layer CFL may be disposed on the low refractive layer LRL. The color filter layer CFL may include the first color filter CF1 and the light blocking patterns LBP. The first color filter CF1 may overlap the first light conversion pattern CCP1. The first color filter CF1 may selectively transmit light of a desired wavelength range. In the case that the first sub-pixel SP1" is a red sub-pixel, the first color filter CF1 may include a red color filter. The light blocking patterns LBP may include at least one of various types of light blocking materials.

Referring to FIGS. 27 and 29, the pixel circuit layer PCL, the display element layer DPL, and the light functional layer LFL may be sequentially provided on the substrate SUB.

The pixel circuit layer PCL and the display element layer DPL are described similarly to those described with reference to FIG. 28. In the pixel circuit layer PCL, the sub-pixel circuits respectively corresponding to the first to third sub-pixels SP1", SP2", and SP3" may be provided. In the display element layer DPL, the first to third light emitting elements LD1", LD2", and LD3" respectively corresponding to the first to third sub-pixels SP1", SP2", and SP3" may be provided. The first to third light emitting elements LD1", LD2", and LD3" may overlap the first openings OP1 of the first bank BNK1. The first light emitting element LD1" may be connected between the cathode electrode CE" (refer to FIG. 28) and the transistor T_SP (refer to FIG. 28) included in the sub-pixel circuit of the first sub-pixel SP1". The second light emitting element LD2" may be connected between the cathode electrode CE" and the transistor included in the sub-pixel circuit of the second sub-pixel SP2". The third light emitting element LD3" may be connected between the cathode electrode CE" and the transistor included in the sub-pixel circuit of the third sub-pixel SP3". Below, an overlapping description may be omitted.

The light functional layer LFL may be provided on the display element layer DPL. The light functional layer LFL is described similarly to that described with reference to FIG. 28. Below, an overlapping description may be omitted.

The second bank BNK2 may have eighth openings OP8. It may be understood that the emission area EMA and the non-emission area NEMA for the first to third sub-pixels SP1", SP2", and SP3" are defined by the second bank BNK2. An area overlapping the second bank BNK2 may correspond to the non-emission area NEMA. An area overlapping the eighth openings OP8 of the second bank BNK2 may correspond to the emission area EMA of the first to third sub-pixels SP1", SP2", and SP3".

The fourth passivation layer PSV4 may be disposed in the eighth openings OP8, on the capping layer CPL. The first and second light conversion patterns CCP1 and CCP2 and the light scattering pattern LSP may be disposed in the eighth openings OP8, on the fourth passivation layer PSV4.

In embodiments, the first to third light emitting elements LD1", LD2", and LD3" may be configured to emit light of a blue color. In this case, the first light conversion pattern CCP1 may include first color conversion particles QD1 configured to convert the light of the blue color into light of a red color. The second light conversion pattern CCP2 may include second color conversion particles QD2 configured to convert the light of the blue color into light of a green color. The light scattering pattern LSP may include scattering particles SCT that scatter the light of the blue color to improve light output efficiency. Accordingly, the first to third sub-pixels SP1", SP2", and SP3" may be provided as a red sub-pixel, a green sub-pixel, and a blue sub-pixel, respectively. In embodiments, at least one of the first and second light conversion patterns CCP1 and CCP2 and the light scattering pattern LSP may further include color conversion particles that convert the light of the blue color into light of a white color.

In embodiments, the first to third light emitting elements LD1", LD2", and LD3" may be configured to emit the light of the red color, the green color, and the blue color, respectively. In this case, each of the first and second light conversion patterns CCP1 and CCP2 and the light scattering pattern LSP may include scattering particles SCT. As described above, according to the first to third light emitting elements LD1", LD2", and LD3", particles included in the first and second light conversion patterns CCP1 and CCP2 and the light scattering pattern LSP may be variously changed.

In embodiments, the first and second light conversion patterns CCP1 and CCP2 and the light scattering pattern LSP may be omitted.

The low refractive layer LRL may be disposed on the second bank BNK2, the reflective layer RFL, the first and second light conversion patterns CCP1 and CCP2, and the light scattering pattern LSP. The low refractive layer LRL may have a refractive index lower than that of the first and second light conversion patterns CCP1 and CCP2 and the light scattering pattern LSP. In embodiments, the low refractive layer LRL may be omitted in an area corresponding to the third sub-pixel SP3".

The color filter layer CFL may be disposed on the low refractive layer LRL. The color filter layer CFL may include the first to third color filters CF1, CF2, and CF3, and the light blocking patterns LBP.

Each of the first to third color filters CF1, CF2, and CF3 may selectively transmit light of a desired wavelength range. In the case that the first sub-pixel SP1" is a red sub-pixel, the first color filter CF1 may include a red color filter. In the case that the second sub-pixel SP2" is a green sub-pixel, the second color filter CF2 may include a green color filter. In the case that the third sub-pixel SP3" is a blue sub-pixel, the third color filter CF3 may include a blue color filter. The first to third color filters CF1, CF2, and CF3 may have a refractive index higher than that of the low refractive layer LRL. However, embodiments are not limited thereto, and the first to third color filters CF1, CF2, and CF3 may have a refractive index lower than or equal to that of the low refractive layer LRL.

The light blocking patterns LBP may be disposed between the first to third color filters CF1, CF2, and CF3. It may be understood that the emission area (or a light output area) EMA and the non-emission area NEMA for the first to third sub-pixels SP1", SP2", and SP3" are defined by the light blocking patterns LBP. An area overlapping the light blocking patterns LBP may correspond to the non-emission area NEMA. An area that does not overlap the light blocking patterns LBP may correspond to the emission area EMA.

In embodiments, the light blocking patterns LBP may include at least one of various types of light blocking materials. In embodiments, each of the light blocking patterns LBP may be provided in a form of multiple layers in which at least two color filters among the first to third color filters CF1, CF2, and CF3 overlap. For example, each of the light blocking patterns LBP may be formed by overlapping the first to third color filters CF1, CF2, and CF3. As another example, a light blocking pattern between the first and second color filters CF1 and CF2 among the light blocking patterns LBP may be formed as multiple layers in which the first and second color filters CF1 and CF2 overlap, a light blocking pattern between the second and third color filters CF2 and CF3 among the light blocking patterns LBP may be formed as multiple layers in which the second and third color filters CF2 and CF3 overlap, and a light blocking pattern between the first color filter CF1 and the third color filter CF3 of a neighboring pixel may be formed as multiple layers in which the first and third color filters CF1 and CF3 overlap. As described above, each of the first to third color filters CF1, CF2, and CF3 may extend to the non-emission area NEMA to form the light blocking patterns LBP.

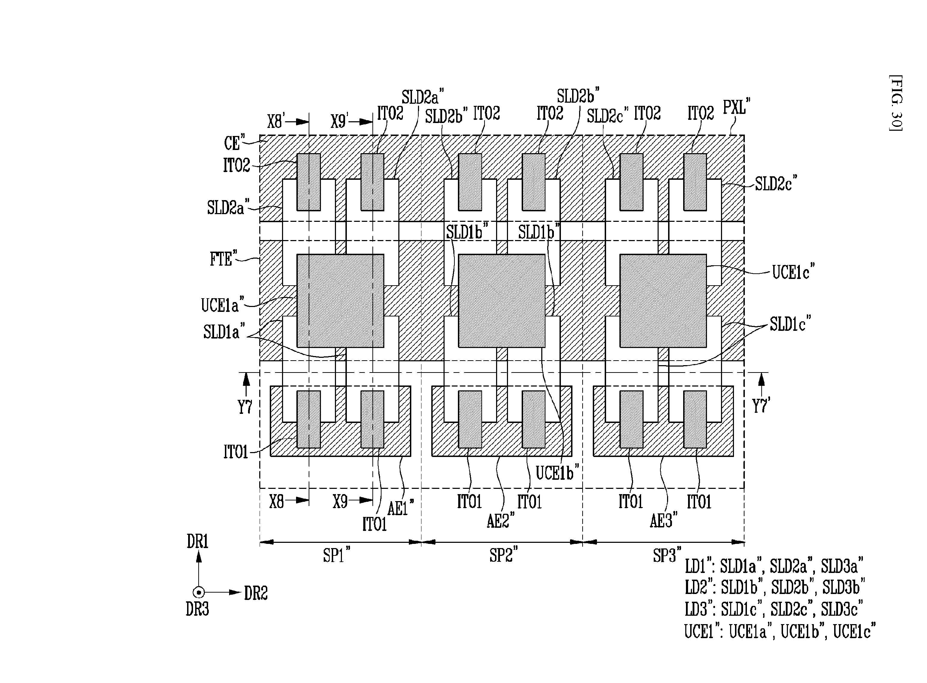

FIG. 30 is a schematic plan view illustrating a (3-2)-th embodiment of one of the pixels included in the display panel of FIG. 3.

Referring to FIG. 30, the pixel PXL" according to the (3-2)-th embodiment of the disclosure may be substantially the same as the pixel PXL" according to the (3-1)-th embodiment of the disclosure described with reference to FIG. 27, except that each of the (1-1)-th to (1-3)-th sub light emitting elements SLD1a", SLD1b", and SLD1c" and the (2-1)-th to (2-3)-th sub light emitting elements SLD2a", SLD2b", and SLD2c" are provided. Therefore, a description of an overlapping content may be omitted.

The (1-1)-th sub light emitting elements SLD1a" may be provided. For example, two (1-1)-th sub light emitting elements SLD1a" may be provided, but the disclosure is not limited thereto. Three or more (1-1)-th sub light emitting elements SLD1a" may be provided. Each of the (1-1)-th sub light emitting elements SLD1a" may be electrically connected to the first anode electrode AE1" and the (1-1)-th connection electrode UCE1a". In this case, the (1-1)-th sub light emitting elements SLD1a" may be connected to each other in parallel between the first anode electrode AE1" and the (1-1)-th connection electrode UCE1a".

The (2-1)-th sub light emitting elements SLD2a" may be provided. For example, two (2-1)-th sub light emitting elements SLD2a" may be provided, but the disclosure is not limited thereto. Three or more (2-1)-th sub light emitting elements SLD2a" may be provided. Each of the (2-1)-th sub light emitting elements SLD2a" may be electrically connected to the (1-1)-th connection electrode UCE1a" and the cathode electrode CE". In this case, the (2-1)-th sub light emitting elements SLD2a" may be connected to each other in parallel between the (1-1)-th connection electrode UCE1a" and the cathode electrode CE".

Between the first anode electrode AE1" and the cathode electrode CE", the (1-1)-th sub light emitting elements SLD1a" and the (2-1)-th sub light emitting elements SLD2a" may be connected to each other in series through the (1-1)-th connection electrode UCE1a".

Similarly, the (1-2)-th and (1-3)-th sub light emitting elements SLD1b" and SLD1c" and the (2-2)-th and (2-3)-th sub light emitting elements SLD2b" and SLD2c" may also be provided. In this case, the (1-2)-th sub light emitting elements SLD1b" may be connected to each other in parallel, the (1-3)-th sub light emitting elements SLD1c" may be connected to each other in parallel, the (2-2)-th sub light emitting elements SLD2b" may be connected to each other in parallel, and the (2-3)-th sub light emitting elements SLD2c" may be connected to each other in parallel. The (1-2)-th sub light emitting elements SLD1b" and the (2-2)-th sub light emitting elements SLD2b" may be connected to each other in series, and the (1-3)-th sub light emitting elements SLD1c" and the (2-3)-th sub light emitting elements SLD2c" may be connected to each other in series.

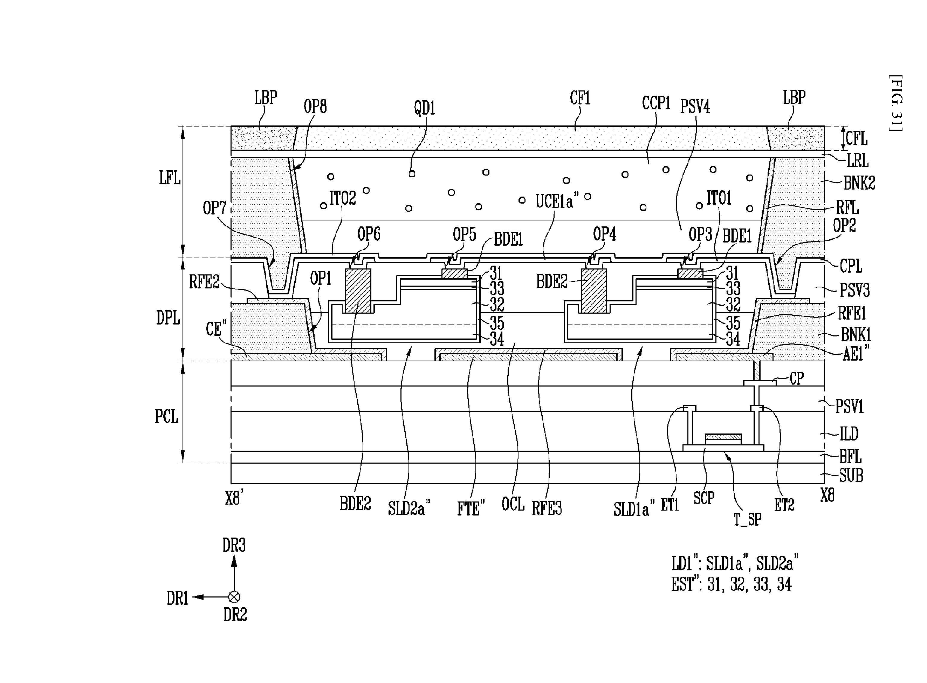

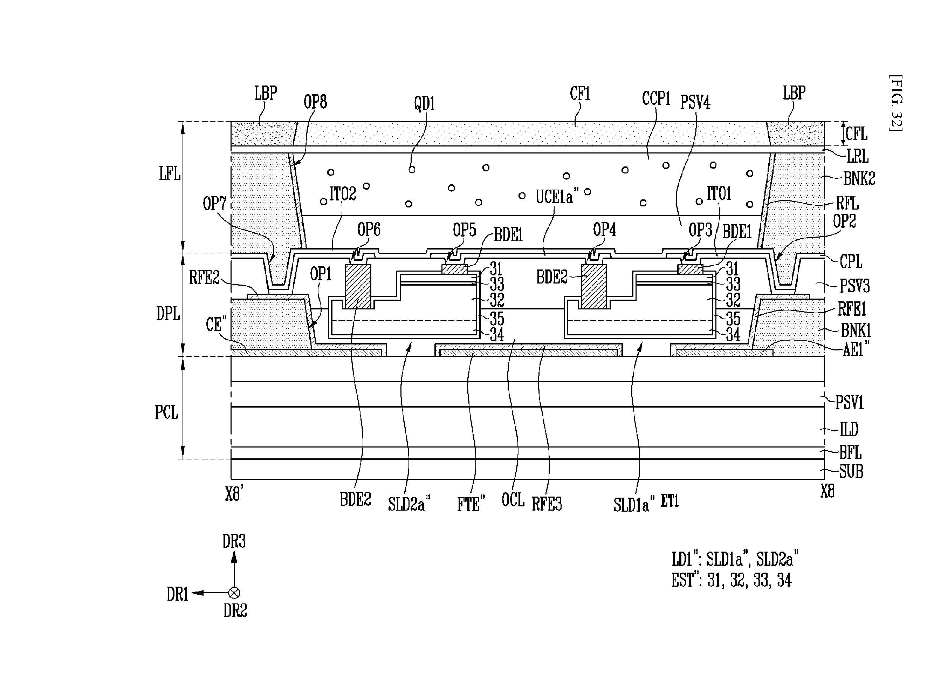

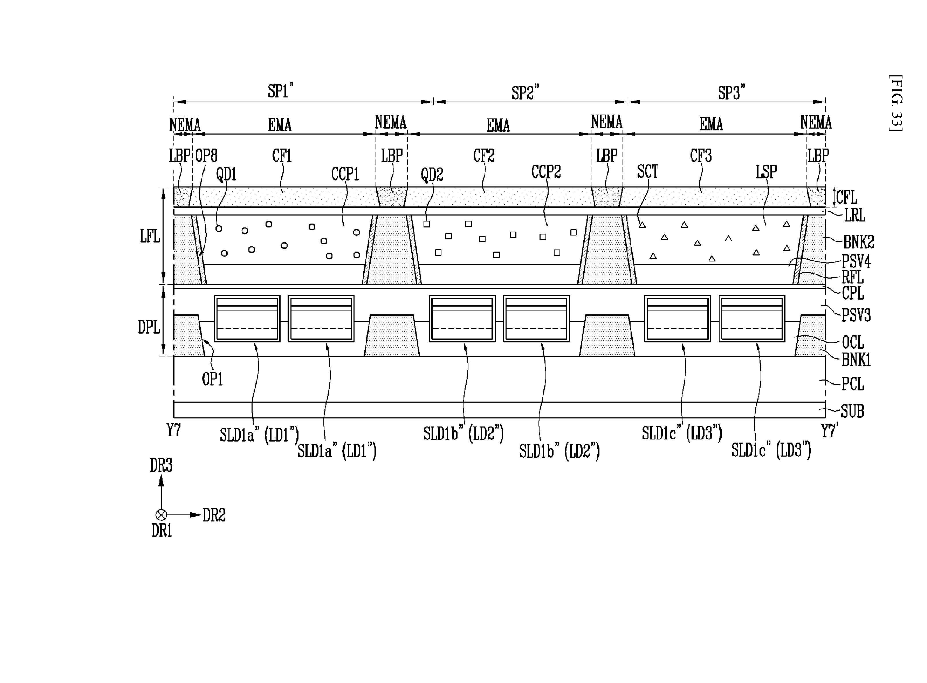

FIGS. 31 to 33 are schematic cross-sectional views illustrating the pixel according to the (3-2)-th embodiment of FIG. 30. FIG. 31 is a schematic cross-sectional view taken along line X8-X8' of FIG. 30, FIG. 32 is a schematic cross-sectional view taken along line X9-X9' of FIG. 30, and FIG. 33 is a schematic cross-sectional view taken along line Y7-Y7' of FIG. 30.

Referring to FIGS. 30 to 33, the each of the (1-1)-th to (1-3)-th sub light emitting elements SLD1a", SLD1b", and SLD1c" and the (2-1)-th to (2-3)-th sub light emitting elements SLD2a", SLD2b", and SLD2c" may be provided. In this case, each of the (1-1)-th to (1-3)-th sub light emitting elements SLD1a", SLD1b", and SLD1c" and the (2-1)-th to (2-3)-th sub light emitting elements SLD2a", SLD2b", and SLD2c" may be a lateral chip type of light emitting element as described with reference to FIG. 28. Hereinafter, a description of a content overlapping that described with reference to FIGS. 28 and 29 may be omitted.

In embodiments, the first bonding electrodes BDE1 of the (1-1)-th sub light emitting elements SLD1a" may be electrically connected to the first anode electrode AE1" through the first transparent electrodes ITO1 and the first reflective electrode RFE1. The second bonding electrodes BDE2 of the (2-1)-th sub light emitting elements SLD2a" may be electrically connected to the cathode electrode CE" through the second transparent electrodes ITO2 and the second reflective electrode RFE2.

In embodiments, the second bonding electrodes BDE2 of the (1-1)-th sub light emitting elements SLD1a" may be electrically connected to the first bonding electrodes BDE1 of the (2-1)-th sub light emitting elements SLD2a" through the (1-1)-th connection electrode UCE1a".

Accordingly, between the first anode electrode AE1" and the cathode electrode CE", the (1-1)-th sub light emitting elements SLD1a" and the (2-1)-th sub light emitting elements SLD2a" may be connected to each other in series. The (1-1)-th sub light emitting elements SLD1a" may be connected to each other in parallel between the first anode electrode AE1" and the (1-1)-th connection electrode UCE1a", and the (2-1)-th sub light emitting elements SLD2a" may be connected to each other in parallel between the (1-1)-th connection electrode UCE1a" and the cathode electrode CE".

Above, the first light emitting element LD1" included in the first sub-pixel SP1" is described, but each of the second and third light emitting elements LD2" and LD3" included in the second and third sub-pixels SP2" and SP3" of FIG. 30 may be configured similarly to the first light emitting element LD1" unless otherwise described herein.

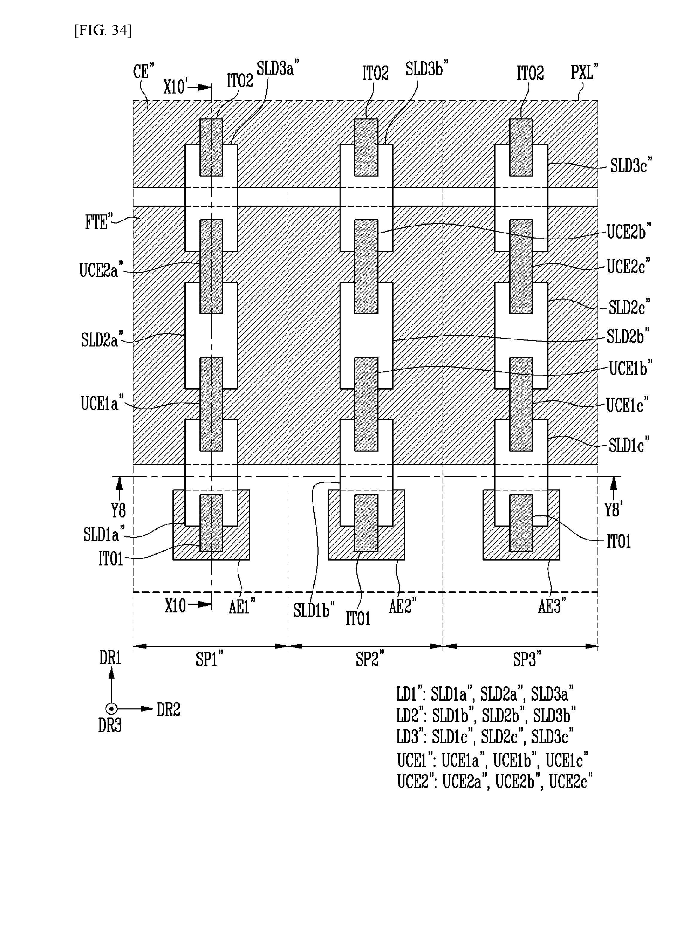

FIG. 34 is a schematic plan view illustrating a (3-3)-th embodiment of one of the pixels included in the display panel of FIG. 3.

Referring to FIG. 34, the pixel PXL" may include first to third sub-pixels SP1", SP2", and SP3". The first to third sub-pixels SP1", SP2", and SP3" may be arranged in the second direction DR2. However, an arrangement of the pixel PXL" is not limited thereto and may variously change according to embodiments. For example, the first to third sub-pixels SP1", SP2", and SP3" may be arranged in a zigzag.

First to third anode electrodes AE1", AE2", and AE3" may be disposed in the first to third sub-pixels SP1", SP2", and SP3", respectively. The first to third anode electrodes AE1", AE2", and AE3" may be configured similarly to those described with reference to FIG. 27.

The cathode electrode CE" may be spaced apart from the first to third anode electrodes AE1", AE2", and AE3". The cathode electrode CE" may be configured similarly to that described with reference to FIG. 27.

In embodiments, a floating electrode FTE" may be further disposed between the first to third anode electrodes AE1", AE2", AE3" and the cathode electrode CE". The floating electrode FTE" may be configured similarly to that described with reference to FIG. 27.

First to third light emitting elements LD1", LD2", and LD3" may be disposed on the first to third anode electrodes AE1", AE2", and AE3", the cathode electrode CE", and the floating electrode FTE".

The first light emitting element LD1" may be provided as the light emitting element LD (refer to FIG. 2) connected to the sub-pixel circuit SPC of the first sub-pixel SP1". The first light emitting element LD1" may include a (1-1)-th sub light emitting element SLD1a", a (2-1)-th sub light emitting element SLD2a", and a (3-1)-th sub light emitting element SLD3a". The (1-1)-th sub light emitting element SLD1a" may be electrically connected to the first anode electrode AE1" and the (1-1)-th connection electrode UCE1a". The (2-1)-th sub light emitting element SLD2a" may be electrically connected to the (1-1)-th connection electrode UCE1a" and a (2-1)-th connection electrode UCE2a". The (3-1)-th sub light emitting element SLD3a" may be electrically connected to the (2-1)-th connection electrode UCE2a" and the cathode electrode CE". Accordingly, between the first anode electrode AE1" and the cathode electrode CE", the (1-1)-th sub light emitting element SLD1a", the (2-1)-th sub light emitting element SLD2a", and the (3-1)-th sub light emitting element SLD3a" may be connected to each other in series through the (1-1)-th connection electrode UCE1a" and the (2-1)-th connection electrode UCE2a".

The second light emitting element LD2" may be provided as the light emitting element LD (refer to FIG. 2) connected to the sub-pixel circuit SPC of the second sub-pixel SP2". The second light emitting element LD2" may include a (1-2)-th sub light emitting element SLD1b", a (2-2)-th sub light emitting element SLD2b", and a (3-2)-th sub light emitting element SLD3b". The (1-2)-th sub light emitting element SLD1b" may be electrically connected to the second anode electrode AE2" and the (1-2)-th connection electrode UCE1b". The (2-2)-th sub light emitting element SLD2b" may be electrically connected to the (1-2)-th connection electrode UCE1b" and a (2-2)-th connection electrode UCE2b". The (3-2)-th sub light emitting element SLD3b" may be electrically connected to the (2-2)-th connection electrode UCE2b" and the cathode electrode CE". Accordingly, between the second anode electrode AE2" and the cathode electrode CE", the (1-2)-th sub light emitting element SLD1b", the (2-2)-th sub light emitting element SLD2b" and the (3-2)-th sub light emitting element SLD3b" may be connected to each other in series through the (1-2)-th connection electrode UCE1b" and the (2-2)-th connection electrode UCE2b".

The third light emitting element LD3" may be provided as the light emitting element LD (refer to FIG. 2) connected to the sub-pixel circuit SPC of the third sub-pixel SP3". The third light emitting element LD3" may include a (1-3)-th sub light emitting element SLD1c", a (2-3)-th sub light emitting element SLD2c", and a (3-3)-th sub light emitting element SLD3c". The (1-3)-th sub light emitting element SLD1c" may be electrically connected to the third anode electrode AE3" and the (1-3)-th connection electrode UCE1c". The (2-3)-th sub light emitting element SLD2c" may be electrically connected to the (1-3)-th connection electrode UCE1c" and a (2-3)-th connection electrode UCE2c". The (3-3)-th sub light emitting element SLD3c" may be electrically connected to the (2-3)-th connection electrode UCE2c" and the cathode electrode CE". Accordingly, between the third anode electrode AE3" and the cathode electrode CE", the (1-3)-th sub light emitting element SLD1c", the (2-3)-th sub light emitting element SLD2c", and the (3-3)-th sub light emitting element SLD3c" may be connected to each other in series through the (1-3)-th connection electrode UCE1c" and the (2-3)-th connection electrode UCE2c".

The first light emitting element LD1", the second light emitting element LD2", and the third light emitting element LD3" may be inorganic light emitting diodes including an inorganic light emitting material. However, embodiments are not limited thereto, and for example, organic light emitting diodes may be used.

The first transparent electrode ITO1, the second transparent electrode ITO2, the first connection electrode UCE1", and a second connection electrode UCE2" may be disposed on the first light emitting element LD1", the second light emitting element LD2", and the third light emitting element LD3".

The first transparent electrode ITO1 may be disposed in the first to third sub-pixels SP1", SP2", and SP3", respectively. In the first sub-pixel SP1", the first anode electrode AE1" and the (1-1)-th sub light emitting element SLD1a" may be electrically connected to each other through the first transparent electrode ITO1. In the second sub-pixel SP2", the second anode electrode AE2" and the (1-2)-th sub light emitting element SLD1b" may be electrically connected to each other through the first transparent electrode ITO1. In the third sub-pixel SP3", the third anode electrode AE3" and the (1-3)-th sub light emitting elements SLD1c" may be electrically connected to each other through the first transparent electrode ITO1.

The second transparent electrode ITO2 may be disposed in the first to third sub-pixels SP1", SP2", and SP3", respectively. In the first sub-pixel SP1", the cathode electrode CE" and the (3-1)-th sub light emitting elements SLD3a" may be electrically connected to each other through the second transparent electrode ITO2. In the second sub-pixel SP2", the cathode electrode CE" and the (3-2)-th sub light emitting element SLD3b" may be electrically connected to each other through the second transparent electrode ITO2. In the third sub-pixel SP3", the cathode electrode CE" and the (3-3)-th sub light emitting elements SLD3c" may be electrically connected to each other through the second transparent electrode ITO1.

The first connection electrode UCE1" may be spaced apart from the first and second transparent electrodes ITO1 and ITO2. In embodiments, the first connection electrode UCE1" may be disposed in a same layer as the first and second transparent electrodes ITO1 and ITO2. The first connection electrode UCE1" may include a (1-1)-th connection electrode UCE1a", a (1-2)-th connection electrode UCE1b", and a (1-3)-th connection electrode UCE1c".

The (1-1)-th connection electrode UCE1a" may be provided in the first sub-pixel SP1". The (1-1)-th connection electrode UCE1a" may be electrically connected to the (1-1)-th sub light emitting element SLD1a" and the (2-1)-th sub light emitting element SLD2a".

The (1-2)-th connection electrode UCE1b" may be provided in the second sub-pixel SP2". The (1-2)-th connection electrode UCE1b" may be electrically connected to the (1-2)-th sub light emitting element SLD1b" and the (2-2)-th sub light emitting element SLD2b".

The (1-3)-th connection electrode UCE1c" may be provided in the third sub-pixel SP3". The (1-3)-th connection electrode UCE1c" may be electrically connected to the (1-3)-th sub light emitting element SLD1c" and the (2-3)-th sub light emitting element SLD2c".

The second connection electrode UCE2" may be spaced apart from the first and second transparent electrodes ITO1 and ITO2 and the first connection electrode UCE1". In embodiments, the second connection electrode UCE2" may be disposed in a same layer as the first and second transparent electrodes ITO1 and ITO2. The second connection electrode UCE2" may include a (2-1)-th connection electrode UCE2a", a (2-2)-th connection electrode UCE2b", and a (2-3)-th connection electrode UCE2c".

The (2-1)-th connection electrode UCE2a" may be provided in the first sub-pixel SP1". The (2-1)-th connection electrode UCE2a" may be electrically connected to the (2-1)-th sub light emitting element SLD2a" and the (3-1)-th sub light emitting element SLD3a".

The (2-2)-th connection electrode UCE2b" may be provided in the second sub-pixel SP2". The (2-2)-th connection electrode UCE2b" may be electrically connected to the (2-2)-th sub light emitting element SLD2b" and the (3-2)-th sub light emitting element SLD3b".

The (2-3)-th connection electrode UCE2c" may be provided in the third sub-pixel SP3". The (2-3)-th connection electrode UCE2c" may be electrically connected to the (2-3)-th sub light emitting element SLD2c" and the (3-3)-th sub light emitting element SLD3c".

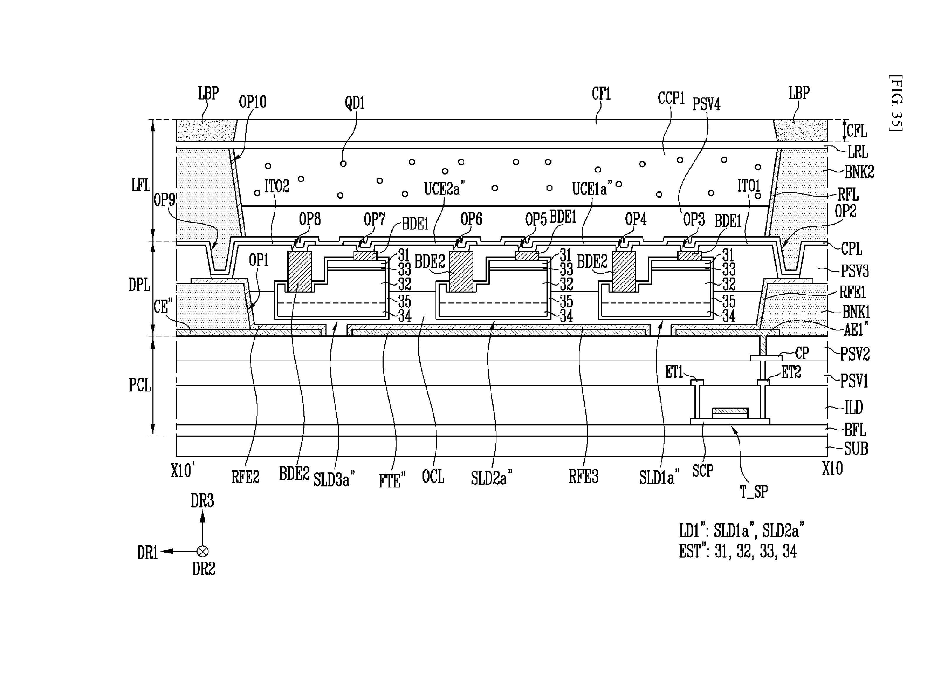

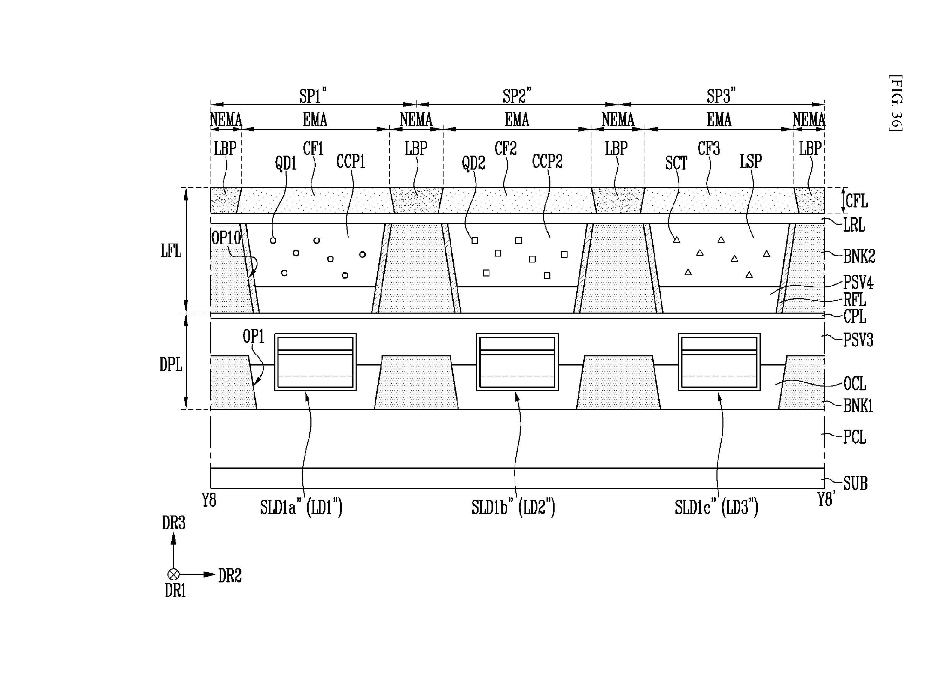

FIGS. 35 and 36 are schematic cross-sectional views illustrating the pixel according to the (3-3)-th embodiment of FIG. 34. FIG. 35 is a schematic cross-sectional view taken along line X10-X10' of FIG. 34, and FIG. 36 is a schematic cross-sectional view taken along line Y8-Y8' of FIG. 34.

Referring to FIGS. 34 and 35, the pixel circuit layer PCL, the display element layer DPL, and the light functional layer LFL may be sequentially disposed on the substrate SUB.

The pixel circuit layer PCL may be configured similarly to that described with reference to FIG. 28. Therefore, a description of an overlapping content may be omitted.

The display element layer DPL may be disposed on the pixel circuit layer PCL. The display element layer DPL may include the first anode electrode AE1", the floating electrode FTE", the cathode electrode CE", the first bank BNK1, the first to third reflective electrodes RFE1, RFE2, and RFE3, the overcoat layer OCL, the first light emitting element LD1", the third passivation layer PSV3, the first and second transparent electrodes ITO1 and ITO2, the (1-1)-th connection electrode UCE1a", the (2-1)-th connection electrode UCE2a", and the capping layer CPL.

The first anode electrode AE1" may be electrically connected to the connection pattern CP through a contact hole passing through the second passivation layer PSV2. As described above, the first anode electrode AE1" may be electrically connected to the transistor T_SP.

The cathode electrode CE" may be spaced apart from the first anode electrode AE1" in the first direction DR1. The cathode electrode CE" may be electrically connected to the second power voltage node VSSN of FIG. 2. Accordingly, the second power voltage applied to the second power voltage node VSSN may be transmitted to the cathode electrode CE".

The floating electrode FTE" may be disposed between the first anode electrode AE1" and the cathode electrode CE". The floating electrode FTE" may be spaced apart from the first anode electrode AE1" and the cathode electrode CE".

The first bank BNK1 may be disposed on the first anode electrode AE1", the floating electrode FTE", and the cathode electrode CE". The first bank BNK1 may have a first opening OP1 exposing portions of the first anode electrode AE1", the floating electrode FTE", and the cathode electrode CE". The first light emitting element LD1" may be disposed in the first opening OP1 of the first bank BNK1. As described above, the first bank BNK1 may be provided as a pixel defining layer that defines an area where the first light emitting element LD1" is positioned.

The first bank BNK1 may be configured to include a light blocking material, thereby preventing light mixing between adjacent sub-pixels. In embodiments, the first bank BNK1 may include an organic material. For example, the first bank BNK1 may include an organic insulating material such as acryl resin, epoxy resin, phenol resin, polyamide resin, and polyimide resin.

The first reflective electrode RFE1 may be disposed on the exposed portion of the first anode electrode AE1" and on a side surface of the first bank BNK1 adjacent thereto. The second reflective electrode RFE2 may be disposed on the exposed portion of the cathode electrode CE" and on a side surface of the first bank BNK1 adjacent thereto. The third reflective electrode RFE3 may be disposed on the exposed portion of the floating electrode FTE" and on a side surface of the first bank BNK1 adjacent thereto. The first to third reflective electrodes RFE1, RFE2, and RFE3 may include conductive materials suitable for reflecting light. Accordingly, light output efficiency of the first light emitting element LD1" may be improved. In embodiments, the first to third reflective electrodes RFE1, RFE2, and RFE3 may include at least one among aluminium (Al), silver (Ag), magnesium (Mg), platinum (Pt), palladium (Pd), gold (Au), nickel (Ni), neodymium (Nd), iridium (Ir), chromium (Cr), titanium (Ti), and an alloy of two or more materials selected from them. However, embodiments are not limited thereto.

The overcoat layer OCL may be disposed in the first opening OP1 of the first bank BNK1, on the first to third reflective electrodes RFE1, RFE2, and RFE3 and the second passivation layer PSV2. The first light emitting element LD1" may be disposed on the overcoat layer OCL. The first light emitting element LD1" may be partially buried in the overcoat layer OCL.

The overcoat layer OCL may fix the first light emitting element LD1" so that the first light emitting element LD1" does not move. The overcoat layer OCL may protect components disposed under the overcoat layer OCL from a foreign substance such as dust and moisture. For example, the overcoat layer OCL may include at least one of an inorganic insulating layer and an organic insulating layer. For example, the overcoat layer OCL may include epoxy, but embodiments are not limited thereto.

The first light emitting element LD1" may include a (1-1)-th sub light emitting element SLD1a", a (2-1)-th sub light emitting element SLD2a", and a (3-1)-th sub light emitting element SLD3a". Each of the (1-1)-th sub light emitting element SLD1a", the (2-1)-th sub light emitting element SLD2a", and the (3-1)-th sub light emitting element SLD3a"may include a light emitting stack EST" in which an auxiliary layer 34, a second semiconductor layer 32, an active layer 33, and a first semiconductor layer 31 may be sequentially stacked each other, and first and second bonding electrodes BDE1 and BDE2. Here, the first and second bonding electrodes BDE1 and BDE2 may protrude in a direction far from the pixel circuit layer PCL, and the first light emitting element LD1" may be referred to as a lateral chip type of light emitting element. Here, the content described with reference to FIG. 28 may be substantially applied identically to the lateral chip type of light emitting element. Therefore, a description of an overlapping content may be omitted.

The third passivation layer PSV3 may be disposed on the first to third reflective electrodes RFE1, RFE2, and RFE3, the first light emitting element LD1", and the overcoat layer OCL. The third passivation layer PSV3 may protect components disposed under the third passivation layer PSV3 and may provide a flat upper surface. The third passivation layer PSV3 may include a same material as one of the first and second passivation layers PSV1 and PSV2, but embodiments are not limited thereto.

The third passivation layer PSV3 may have second to ninth openings OP2, OP3, OP4, OP5, OP6, OP7, OP8, and OP9. The second opening OP2 may expose a portion of the first reflective electrode RFE1. The third opening OP3 may expose an upper surface of the first bonding electrode BDE1 of the (1-1)-th sub light emitting element SLD1a". The fourth opening OP4 may expose an upper surface of the second bonding electrode BDE2 of the (1-1)-th sub light emitting element SLD1a". The fifth opening OP5 may expose an upper surface of the first bonding electrode BDE1 of the (2-1)-th sub light emitting element SLD2a". The sixth opening OP6 may expose an upper surface of the second bonding electrode BDE2 of the (2-1)-th sub light emitting element SLD2a". The seventh opening OP7 may expose an upper surface of the first bonding electrode BDE1 of the (3-1)-th sub light emitting element SLD3a". The eighth opening OP8 may expose an upper surface of the second bonding electrode BDE2 of the (3-1)-th sub light emitting element SLD3a". The ninth opening OP9 may expose a portion of the second reflective electrode RFE2.

The first transparent electrode ITO1, the second transparent electrode ITO2, the (1-1)-th connection electrode UCE1a", and the (2-1)-th connection electrode UCE2a" may be disposed on the third passivation layer PSV3.

The first transparent electrode ITO1 may electrically connect the first reflective electrode RFE1 exposed by the second opening OP2 to the first bonding electrode BDE1 of the (1-1)-th sub light emitting element SLD1a" exposed by the third opening OP3. Accordingly, the first bonding electrode BDE1 of the (1-1)-th sub light emitting element SLD1a" may be electrically connected to the first anode electrode AE1" through the first transparent electrode ITO1 and the first reflective electrode RFE1.

The second transparent electrode ITO2 may electrically connect the second reflective electrode RFE2 exposed by the ninth opening OP9 to the second bonding electrode BDE2 of the (3-1)-th sub light emitting element SLD3a" exposed by the eighth opening OP8. Accordingly, the second bonding electrode BDE2 of the (3-1)-th sub light emitting element SLD3a" may be electrically connected to the cathode electrode CE" through the second transparent electrode ITO2 and the second reflective electrode RFE2.

The (1-1)-th connection electrode UCE1a" may electrically connect the second bonding electrode BDE2 of the (1-1)-th sub light emitting element SLD1a" exposed by the fourth opening OP4 to the first bonding electrode BDE1 of the (2-1)-th sub light emitting element SLD2a" exposed by the fifth opening OP5. Accordingly, the second bonding electrode BDE2 of the (1-1)-th sub light emitting element SLD1a" may be electrically connected to the first bonding electrode BDE1 of the (2-1)-th sub light emitting element SLD2a" through the (1-1)-th connection electrode UCE1a".

The (2-1)-th connection electrode UCE2a" may electrically connect the second bonding electrode BDE2 of the (2-1)-th sub light emitting element SLD2a" exposed by the sixth opening OP6 to the first bonding electrode BDE1 of the (3-1)-th sub light emitting element SLD3a" exposed by the seventh opening OP7. Accordingly, the second bonding electrode BDE2 of the (2-1)-th sub light emitting element SLD2a" may be electrically connected to the first bonding electrode BDE1 of the (3-1)-th sub light emitting element SLD3a" through the (2-1)-th connection electrode UCE2a".

As described above, between the first anode electrode AE1" and the cathode electrode CE", the (1-1)-th sub light emitting element SLD1a", the (2-1)-th sub light emitting element SLD2a", and the (3-1)-th sub light emitting element SLD3a" may be connected to each other in series through the (1-1)-th connection electrode UCE1a" and the (2-1)-th connection electrode UCE2a".

In embodiments, the first transparent electrode ITO1, the second transparent electrode ITO2, the (1-1)-th connection electrode UCE1a", and the (2-1)-th connection electrode UCE2a" may be configured to be substantially transparent or translucent to satisfy a selectable light transmittance. In embodiments, the first transparent electrode ITO1, the second transparent electrode ITO2, the (1-1)-th connection electrode UCE1a", and the (2-1)-th connection electrode UCE2a" may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, a material of the first transparent electrode ITO1, the second transparent electrode ITO2, the (1-1)-th connection electrode UCE1a", and the (2-1)-th connection electrode UCE2a" is not limited thereto.

The capping layer CPL may be disposed on the third passivation layer PSV3. The capping layer CPL may protect components under the capping layer CPL, such as the first and second transparent electrodes ITO1 and ITO2, the (1-1)-th connection electrode UCE1a", the (2-1)-th connection electrode UCE2a", the first light emitting element LD1", and the like within the spirit and the scope of the disclosure. The capping layer CPL may include at least one of silicon nitride, silicon oxide, silicon oxynitride, and a metal oxide such as aluminium oxide. However, a material of the capping layer CPL is not limited thereto.

Above, the pixel circuit layer PCL and the display element layer DPL of the first sub-pixel SP1" are described. Each of the second and third sub-pixels SP2" and SP3" of FIG. 34 may be configured similarly to the first sub-pixel SP1" unless otherwise described herein.

The light functional layer LFL may be disposed on the capping layer CPL. The light functional layer LFL may include the second bank BNK2, the reflective layer RFL, a fourth passivation layer PSV4, the first light conversion pattern CCP1, the low refractive layer LRL, and the color filter layer CFL. The light functional layer LFL is described similarly to that described with reference to FIG. 28. Therefore, an overlapping description may be omitted.

Referring to FIGS. 34 and 36, the pixel circuit layer PCL, the display element layer DPL, and the light functional layer LFL may be sequentially provided on the substrate SUB.

The pixel circuit layer PCL and the display element layer DPL are described similarly to those described with reference to FIG. 35. In the pixel circuit layer PCL, the sub-pixel circuits respectively corresponding to the first to third sub-pixels SP1", SP2", and SP3" may be provided. In the display element layer DPL, the first to third light emitting elements LD1", LD2", and LD3" respectively corresponding to the first to third sub-pixels SP1", SP2", and SP3" may be provided. The first to third light emitting elements LD1", LD2", and LD3" may overlap the first openings OP1 of the first bank BNK1. The first light emitting element LD1" may be connected between the cathode electrode CE" (refer to FIG. 35) and the transistor T_SP (refer to FIG. 35) included in the sub-pixel circuit of the first sub-pixel SP1". The second light emitting element LD2" may be connected between the cathode electrode CE" and the transistor included in the sub-pixel circuit of the second sub-pixel SP2". The third light emitting element LD3" may be connected between the cathode electrode CE" and the transistor included in the sub-pixel circuit of the third sub-pixel SP3". Below, an overlapping description may be omitted.

The light functional layer LFL may be provided on the display element layer DPL. The light functional layer LFL is described similarly to that described with reference to FIG. 29. Therefore, an overlapping description may be omitted.

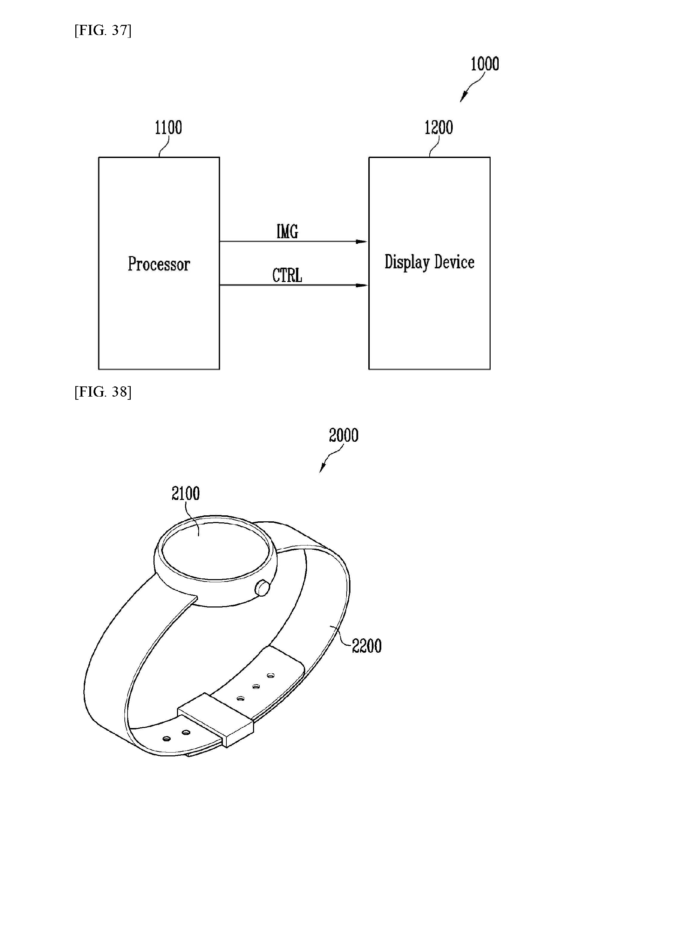

FIG. 37 is a block diagram illustrating a display system according to an embodiment.

Referring to FIG. 37, the display system 1000 may include a processor 1100 and a display device 1200.

The processor 1100 may perform various tasks and calculations. In embodiments, the processor 1100 may include an application processor, a graphics processor, a microprocessor, a central processing unit (CPU), and the like within the spirit and the scope of the disclosure. The processor 1100 may be connected to other components of the display system 1000 through a bus system to control the other components.

The processor 1100 may transmit image data IMG and a control signal CTRL to the display device 1200. The display device 1200 may display an image based on the image data IMG and the control signal CTRL. The display device 1200 may be configured similarly to the display device DD described with reference to FIG. 1. In this case, the image data IMG and the control signal CTRL may be provided as the input image data IMG and the control signal CTRL of FIG. 1, respectively.

The display system 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

FIGS. 38 to 41 are schematic perspective views illustrating application examples of the display system of FIG. 37.

Referring to FIG. 38, the display system 1000 of FIG. 37 may be applied to a smart watch 2000 including a display unit 2100 and a strap unit 2200.

The smart watch 2000 may be a wearable electronic device. For example, the smart watch 2000 may have a structure in which the strap unit 2200 is mounted on a user's wrist. Here, the display system 1000 and/or the display device 1200 may be applied to the display unit 2100, and image data including time information may be provided to a user.

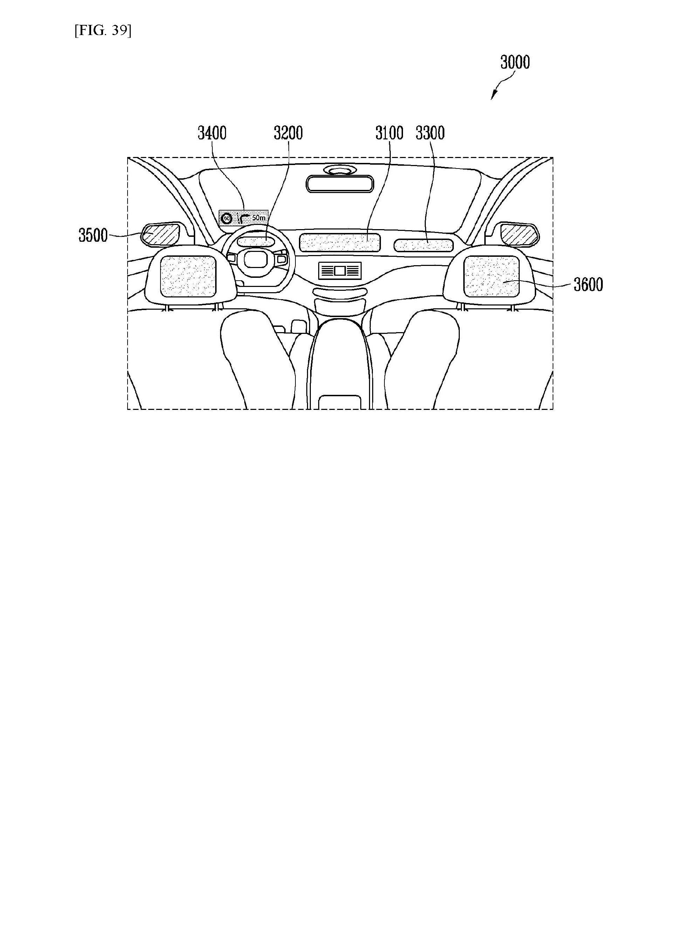

Referring to FIG. 39, the display system 1000 of FIG. 37 may be applied to an automotive display system 3000. Here, the automotive display system 3000 may include a computing system provided inside and/or outside a vehicle to provide image data.

For example, the display system 1000 and/or the display device 1200 may be applied to at least one of an infotainment panel 3100, a cluster 3200, a co-driver display 3300, a head-up display 3400, a side mirror display 3500, and a rear seat displays 3600 provided in a vehicle.

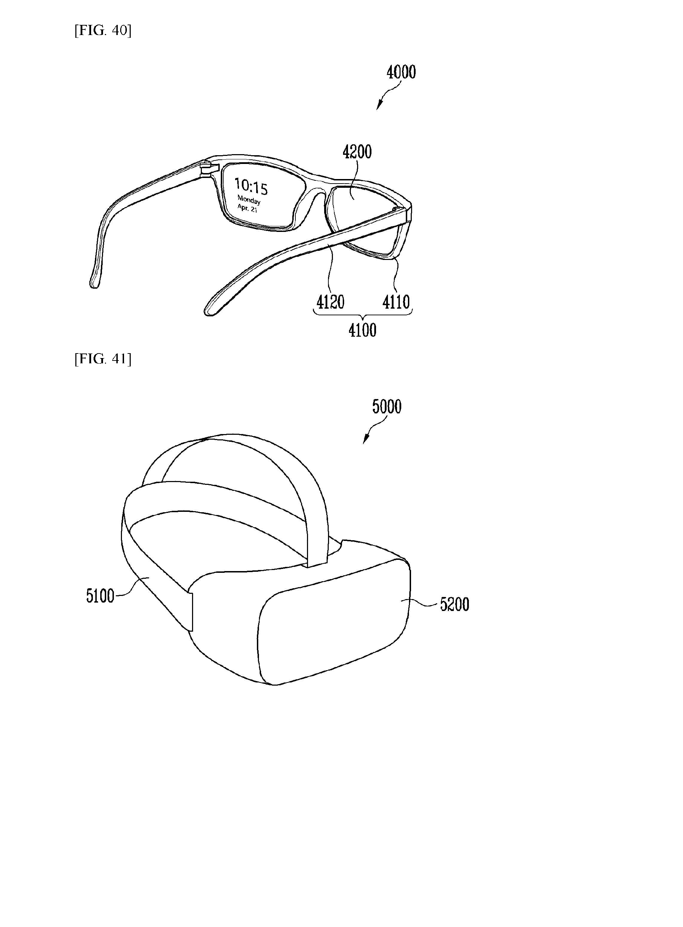

Referring to FIG. 40, the display system 1000 of FIG. 37 may be applied to smart glasses 4000. The smart glasses 4000 may be a wearable electronic device that may be worn on a user's head. For example, the smart glasses 4000 may be a wearable device for augmented reality.

The smart glasses 4000 may include a frame 4100 and a lens unit 4200. The frame 4100 may include a housing 4110 that supports the lens unit 4200 and a leg unit 4120 for the user to wear. The leg unit 4120 may be connected to the housing 4110 through a hinge and may be folded or unfolded relative to the housing 4110.

A battery, a touch pad, a microphone, a camera, and the like may be built in the frame 4100. A projector that outputs light, a processor that controls a light signal, and the like may be built in the frame 4100.

The lens unit 4200 may include an optical member that transmits or reflects light. For example, the lens unit 4200 may include glass, transparent synthetic resin, or the like within the spirit and the scope of the disclosure.

In order for user's eyes to recognize visual information, the lens unit 4200 may reflect an image by the light signal transmitted from the projector of the frame 4100 by a rear surface (for example, a surface of a direction facing the user's eyes) of the lens unit 4200. For example, the user may recognize visual information such as time and date displayed on the lens unit 4200. At this time, the projector and/or the lens unit 4200 may be a type of display device. The display device 1200 may be applied to the projector and/or the lens unit 4200.

Referring to FIG. 41, the display system 1000 of FIG. 37 may be applied to a head mounted display device 5000.

The head mounted display device 5000 may be a wearable electronic device that may be worn on a user's head. For example, the head mounted display device 5000 may be a wearable device for virtual reality or mixed reality.

The head mounted display device 5000 may include a head mount band 5100 and a display device receiving case 5200. The head mount band 5100 may be connected to the display device receiving case 5200. The head mount band 5100 may include a horizontal band and/or a vertical band for fixing the head mounted display device 5000 to a user's head. The horizontal band may be configured to surround a side portion of the user's head, and the vertical band may be configured to surround an upper portion of the user's head. However, embodiments are not limited thereto. For example, the head mount band 5100 may be implemented in a form of a glasses frame, a helmet, or the like within the spirit and the scope of the disclosure.

The display device receiving case 5200 may receive the display system 1000 and/or the display device 1200.

Although described with reference to the above embodiments, it will be understood that those skilled in the art can variously modify and change the disclosure without departing from the spirit and scope of the disclosure and described in the claims below.

## Claims

1. A display device comprising:
a pixel circuit layer including a transistor;
an anode electrode disposed on the pixel circuit layer and electrically connected to the transistor;
a first lower connection electrode, the first lower connection electrode and the anode electrode being disposed on a same layer, the first lower connection electrode spaced apart from the anode electrode;
a first upper connection electrode electrically connected to the first lower connection electrode and disposed on the anode electrode to face the anode electrode;
a cathode electrode, the cathode electrode and the first upper connection electrode being disposed on a same layer, the cathode electrode spaced apart from the first upper connection electrode;
a first sub light emitting element that overlaps the anode electrode; and
a second sub light emitting element that overlaps the first lower electrode,
wherein the first sub light emitting element is electrically connected to the second sub light emitting element in series through the first lower connection electrode and the first upper connection electrode between the anode electrode and the cathode electrode.

2. The display device according to claim 1, wherein
the first sub light emitting element includes a plurality of first sub light emitting elements, and
the plurality of first sub light emitting elements are electrically connected in parallel.

3. The display device according to claim 1, wherein
the second sub light emitting element includes a plurality of second sub light emitting elements, and
the plurality of second sub light emitting elements are electrically connected in parallel.

4. The display device according to claim 1, wherein each of the first sub light emitting element and the second sub light emitting element comprises:
a first semiconductor layer having a first polarity; and
a second semiconductor layer having a second polarity different from the first polarity and disposed on the first semiconductor layer.

5. The display device according to claim 4, wherein
the first semiconductor layer of the first sub light emitting element is electrically connected to the anode electrode,
the second semiconductor layer of the first sub light emitting element is electrically connected to the first upper connection electrode, and
the first semiconductor layer of the second sub light emitting element is electrically connected to the first lower connection electrode.

6. The display device according to claim 1, further comprising:
a second upper connection electrode, the second upper connection electrode and the first upper connection electrode being disposed on a same layer, the second upper connection electrode spaced apart from the cathode electrode and the first upper connection electrode, and disposed on the first lower connection electrode to face the first lower connection electrode;
a second lower connection electrode, the second lower connection electrode and the anode electrode being disposed on a same layer, the second lower connection electrode spaced apart from the anode electrode and the first lower connection electrode, and electrically connected to the second upper connection electrode; and
a third sub light emitting element that overlaps the second lower connection electrode.

7. The display device according to claim 6, wherein the second sub light emitting element is electrically connected to the third sub light emitting element in series through the second lower connection electrode and the second upper connection electrode between the first lower connection electrode and the cathode electrode.

8. The display device according to claim 7, wherein
the third sub light emitting element includes a plurality of third sub light emitting elements, and
the plurality of third sub light emitting elements are electrically connected in parallel.

9. The display device according to claim 6, further comprising:
a third upper connection electrode, the third upper connection electrode and the first upper connection electrode being disposed on a same layer, the third upper connection electrode spaced apart from the cathode electrode, the first upper connection electrode, and the second upper connection electrode, and disposed on the second lower connection electrode to face the second lower connection electrode;
a third lower connection electrode, the third lower connection electrode and the anode electrode being disposed on a same layer, the third lower connection electrode spaced apart from the anode electrode, the first lower connection electrode, and the second lower connection electrode, and electrically connected to the third upper connection electrode; and
a fourth sub light emitting element that overlaps the third lower connection electrode.

10. The display device according to claim 9, wherein the third sub light emitting element is electrically connected to the fourth sub light emitting element in series through the third lower connection electrode and the third upper connection electrode between the second lower connection electrode and the cathode electrode.

11. A display device comprising:
a pixel circuit layer including a transistor;
an anode electrode disposed on the pixel circuit layer and electrically connected to the transistor;
a first connection electrode spaced apart from the anode electrode, the first connection electrode and the anode electrode being disposed on a same layer;
a cathode electrode spaced apart from the anode electrode and the first connection electrode, the cathode electrode and the anode electrode being disposed on a same layer;
a first sub light emitting element electrically connected between the anode electrode and the first connection electrode; and
a second sub light emitting element electrically connected between the first connection electrode and the cathode electrode,
wherein the first sub light emitting element is electrically connected to the second sub light emitting element in series through the first connection electrode between the anode electrode and the cathode electrode.

12. The display device according to claim 11, wherein
the first sub light emitting element includes a plurality of first sub light emitting elements, and
the plurality of first sub light emitting elements are electrically connected in parallel.

13. The display device according to claim 11, wherein
the second sub light emitting element includes a plurality of second sub light emitting elements, and
the plurality of second sub light emitting elements are electrically connected in parallel.

14. The display device according to claim 11, wherein each of the first sub light emitting element and the second sub light emitting element comprises:
a first semiconductor layer having a first polarity;
a second semiconductor layer having a second polarity different from the first polarity and disposed on the first semiconductor layer;
a first bonding electrode electrically connected to the first semiconductor layer and protruding in a direction facing the pixel circuit layer; and
a second bonding electrode electrically connected to the second semiconductor layer and protruding in the direction facing the pixel circuit layer.

15. The display device according to claim 14, wherein
the first bonding electrode of the first sub light emitting element is electrically connected to the anode electrode,
the second bonding electrode of the first sub light emitting element is electrically connected to the first connection electrode, and
the first bonding electrode of the second sub light emitting element is electrically connected to the first connection electrode.

16. The display device according to claim 11, further comprising:
a second connection electrode, the second connection electrode and the anode electrode being disposed on a same layer, the second connection electrode spaced apart from the anode electrode, the first connection electrode, and the cathode electrode; and
a third sub light emitting element electrically connected between the second connection electrode and the cathode electrode,
wherein the second sub light emitting element and the third sub light emitting element are electrically connected in series through the second connection electrode between the first connection electrode and the cathode electrode.

17. The display device according to claim 16, wherein
the third sub light emitting element includes a plurality of third sub light emitting elements, and
the plurality of third sub light emitting elements are electrically connected in parallel.

18. A display device comprising:
a pixel circuit layer including a transistor;
an anode electrode disposed on the pixel circuit layer and electrically connected to the transistor;
a cathode electrode, the cathode electrode and the anode electrode being disposed on a same layer, the cathode electrode spaced apart from the anode electrode;
a first sub light emitting element and a second sub light emitting element electrically connected between the anode electrode and the cathode electrode; and
a first connection electrode disposed on the first sub light emitting element and the second sub light emitting element, the first connection electrode electrically connecting the first sub light emitting element and the second sub light emitting element,
wherein the first sub light emitting element and the second sub light emitting element are electrically connected in series through the first connection electrode between the anode electrode and the cathode electrode.

19. The display device according to claim 18, wherein
the first sub light emitting element includes a plurality of first sub light emitting elements, and
the plurality of first sub light emitting elements are electrically connected in parallel.

20. The display device according to claim 18, wherein
the second sub light emitting element includes a plurality of second sub light emitting elements, and
the plurality of second sub light emitting elements are electrically connected in parallel.

21. The display device according to claim 11, wherein each of the first sub light emitting element and the second sub light emitting element comprises:
a first semiconductor layer having a first polarity;
a second semiconductor layer having a second polarity different from the first polarity and disposed below the first semiconductor layer;
a first bonding electrode electrically connected to the first semiconductor layer and protruding in a direction away from the pixel circuit layer; and
a second bonding electrode electrically connected to the second semiconductor layer and protruding in the direction away from the pixel circuit layer.

22. The display device according to claim 21, wherein
the first bonding electrode of the first sub light emitting element is electrically connected to the anode electrode,
the second bonding electrode of the first sub light emitting element is electrically connected to the first connection electrode, and
the first bonding electrode of the second sub light emitting element is electrically connected to the first connection electrode.

23. The display device according to claim 18, further comprising:
a third sub light emitting element electrically connected between the first connection electrode and the cathode electrode; and
a second connection electrode disposed on the second sub light emitting element and the third sub light emitting element, the second connection electrode electrically connecting the second sub light emitting element and the third sub light emitting element,
wherein the second sub light emitting element and the third sub light emitting element are electrically connected to each other in series through the second connection electrode between the first connection electrode and the cathode electrode.

24. The display device according to claim 23, wherein
the third sub light emitting element includes a plurality of third sub light emitting elements, and
the plurality of third sub light emitting elements are electrically connected to each other in parallel.

25. The display device according to claim 18, further comprising:
a floating electrode disposed between the anode electrode and the cathode electrode.

26. The display device according to claim 25, further comprising:
a reflective electrode covering at least a portion of the floating electrode.
